# EUROPEAN PATENT APPLICATION

(11) **EP 4 633 314 A1**
(43) Date of publication of application: **15.10.2025**
(21) Application number: 25169509.4
(22) Date of filing: 09.04.2025
(51) Int. Cl.: H05K 7/20

(54) **SYSTEM AND METHOD FOR SIDECAR COOLING SYSTEM**

(30) Priority: 09.04.2024 US 202463631825 P
(71) Applicant: Hoffman Enclosures, Inc., Anoka, MN 55303 (US)
(72) Inventor: Archibald, Matthew R., Derry (US)
(74) Representative: Barker Brettell LLP

(57) **Abstract**

A liquid cooling system has an enclosure (201) and a heat exchanger (102, 202) positioned in the enclosure. The heat exchanger transfers heat from a first fluid to a second fluid. The first fluid cools electrical equipment within a data center. The system includes a first flow control assembly to control flow of the first fluid and a second flow control assembly to control flow of the second fluid through the heat exchanger. A first temperature sensor and a first flow sensor are positioned within the enclosure. A controller receives measurements from the sensors. The controller determines a first signal based on a flow rate measurement and a target flow rate and sends the first signal to the first flow control assembly. The controller determines a second signal based on the temperature measurement and a target temperature and sends the second signal to the second flow control assembly.

## Description

### CROSS REFERENCE TO RELATED APPLICATIONS

This application claims the benefit of the U.S. Provisional Patent Application No. 63/631,825, filed April 9, 2024, which is incorporated herein by reference in its entirety.

### BACKGROUND

Cooling systems can be provided for electrical components in data centers. In some cases, equipment in a data center can be cooled through various means, including through liquid-based cooling systems, air-based cooling systems, or combinations thereof. Electrical equipment within a data center can be housed in racks and can include piping and manifolds for receiving a liquid coolant pumped through a liquid cooling circuit. The liquid coolant can be delivered to components of electrical equipment to provide a heat transfer from those components to the heat of the liquid coolant circuit.

### SUMMARY

Some examples of the disclosed technologies provide a liquid cooling system having an enclosure and a heat exchanger positioned in the enclosure, the heat exchanger transferring heat from a first fluid to a second fluid, the first fluid cooling electrical equipment within a data center. The cooling system can include a first flow control assembly to control flow of the first fluid through the heat exchanger. The cooling system can include a second flow control assembly to control flow of the second fluid through the heat exchanger. The cooling system can include a first temperature sensor and a first flow sensor positioned within the enclosure. The cooling system can include a controller in communication with the first flow control assembly, the second flow control assembly, the first temperature sensor, and the first flow sensor. The controller can receive a flow rate measurement from the first flow sensor, and receive a temperature measurement from the first temperature sensor. The controller can determine a first signal based on the flow rate measurement and a target flow rate of the first fluid. The controller can determine a second signal based on the temperature measurement and a target temperature of the first fluid. The controller can send the first signal to the first flow control assembly, and send the second signal to the second flow control assembly in order to simultaneously control flow of the first fluid and the second fluid through the heat exchanger.

In some examples, the first flow control assembly can include a first pump, and the second flow control assembly can include a first fan, the first signal can be a first pump speed signal and the second signal can be a first fan speed signal. In some examples, the controller can determine that the first fan is operating at a maximum fan speed, and in response to determining that the first fan is operating at the maximum fan speed, when the temperature measurement exceeds the target temperature of the first fluid, can determine, based on the temperature measurement, a second pump speed signal, and send the second pump speed signal to the first pump. In some examples, the second pump speed signal can comprise an instruction to operate the first pump at a maximum allowable speed. In some examples, the second pump speed signal can be determined by a proportional integral derivative controller that controls a speed of the first pump to achieve a target temperature of the first fluid. In some examples, the controller can detect a failure condition of the second flow control assembly, and in response to detecting the failure condition, generate a third signal, the third signal comprising an instruction to the first flow control assembly to increase a flow rate of the first fluid. The controller can send the third signal to the first flow control assembly. In some examples, the first flow control assembly can include a plurality of fans, and the second flow control assembly can include a controllable valve, and the second signal and include an instruction to one of open, partially open, or close the controllable valve. In some examples, the controller can be housed in a removable housing installed in at least one of an air-to-liquid cooling unit or a liquid-to-air cooling unit. In some examples, the controller can calculate a dew point for the first fluid, and the first signal and the second signal can be generated based on the dew point. In some examples, the cooling system can further comprise a first pressure sensor, and the first signal can be determined based on a maximum allowable pressure of the first fluid.

Some examples of the disclosed technologies provide a method of controlling a liquid cooling system including a heat exchanger transferring heat from a first fluid to a second fluid, the first fluid cooling electrical equipment within a data center. The method can include sensing a temperature and a flow rate of the first fluid. The method can include comparing the flow rate to a target flow rate of the first fluid, and comparing the temperature to a target temperature of the first fluid. The method can include generating a first pump speed signal and generating a second fan speed signal. The method can further include determining that the second fan speed signal is a maximum fan speed, determining that the temperature exceeds a target temperature of the first fluid, and determining a second pump speed signal when the second fan speed signal is at the maximum fan speed and the temperature exceeds the target temperature of the first fluid.

In some examples, the method can further include generating a second pump speed signal to operate a pump at a maximum allowable speed. In some examples, the method can further include generating the second pump speed signal using proportional integral derivative control. In some examples, the method can further include calculating a dew point of the first fluid and generating the first pump speed signal and the second fan speed signal based on the dew point. In some examples, the method can further include sensing a pressure and determining the first pump speed signal based on a maximum allowable pressure.

Some examples of the disclosed technologies provide a computer program product for operating a cooling unit within a data center. The computer program product can include instructions stored on a non-transitory computer readable medium to cause at least one processor to sense a temperature and a flow rate of a first fluid, compare the flow rate to a target flow rate of the first fluid, compare the temperature to a target temperature of the first fluid, generate a first pump speed signal, generate a second fan speed signal, determine that the second fan speed signal is a maximum fan speed, determine that the temperature exceeds a target temperature of the first fluid, and determine a second pump speed signal when the second fan speed signal is at the maximum fan speed and the temperature exceeds the target temperature of the first fluid.

In some examples, the instructions can further cause the at least one processor to generate a second pump speed signal to operate a pump at a maximum allowable speed. In some examples, the instructions can further cause the at least one processor to generate the second pump speed signal using proportional integral derivative control. In some examples, the instructions can further cause the at least one processor to calculate a dew point of the first fluid and generate the first pump speed signal and the second fan speed signal based on the dew point. In some examples, the instructions can further cause the at least one processor to sense a pressure and determine the first pump speed signal based on a maximum allowable pressure.

In some implementations, devices or systems disclosed herein can be utilized, manufactured, installed, etc. using methods embodying aspects of the disclosure. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the disclosed technologies, of the utilized features and implemented capabilities of such device or system.

Features which are described in the context of separate aspects and/or embodiments of the invention may be used together and/or be interchangeable wherever possible. Similarly, where features are, for brevity, described in the context of a single embodiment, those features may also be provided separately or in any suitable sub-combination. Features described in connection with the system or other device or component may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the disclosed technologies and, together with the description, serve to explain the principles of embodiments of the disclosed technologies:
FIG. 1 is a schematic of a coolant distribution system, according to an embodiment of the disclosure;
FIG. 2 is an isometric view of a liquid-to-air cooling unit, according to an embodiment of the disclosure;
FIG. 3 is a rear, left isometric view of the liquid-to-air cooling unit of FIG. 2;
FIG. 4 is a front elevation view of the liquid-to-air cooling unit of FIG. 2;
FIG. 5 is a front, right view of the liquid-to-air cooling unit of FIG. 2, with side panels of the unit removed;
FIG. 6 is a rear, left isometric view of the liquid-to-air cooling unit of FIG. 2 with the side panels removed;
FIG. 7 is a section view of the liquid-to-air cooling unit, showing the liquid-to-air heat exchanger within the unit at an oblique angle relative to the side walls of the unit;
FIG. 8 is a top plan section view of the liquid-to-air cooling unit of FIG. 2, showing the liquid-to-air heat exchanger within the unit at an oblique angle relative to the side walls of the unit;
FIGS. 9 is a section views of the liquid-to-air cooling unit of FIG. 2, showing a mounting bracket securing the heat exchanger to the unit;
FIG. 10 is a partial view of components of the liquid-to-air cooling unit of FIG. 2, illustrating plumbing elements in a top portion of the unit;
FIG. 11 is a partial view of components of the liquid-to-air cooling unit of FIG. 2, illustrating plumbing elements in a bottom portion of the unit;
FIG. 12 is a partial front, right view of the liquid-to-air cooling unit of FIG. 2, showing a pumping unit installed in the bottom slot of the unit;
FIG. 13 is an isometric view of a manifold of the liquid-to-air cooling unit of FIG. 2;
FIGS. 14 and 15 are isometric views of a filter assembly of the liquid-to-air cooling unit of FIG. 2;
FIG. 16 is a rear isometric view of expansion tanks of a liquid-to-air cooling unit, according to some embodiments;
FIGS. 17 and 18 are isometric views of a heat exchanger used in the liquid-to-air cooling unit of FIG. 2;
FIGS. 19 and 20 are isometric views of fan units used in the liquid-to-air cooling unit of FIG. 2;
FIG. 21 is an isometric view of a control unit for use with a pumping unit of the liquid-to-air cooling unit of FIG. 2 according to embodiments of the disclosure;
FIG. 22 is an isometric view of a power supply unit of the liquid-to-air cooling unit of FIG. 2, according to some embodiments of the disclosure;
FIG. 23 is a front, right isometric view of a power supply unit for use with liquid-to-air cooling units;
FIG. 24 is a front, right isometric view of an environmental monitoring platform, according to embodiments of the disclosure;
FIGS. 25 is a system schematic of high-density liquid cool units, according to some embodiments of the disclosure;
FIGS. 26 is a system schematics of high-density liquid cooling units, according to some embodiments of the disclosure;
FIGS. 27 and 28 are schematics for feedback control systems for high-density liquid cooling systems;
FIGS. 29A-29C are system schematics showing a controller, and an interface board for controlling elements of a high-density liquid cooling system;
FIGS. 30A-1 through 30B-2 are a list of sensors that can be used with a liquid-to-air cooling unit, according to some embodiments;
FIG. 31 is a schematic of a control system for a liquid-to-air cooling unit, according to some embodiments;
FIG. 32 is a schematic of a controller, which can be used as a controller of a liquid-to-air cooling unit, according to some embodiments;
FIG. 33 is a flowchart illustrating an example control process of a liquid-to-air cooling unit, according to some embodiments;
FIG. 34 is a flowchart illustrating an example control process of a cooling unit, according to some embodiments;
FIG. 35 is a flowchart illustrating an example control process of a cooling unit, including an autonomous mode of mechatronic components of the cooling unit, according to some embodiments;
FIGS. 36B and 36B are a flowchart illustrating an example control process for operating pumps of a cooling unit, according to some embodiments;
FIG. 37 is a flowchart illustrating an example control process for controlling an operation of fans of a cooling unit, according to some embodiments;
FIG. 38 is a flowchart illustrating an example control process for switching over from an active pump to a non-active pump, according to some embodiments; and
FIG. 39 is a flowchart illustrating example operating modes for pumps of a cooling unit, according to some embodiments.

### DETAILED DESCRIPTION

Before any embodiments of the disclosed technologies are explained in detail, it is to be understood that the disclosure is not limited in its application to the details of construction and the arrangement of components set forth in the following description or illustrated in the following drawings. The disclosed technologies are capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In some implementations, devices or systems disclosed herein can be utilized, manufactured, installed, etc. using methods embodying aspects of the disclosure. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the disclosure, of the utilized features and implemented capabilities of such device or system.

In some embodiments, aspects of the disclosure, including computerized implementations of methods according to the disclosure, can be implemented as a system, method, apparatus, or article of manufacture using standard programming or engineering techniques to produce software, firmware, hardware, or any combination thereof to control a processor device (e.g., a serial or parallel general purpose or specialized processor chip, a single- or multi-core chip, a microprocessor, a field programmable gate array, any variety of combinations of a control unit, arithmetic logic unit, and processor register, and so on), a computer (e.g., a processor device operatively coupled to a memory), or another electronically operated controller to implement aspects detailed herein. Accordingly, for example, embodiments of the disclosure can be implemented as a set of instructions, tangibly embodied on a non-transitory computer-readable media, such that a processor device can implement the instructions based upon reading the instructions from the computer-readable media. Some embodiments of the disclosure can include (or utilize) a control device such as an automation device, a special purpose or general-purpose computer including various computer hardware, software, firmware, and so on, consistent with the discussion below. As specific examples, a control device can include a processor, a microcontroller, a field-programmable gate array, a programmable logic controller, logic gates etc., and other typical components that are known in the art for implementation of appropriate functionality (e.g., memory, communication systems, power sources, user interfaces and other inputs, etc.). In some embodiments, a control device can include a centralized hub controller that receives, processes and (re)transmits control signals and other data to and from other distributed control devices (e.g., an engine controller, an implement controller, a drive controller, etc.), including as part of a hub-and-spoke architecture or otherwise.

The term "article of manufacture" as used herein is intended to encompass a computer program accessible from any computer-readable device, carrier (e.g., non-transitory signals), or media (e.g., non-transitory media). For example, computer-readable media can include but are not limited to magnetic storage devices (e.g., hard disk, floppy disk, magnetic strips, and so on), optical disks (e.g., compact disk (CD), digital versatile disk (DVD), and so on), smart cards, and flash memory devices (e.g., card, stick, and so on). Additionally, it should be appreciated that a carrier wave can be employed to carry computer-readable electronic data such as those used in transmitting and receiving electronic mail or in accessing a network such as the Internet or a local area network (LAN). Those skilled in the art will recognize that many modifications may be made to these configurations without departing from the scope or spirit of the claimed subject matter.

Certain operations of methods according to the disclosure, or of systems executing those methods, may be represented schematically in the FIGS., or otherwise discussed herein. Unless otherwise specified or limited, representation in the FIGS. of particular operations in particular spatial order may not necessarily require those operations to be executed in a particular sequence corresponding to the particular spatial order. Correspondingly, certain operations represented in the FIGS., or otherwise disclosed herein, can be executed in different orders than are expressly illustrated or described, as appropriate for particular embodiments of the disclosure. Further, in some embodiments, certain operations can be executed in parallel, including by dedicated parallel processing devices, or separate computing devices configured to interoperate as part of a large system.

As used herein in the context of computer implementation, unless otherwise specified or limited, the terms "component," "system," "module," "block," and the like are intended to encompass part or all of computer-related systems that include hardware, software, a combination of hardware and software, or software in execution. For example, a component may be, but is not limited to being, a processor device, a process being executed (or executable) by a processor device, an object, an executable, a thread of execution, a computer program, or a computer. By way of illustration, both an application running on a computer and the computer can be a component. One or more components (or system, module, and so on) may reside within a process or thread of execution, may be localized on one computer, may be distributed between two or more computers or other processor devices, or may be included within another component (or system, module, and so on).

Also as used herein, unless otherwise limited or defined, the terms "about," "substantially," and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. **In** contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some cases, a lateral direction can be a radial or other perpendicular direction relative to a reference direction.

The following discussion is presented to enable a person skilled in the art to make and use embodiments of the disclosure. Various modifications to the illustrated embodiments will be readily apparent to those skilled in the art, and the generic principles herein can be applied to other embodiments and applications without departing from embodiments of the disclosure. Thus, embodiments of the disclosure are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the disclosure. Skilled artisans will recognize the examples provided herein have many useful alternatives and fall within the scope of embodiments of the disclosure.

Cooling systems can be provided for data centers to cool electrical components within a data center. During operation, electrical components, typically housed in racks having a standard rack footprint (e.g., a standard height, width, and depth), generate heat. As that heat may degrade electrical components, damage the systems, or degrade performance of the components, cooling systems can be provided for data centers for transferring heats away from racks of the data center with electrical components that need to be cooled.

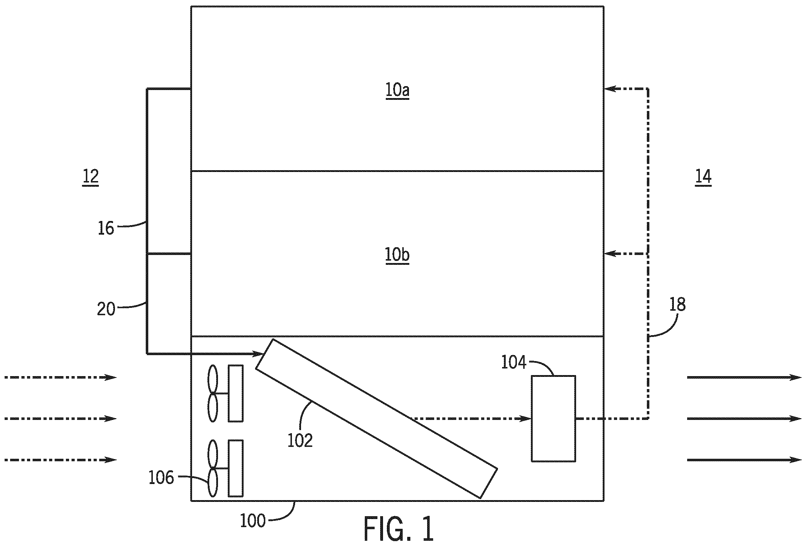

Cabinets or racks containing electrical equipment are typically arranged in rows within a data center, defining aisles between consecutive rows. Racks can be pre-assembled and "rolled in" to a space in the row adjacent to other racks, the space being pre-defined to have the footprint of a standard rack. This arrangement allows a modular construction of or addition to components in a data center. **In** some configurations, aisles on opposite sides of a row of cabinets can be alternately designated as a cold aisle, or a hot aisle, and heat generated by the electrical components of a cabinet can be expelled to the hot air aisle, as shown in FIG. 1.

FIG. 1 illustrates a schematic for a cooling system 1, according to some embodiments of the disclosure. As described above, electrical equipment (e.g., servers, storage devices, networking devices, etc.) within a data center can generate heat in operation and can require cooling systems to dissipate or transfer heat away from the electrical components. FIG. 1 illustrates cabinets 10a, 10b housing electrical equipment that can be a load of the cooling system 1. As shown, cabinets 10a, 10b are arranged in a row, with a front of each of the cabinets facing a cold aisle 12, and a rear of each of the cabinets 10a, 10b facing a hot aisle 14. As shown, both cabinets 10a, 10b can be in the flow path of a liquid coolant circuit 16 (e.g., a liquid cooling loop), and a coolant of the liquid coolant circuit 16 can flow through the cabinets 10a, 10b to transfer heat from electrical components in the cabinets 10a, 10b. For example, the liquid coolant circuit 16 can include a cold side 18 having a cooled fluid, and a hot side having 20 having a heated fluid. As shown, coolant from the cold side 18 can flow into each of the cabinets 10a, 10b, and can be heated by a heat transferred to the fluid from electrical components within the cabinets 10a, 10b. The heated fluid can then flow out of the electrical cabinets 10a, 10b to the hot side 20 of the liquid coolant circuit 16 to transfer the heat away from the respective electrical cabinets 10a, 10b. In some examples, a liquid coolant within a liquid coolant circuit (e.g., liquid coolant circuit 16) can be water. In some examples, the liquid coolant can be a dielectric fluid. In some examples, the liquid coolant can be a propylene glycol, or a combination of water and an anti-corrosion agent.

While the above description references cabinets of electrical equipment within a data center, it should be noted that the disclosure is not limited to cooling electrical cabinets within a data center and can be equally applicable to any application or use case requiring liquid cooling. For example, cabinets along a first liquid coolant circuit (e.g., one or more of cabinets 10a, 10b along liquid coolant circuit 16) can house liquid to liquid heat exchangers which can transfer heat from a coolant of a second liquid coolant circuit to the liquid of the first liquid coolant circuit. In some cases, liquid cooling circuits and systems can be provided for power supply systems, and can be used to cool batteries, transformers, power converters, electric motors, and the like. In some cases, liquid coolant circuits consistent with this disclosure can be used to cool thermal loads outside of data centers.

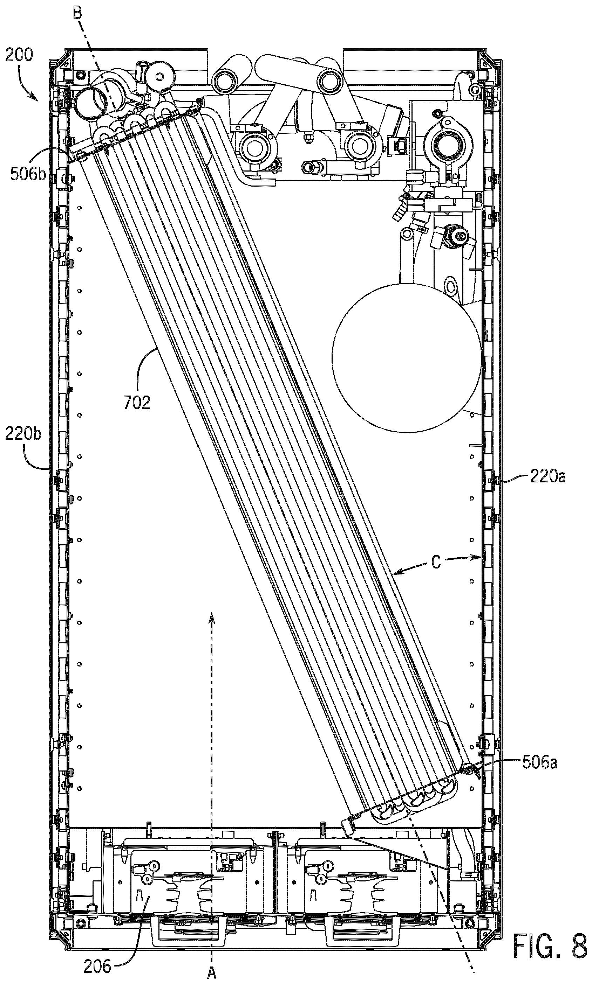

Cooling systems can include liquid-to-air cooling units to transfer heat from a liquid of a liquid cooling circuit (e.g., liquid coolant circuit 16) to an air of a data center (e.g., air of the hot aisle 14). As will be discussed further, the in-row cooling unit can be housed in a rack having a standard rack footprint for modular assembly, ease of installation and integration within a data center. In other embodiments, the footprint of an in-row cooling unit may be smaller than a standard rack footprint. As further illustrated in FIG. 1, the cooling system 1 can include an in-row liquid-to-air cooling unit 100 (LACU) for transferring heat from the fluid of the liquid coolant circuit 16 to air of the hot aisle 14. The LACU 100 can be housed in a rack, within an aisle of electrical equipment. For example, as shown, the LACU 100 can be in a row with electrical cabinets 10a, 10b along the liquid coolant circuit 16, with a front of the LACU 100 facing the cold aisle 12 and a rear of the LACU facing the hot aisle 14. The LACU 100 can include a liquid-to-air heat exchanger 102 (HX) for transferring a heat from fluid in the liquid coolant circuit 16 to air of the data center (e.g., air of the hot aisle 14). The liquid from the hot side 20 of the liquid coolant circuit 16 can enter the HX 102, and the liquid can exit the HX 102 to the cold side 18 of the liquid coolant circuit 16. A surface area of a liquid to air heat exchanger can correspond to a rate of heat transfer from a liquid to air, and a greater surface area of the heat exchanger can correspond to a greater rate of heat transfer. Thus, a heat exchanger of a liquid-to-air cooling unit can be sized and positioned to provide maximal surface area for heat transfer. For example, as shown in FIG. 1, the HX 102 can be positioned at an oblique angle within the LACU 100 relative to sides of the LACU 100 (e.g., as further described with respect to FIG. 8).

In some examples, liquid-to-air cooling units can include air flow components (e.g., fans) to induce a flow of air across a liquid-to-air heat exchanger to increase a heat transfer from liquid of a liquid coolant circuit to an air of the data center. For example, as shown, the LACU 100 can include one or more fans 106 to induce a flow of air across the HX 102. The one or more fans 106 can be positioned at a front of the LACU 100 and can suck in cool air from the cold aisle 12 and blow the air across the HX 102 in a direction toward the hot aisle 14. In some examples, fans of a liquid-to-air cooling unit can be position in a back of the cabinet. In some examples, fans of a liquid-to-air cooling unit can suck air from a rear of the unit across a heat exchanger and blow the air out of a front of the unit (e.g., air can flow in an opposite direction from the air flow direction shown). As discussed below, fans of an air-to-liquid cooling unit can be arranged in rows and columns along a front of the unit.

According to some embodiments, a cooling system for electrical equipment can include one or more pumping units to induce a flow of fluid through a liquid coolant circuit. In some embodiments, the cooling system may not include a pumping unit but may instead rely on water pressure provided by the facility in which the cooling system is installed. In some examples, a pumping unit can be housed in an in-row liquid-to-air cooling unit (e.g., the liquid-to-air cooling unit can be a coolant distribution unit). As further shown in FIG. 1, the LACU 100 can include a pumping unit 104 to pump fluid through the liquid cooling circuit 16. It can be advantageous to pump cool fluid through pumps of a pumping unit, as warm fluid can cause an expansion in components of the pumps, which can decrease a lifetime of the pumps. In some cases, as described below, the pumping unit 104 can include a plurality of pumps. The pumping unit 104 can be positioned downstream of the HX 102 and can be along the cold side 18 of the liquid coolant circuit 16. In other examples, a pumping unit of a liquid-to-air cooling unit can be upstream of a liquid-to-air heat exchanger (e.g., pumps of the liquid-to-air cooling unit can be along a hot side of a liquid cooling circuit). A pumping unit of a liquid-to-air cooling unit can be provided to fit in a standard size slot within a cabinet (e.g., a height of 2U, or 4U, or 8U or occupying four vertical bays of the cabinet). In some embodiments, a coolant distribution unit (CDU) can be provided in the in-row liquid-to-air cooling unit, rather than in the cabinet housing electrical equipment.

In the illustrated embodiment, the cold side 20 of the liquid cooling circuit 16 is shown at a front side of each of the cabinets 10a, 10b and the LACU 100, and the hot side 18 is shown at a rear side of the cabinets 10a, 10b and the LACU 100. However, in some embodiments, it can be advantageous to position liquid entries and exits (e.g., inlet ports and outlet ports) on a same side of a cabinet. For example, liquid manifolds for fluid entry and exit for cabinets can be mounted at a rear of the respective cabinets. In some examples, hosing of a liquid cooling circuit can enter cabinets (e.g., cabinets of electrical equipment or a cabinet of a liquid-to-air cooling unit) from a rear of the cabinet, through an entry in a side panel of the cabinet, from a top entry, or from a bottom entry of the cabinet. Further, in some embodiments, a liquid-to-air cooling unit can be provided to cool more than two electrical cabinets, or only one electrical cabinet.

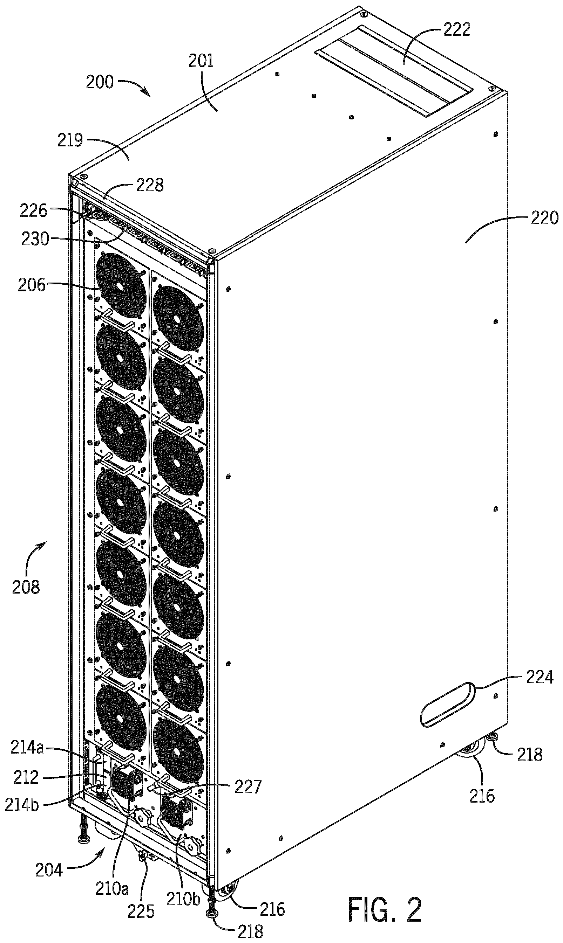

FIG. 2 illustrates an exemplary liquid-to-air cooling unit (LACU) 200, alternatively referred to as a "sidecar" or a coolant distribution unit (CDU). The LACU 200 can be similar to, or substantially identical to LACU 100 described above with respect to FIG. 1 and can include similar numbering for similar components. For example, a plurality of fans 206 can be provided in a fan assembly 208 in a front of the cabinet, as illustrated, which can induce an airflow through the system, increasing the cooling efficiency thereof. In the illustrated embodiment, the fan assembly 208 includes fourteen fans 206 arranged in two columns and seven rows. In some embodiments, a LACU can include more than 14 fans or fewer than 14 fans. In some cases, fans can be arranged in panels including four fans in a single panel, for example. As discussed below, the fans 206 can be hot-swappable (e.g., individual fans 206 of the fan assembly can be removed, replaced, or serviced without causing a downtime of the LACU 200).

It can be advantageous to position pumping units in a bottom of a rack of a liquid-to-air cooling unit (e.g., LACU 200), to prevent any leakage of fluid (e.g., liquid leaks during replacement of components of the pumping units) from producing damage to electronics of the liquid-to-air cooling unit. For example, as further shown in FIG. 2, the LACU 200 can include a replaceable pump unit (RPU) 204. The RPU 204 can be housed beneath the fan assembly 208 and can have a height of four rack units (e.g., the RPU 204 can have a height of 4U, occupying a space equal to four standard shelves of electrical equipment within a cabinet of a data center). The RPU 204 can include two pump cassettes 210a, 210b, and a control unit 212 including two hot-swappable control modules 214a, 214b. In some embodiments, the pump cassettes 210a, 210b can be hot-swappable, and can include blind connectors (not shown) in a back portion of the pump cassette 210a, 210b for electrical and fluid connections. In some embodiments, an RPU can include only one pump cassette, or more than two pump cassettes. In some examples, an RPU can occupy a greater volume within a LACU (e.g., the RPU can have a height of 8U). In some embodiments, the hot-swappable control modules 214a, 214b are substantially similar, and when one hot-swappable control module 214a, 214b is removed for servicing or replacement, the other hot-swappable control module 214a, 214b can implement control processes for the LACU 200, as further described below. In some examples, an RPU does not include a control module (e.g., a main controller for a liquid-to-air cooling unit can be housed at a different location within the cooling unit, or external to the cooling unit), or includes only one control module, or more than two control module.

A liquid-to-air cooling unit can include a fill/drain port for filling the unit and components of the unit with liquid coolant (e.g., charging the unit). In some cases, it can be advantageous to provide a fill/drain port of a liquid-to-air cooling unit at a front of the unit, to be accessible to an operator of the unit from a cold aisle. As shown, the LACU 200 can include liquid fill/drain port 225 at a bottom of the LACU 200. Positioning the fill/drain port at a bottom of the LACU 200 can be advantageous, as it can reduce a pressure to drain the system. In some cases, the fill/drain port 225 can comprise a quick disconnect fitting, to provide for an ease of connecting fill or drain lines to the LACU 200. In other embodiments, a liquid-to-air cooling unit can include more than one port, including, for example, a dedicated fill port and a dedicated drain port. In some examples, ports can be provided at the front of a LACU corresponding to individual components of the LACU. For example, as shown, the RPU 204 can include a liquid fill/drain port 227 for filling or draining a fluid from the RPU 204. In some cases, liquid fill/drain ports can be provided at other locations of a LACU, including in a back, along a side, etc.

As shown, the LACU 200 can be housed within a cabinet 201. The cabinet 201 can have a standard rack footprint, and may have a width of 600mm, as can allow the cabinet to be "rolled in" to a cabinet space within a row of cabinets in a data center. In some embodiments, a cabinet, which can also be referred to as a "rack" or an "enclosure" can have different rack footprints. For example, in some cases a rack can have a width of 1200 mm to occupy a space within a row in a data center that is sized to receive two adjacent racks of equipment. In some cases, a cabinet of a liquid-to-air cooling unit can occupy a footprint with a width of less than 600 mm, or greater than 600 mm. In some cases, a width or height of a cabinet of a liquid-to-air cooling unit can be configured to meet a standard, including, for example, an industry standard, or a regulatory standard.

A cabinet of a liquid-to-air cooling unit can include features to facilitate ease of installation and integration within a data center. For example, as illustrated, the LACU 200 can include a plurality of wheels 216 to allow the LACU 200 to be rolled to a desired location within a data center. **In** some embodiments, a liquid-to-air cooling unit can include casters. The LACU 200 can also include a plurality of adjustable feet 218. Before the LACU 200 is in an installation position, the plurality of adjustable feet 218 can be positioned at a first height, and at the first height, the adjustable feet do not engage or contact a floor of the data center. When the LACU is installed in a desired location, the adjustable feet 218 can be moved to a second height (e.g., by rotating an adjustable screw), at which the adjustable feet 218 engage the floor and prevent displacement of the LACU 200 relative to the floor. **In** some embodiments, a liquid-to-air cooling unit may not include wheels and adjustable feet or can include alternative or additional known mechanisms for facilitating an ease of installation and securing the unit in place when installed.

A cabinet of a liquid-to-air cooling unit can include panels, which can function to enclose components of the unit, partially define a flow path of air through the cabinet, can further shield internal components from view. As further shown in FIG. 2, for example, the cabinet 201 can include a top panel 219 at a top of the cabinet 201, and one or more side panels 220 at lateral sides of the cabinet 201 (e.g., along vertical sides of the LACU 200 not facing either a hot aisle or a cold aisle). In some embodiments, cables for electrical power and hosing for fluid connections can enter cooling units through an open back portion of the cooling unit (not shown). In some cases, however, it may be advantageous to provide cable and hose entries for cabinets of cooling units at other locations. For example, feeding cables and hoses through a back of the cabinet can increase a depth required for a row housing a cooling unit. In some cases, data centers can be arranged with top feed configurations, with connections (e.g., cables, tubing, hosing etc.) being provided from a ceiling. In other configurations, cabinets in a data center are installed on a raised floor, and connections can be provided from a bottom of the cabinet (i.e., in a "bottom feed" configuration). In this regard, panels of a cabinet of a cooling unit can include openings, which can be referred to as apertures or cutouts, to provide an entry for cables and hosing into the cabinet. For example, as shown in FIG. 2, the top panel 219 can include a top-feed cutout 222, for receiving cable and hosing from a top of the cabinet. Similarly, a bottom-feed cutout (not shown) can be provided at a bottom of the cabinet to receiving cabling and hosing through a bottom of the cabinet. In some cases, it can be advantageous to route hosing directly from adjacent cabinets. For example, providing liquid connections directly from an adjacent cabinet can reduce a pressure needed to pump coolant through a liquid coolant circuit. This configuration can reduce a total length of tubing required for a system, which in turn reduces the power required to pump coolant through the system. Additionally, when routing hosing directly through the cutout in the side panel, hosing need not extend out a back portion of either the electrical cabinet or the cabinet housing the cooling system, which may reduce a clearance needed or a total depth of the system. As shown, the side panel 220 can have a side cutout 224 for receiving hosing and/or hosing directly from adjacent cabinets. In some examples, hosing and cabling can enter a cabinet at other locations than illustrated, including, for example, through a front of a cabinet. In some cases, cutouts for receiving hosing into a cooling unit can have an open area that is at least large enough to accommodate 4 hoses having a diameter of 1.5 inches.

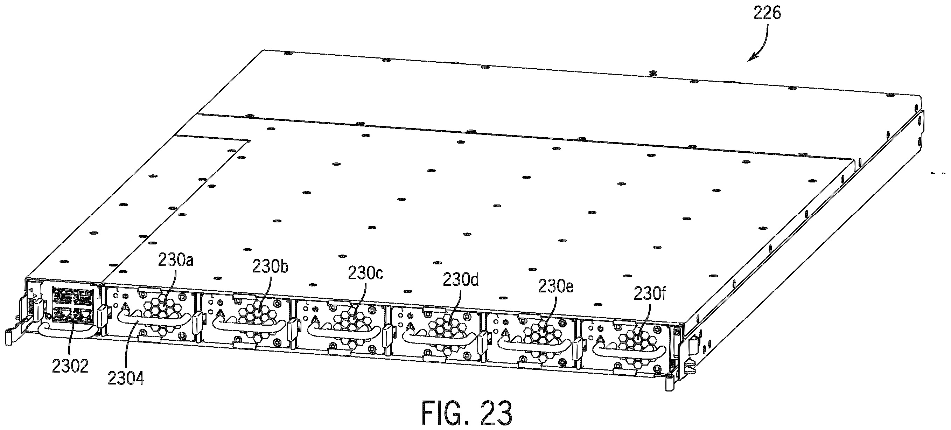

Cooling units for use in data centers, including liquid-to-air cooling units described herein can include power supply modules for controlling aspects of an electrical power provided to electrical components of the cooling unit. For example, as further shown in FIG. 2, the LACU 200 can include a power supply unit 226. As shown, the power supply unit 226 can be provided at or near a top of the LACU 200 (e.g., above liquid flow components in the LACU 200). This arrangement can be advantageous, as it can prevent leakage of liquid onto power control elements of the power supply unit 226. In the illustrated embodiment, the power supply unit 226 has a height of 1U, and an empty slot 228 is provided above the power supply unit 226, the empty slot having a height of 1U. In some embodiments, a power supply unit of a cooling unit can have a height of 2U. In some examples, a cooling unit (e.g., the LACU 200) can include two power supply units. Power supply units for liquid-to-air cooling unit can include one or more removable power modules 230, as further described with respect to power supply unit 2300 shown in FIG. 23. In the illustrated embodiments, the power supply unit 226 includes 6 power supply modules, but in other embodiments, a power supply unit of a cooling unit can include only one power supply module, or at least two power supply modules, at least three power supply modules, at least four power supply modules, or at least five power supply modules. In some examples, a power supply unit can include more than six power supply modules. In some embodiments, a power supply unit can receive three phases of power from a power inlet, and individual phases of the three phases can be provided to a respective power supply module. Thus, it can be advantageous to provide power supply modules in multiples of three to correspond to three phases of a power inlet and allow balancing of phases across power supply modules.

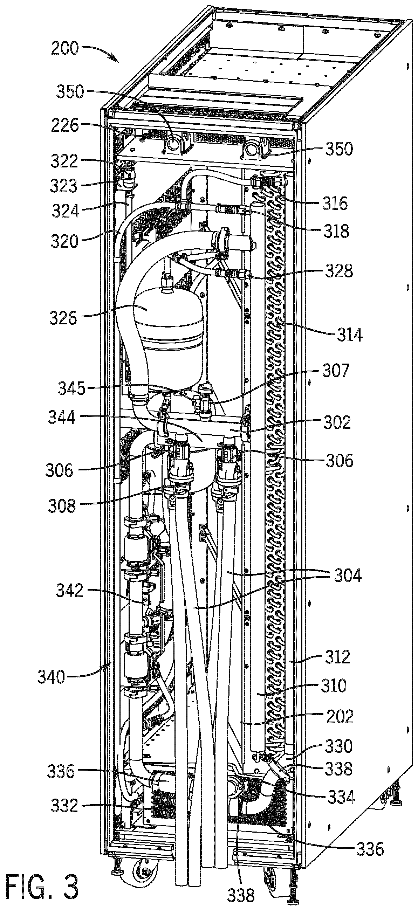

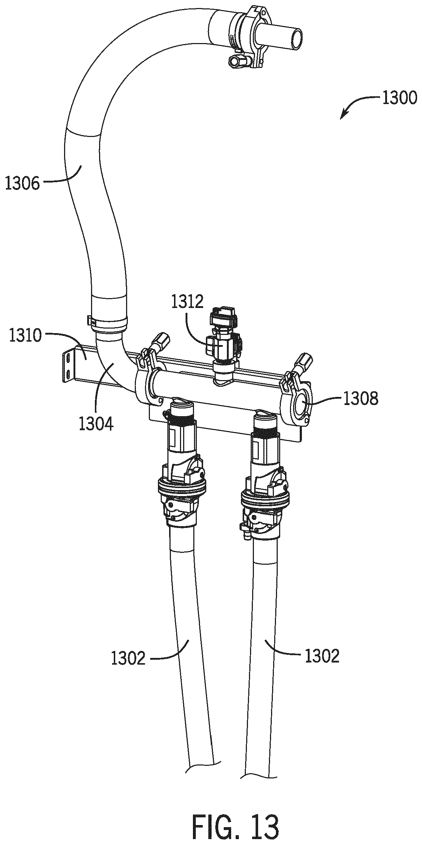

A liquid-to-air cooling unit (e.g., LACUs 100 shown in FIG. 1 and 200 shown in FIG. 2) can include plumbing elements (e.g., piping, hoses, valves, pumps, pressure regulation devices, etc.) for directing a flow of fluid through the unit. Plumbing elements can be housed primarily in a rear of a cabinet of a liquid-to-air cooling unit, as can improve an ease of servicing and reduce a pressure drop across plumbing elements that may otherwise be incurred if plumbing elements were dispersed through the unit. For example, FIG. 3 is a rear isometric view of the LACU 200, showing a plurality of plumbing and flow control elements of the LACU 200. As described above, a liquid-to-air cooling unit can receive heated fluid from a hot side of a fluid coolant circuit (e.g., the hot side 20 of liquid coolant circuit 16, as shown in FIG. 1). In this regard, FIG. 3 illustrates an inlet manifold 302 (e.g., a return manifold) for receiving heated fluid along a hot side of a liquid coolant circuit. In the illustrated embodiment, the inlet manifold 302 receives fluid from two hoses 304, which can each return fluid from respective cabinets of electrical equipment (e.g., cabinets 10a and 10b shown in FIG. 1). As described further with respect to manifold 1300 shown in FIG. 13, the hoses 304 can be connected to the manifold 302 at connection interfaces 306. The connection interfaces 306 can include shutoff valves 308 to block a flow of fluid from the corresponding hose 304 into the LACU 200. If one of the shutoff valves 308 is closed, the LACU 200 can receive heated coolant from only one cabinet, for example. Further, in the illustrated embodiment, the connection interfaces 306 are quick disconnect fittings, as can allow for toolless connection of hoses 304 to the inlet manifold 302 and can minimize a leakage of fluid when one of the hoses 304 is installed or disconnected. In some embodiments, other connection interfaces can be used. For example, hoses of a hot side of a liquid cooling circuit can be connected to an inlet manifold using tri-clamp flanges. In some embodiments, an inlet manifold can be configured to receive heated fluid from more than two cabinets, and can include three connection interfaces, or four connection interfaces, or five connection interface, or six connection interfaces, or more than six connection interfaces, with each connection interface corresponding to hosing providing heated fluid to a liquid-to-air cooling unit from a corresponding cabinet of electrical cabinet.

In the illustrated embodiment, the inlet manifold 302 is positioned and configured to receive hosing 304 from a bottom of the cabinet (e.g., in a bottom-feed configuration). In some embodiments (e.g., as further described with respect to manifold 1300), the manifold 302 can be positioned and configured to receive hosing (e.g., hosing 304) in a top-feed configuration, with the connection interfaces 306 extending upwardly from the inlet manifold 302. In other embodiments, a manifold can be differently positioned in a LACU. For example, while in the illustrated embodiment, the manifold 302 receives hosing 304 in a vertical direction, in other embodiments, a manifold can extend vertically within a cabinet of a LACU and can receive hosing from a direction that is orthogonal or substantially orthogonal to a vertical direction (e.g., from a horizontal direction). In some cases, a liquid-to-air cooling unit may not include an inlet manifold and hosing from electrical cabinets can connect directly to plumbing elements of the cooling unit.

It can be advantageous to measure parameters of a fluid flowing into a cooling unit (e.g., LACU 200). For example, an inlet temperature of a fluid in a cooling unit can be measured and compared to an outlet temperature of fluid of a cooling unit to determine a total cooling rate for the unit. As shown, the inlet manifold can include a sensor module 307. The sensor module 307 can include one of more sensors for measuring a parameter of a fluid at the inlet. For example, the sensor module can include a temperature sensor, a pressure sensor, a flow rate sensor, etc. Values from sensors of the sensor module 307 can be compared to values from other sensors along the liquid coolant circuit, as can facilitate a calculation of efficiency and cooling power provided by one or more components of LACU 200. As an example, an outlet manifold 344 can include a sensor module 345 which can be substantially identical to the sensor module 307, and a temperature value from a sensor of the sensor module 345 can be compared to a temperature value from a temperature sensor of the sensor module 307 to obtain a differential temperature between the inlet and outlet of the LACU 200. In some embodiments, a differential pressure or flow rate can be calculated additionally or alternatively to the differential temperature measurement described.

Liquid coolant of a liquid coolant circuit can flow directly from an inlet (e.g., an inlet manifold) into a liquid-to-air heat exchanger. It can be advantageous to cool a liquid before providing the liquid to other plumbing elements or flow control components (e.g., pumps), as heated liquid can produce more wear on components than a cooled liquid. In this regard, FIG. 3 illustrates a liquid-to-air heat exchanger 202 (LAHX) positioned within the LACU 200. The LAHX 202 includes an inlet pipe 310 for receiving a heated fluid, and an outlet pipe 312 for outputting a cooled fluid from the LAHX 202. Additionally, the LAHX 202 can include a plurality of internal loops 314 to increase a length of a flow path of coolant through the LAHX 202 and maximize a surface area available for heat transfer between the fluid of the liquid coolant circuit and air.

Inlet and outlet pipes of an air-to-liquid heat exchanger can include ports for injecting liquid into the liquid-to-air heat exchanger and removing air or liquid from the liquid cooling circuit or regulating pressure along the liquid coolant circuit. For example, components of a liquid cooling system can be "charged" (e.g., filled) with a coolant before installation or operation of the system. Additionally, system components can be drained of fluid in the system, including, for example, when the component is removed for servicing, or when a coolant of a system is replaced. Thus, a liquid-to-air cooling unit can include fluid fill and drain ports to charge all components of the unit, and individual components of the unit can also include liquid fill and drain ports to charge the individual components. For example, as shown, the LAHX 202 can include a liquid port 316 along the outlet pipe 312 and a liquid port 318 along the inlet pipe 310. Either or both of the liquid ports 316, 318 can comprise quick disconnect fittings for selectively connecting fill lines, drain lines, or air bleed lines to the respective liquid ports 316, 318. As shown, the ports are connected to a liquid fill/drain line 320, which can be fluidly connected to the fill/drain port 225 described with respect to FIG. 2. However, in some cases, there is no piping or hosing connected to the ports 316, 318 in normal operation of the LACU 200.

In some cases, air within a liquid coolant circuit can cause damage to components along the liquid cooling circuit, including, for example, to pumps of a liquid cooling circuit, or to electronic components to be cooled. In some cases, air within a liquid cooling circuit can also reduce a total cooling efficiency of the system, so that greater power is required to cool electronic components. Systems can therefore be provided for a liquid-to-air cooling unit to remove air (e.g., bleed air) from piping of a liquid cooling circuit. As air is less dense than water, air bubbles will tend to rise to a highest point along a liquid flow path of a liquid cooling circuit, and therefore, air bleed valves can be provided at points of the liquid flow path of a liquid cooling circuit that are elevated (e.g., vertically higher) relative to other portions of the piping or plumbing elements. As shown in FIG. 3, the liquid ports 316, 318 can be located at or near a top of the respective pipes 310, 312. Flow of fluid from one or more of the ports 316, 318 can be redirected to an air bleed valve 322. In normal operation of the LACU 200, the air bleed valve 322 can be fluidly isolated from the liquid cooling circuit. However, when an operator is performing an air bleed operation (e.g., when initially charging all or a portion of the LACU 200 with a fluid), the air bleed valve 322 can be fluidly connected to either or both of the ports 316, 318 to bleed air therefrom. In some embodiments, as shown, the air bleed valve 322 can include a connection hose 324 which can be connected to either or both of liquid ports 316, 318 to bleed air from the liquid cooling circuit at either respective location. The air bleed valve 322 can be secured to the cabinet with a mounting bracket 323.

In some cases, it can be useful to include components within a liquid-to-air cooling unit to regulate or maintain a set pressure within the unit, or to prevent a pressure from exceeding a certain value. For example, if a heat of a fluid in a liquid cooling circuit increases, the fluid within the circuit can expand, which can increase a pressure along all or a portion of the liquid cooling circuit. As illustrated, the LACU 200 can include an expansion tank 326. The expansion tank 326 can be in fluid communication with the liquid cooling circuit and can receive fluid from the liquid cooling circuit when a pressure in the liquid cooling circuit exceeds a pressure charge of the expansion tank 326. In the illustrated embodiment, the expansion tank is fluidly positioned along a hot side of the liquid cooling circuit and is connected to the inlet pipe 310 of the LAHX 202 at a liquid port 328. The liquid port 328 can be positioned along the inlet pipe 310 to provide pressure regulation on the hot side of the liquid cooling circuit (e.g., where liquid of the liquid cooling circuit is more prone to expansion due to an increased heat relative to other portions of the cooling unit 200). In some embodiments, an expansion tank of a liquid-to-air cooling system can be positioned at other points along a liquid cooling circuit. For example, an expansion tank can be installed downstream of a liquid-to-air heat exchanger, or downstream of a replaceable pump unit. In some embodiments, a liquid-to-air cooling unit may not include an expansion tank. In some embodiments, a liquid-to-air cooling unit can include more than one expansion tank or cannot include an expansion tank.

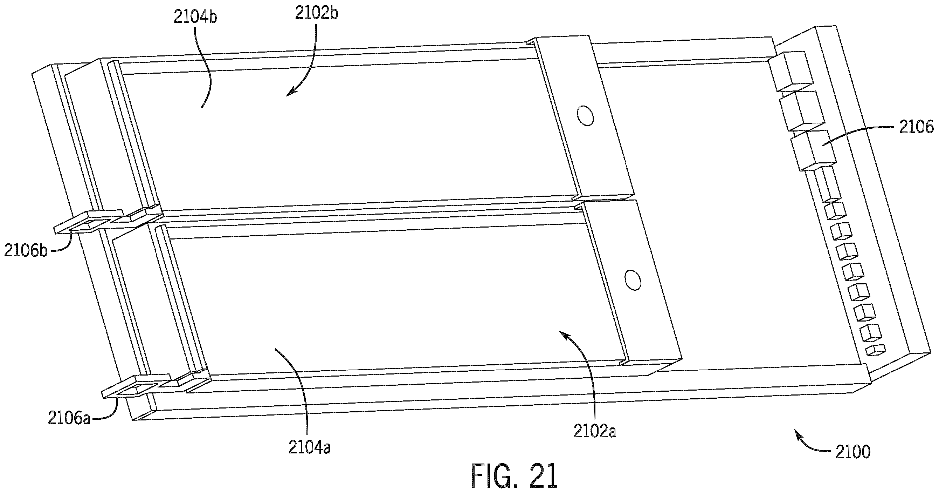

As further shown in FIG. 3, the outlet pipe 312 of the LAHX 202 can be fluidly connected to the RPU 204. For example, an angled elbow connector 330 can be positioned at an outlet end of the outlet pipe and can direct fluid flow generally towards an inlet port 332 of the RPU 204. The angled elbow connector 330 can ensure a smooth (e.g., as opposed to turbulent) flow of fluid into the RPU. Fluid can be pumped through the RPU 204, as further described below, and may exit the RPU 204 at an output port 334. Flexible hosing 336 can be used to fluidly connect the RPU 204 to the liquid cooling circuit, and the flexible hosing 336 can be connected to the ports 332, 334, and other plumbing components (e.g., the outlet pipe 312 or the elbow connect 330) through clamping systems 338 (e.g., tri-clamp flange systems). In other embodiments, cooling units may not include an RPU or pumping units and may rely on a pressure provided from a facility (e.g., as illustrated in schematic of FIG. 21).

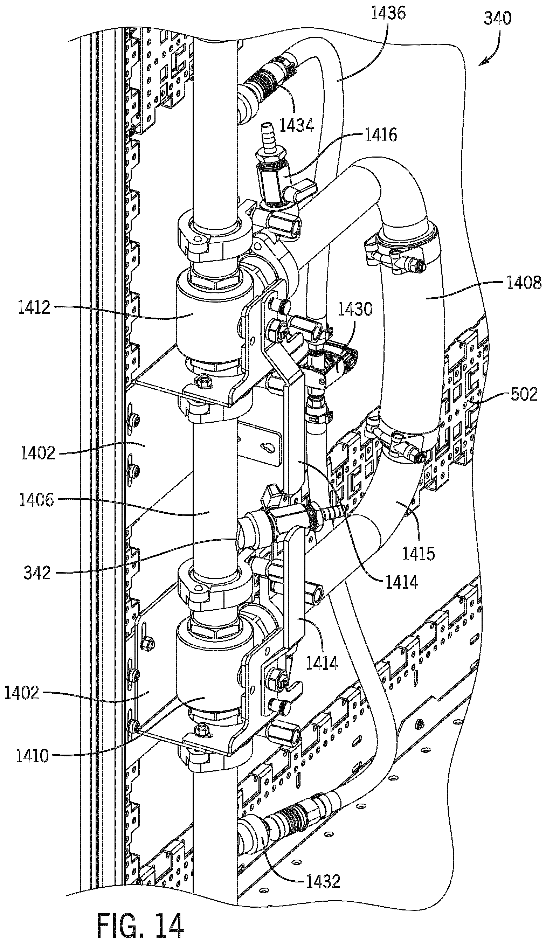

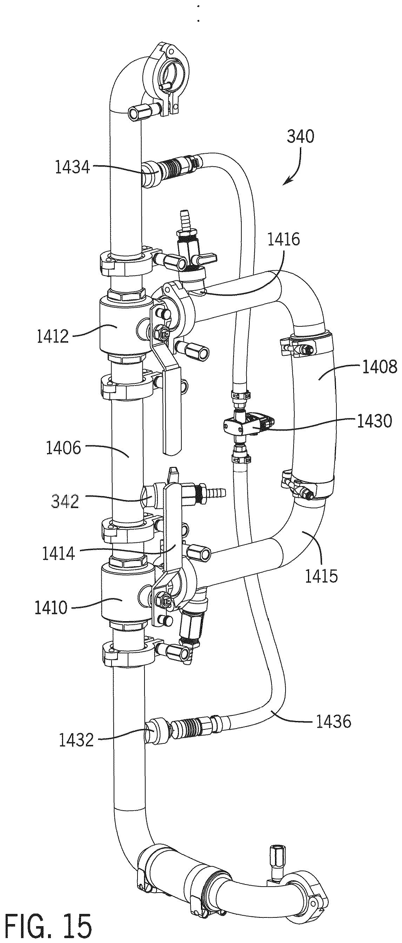

In some cases, it can be advantageous to provide filtration systems for fluid of a liquid cooling circuit (e.g., filers of a liquid-to-air cooling unit). Impurities and particulate matter in a fluid of a liquid cooling circuit can damage plumbing elements along a liquid cooling circuit and electronics cooled by the cooling system, as well as reduce a cooling efficiency. As illustrated in FIG. 3 and described further with respect to FIGS. 14 and 15, a filtration assembly 340 can be provided within the LACU 200. In some embodiments, the filtration assembly 340 can be immediately downstream of the RPU 204. The filtration assembly 340 can include at least one fluid filter 342.

As further shown in FIG. 3, an outlet manifold 344 can be provided for fluid of the liquid cooling circuit to exit the LACU 200. The fluid exiting the outlet manifold 344 can be at a lower temperature than the fluid flowing into the LACU 200 at the inlet manifold 302. The description of the inlet manifold 302 can be applicable to the outlet manifold as well, and both manifolds 302, 344 can meet the description of the manifold 1300 shown and described with respect to FIG. 13.

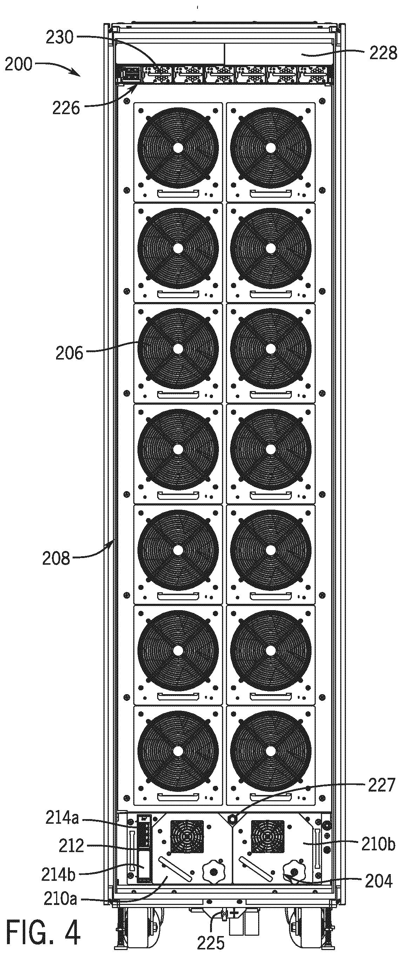

Connections for electricity can be provided within a data center to power electrical elements within cabinets installed in the data center. In some cases, redundant power supplies can be provided for a cabinet to ensure continued operation of the electrical components within a cabinet on failure of a single power supply. In this regard, FIG. 3 illustrates power inlets 350 to receive respective power connections from a data center. The power inlets 350 can be in direct electrical communication with the power supply unit 226 and the power supply modules 230 (shown in FIG. 2) can operate to transform the received power to have desired characteristics (e.g., to convert from AC to DC, to produce a desired output voltage or current, etc.). In some cases, the power inlets can receive a three-phase AC power signal. In some cases, a LACU 200 can operate with power from only one of the power inlets 350, and the opposite inlet can be used when there is a failure in the power source connected to the primary power inlet 350, or when the connection to the primary power inlet 350 is removed. In some cases, a first one of the power inlets 350 provides powers to a first plurality of power supply modules (e.g., three out of six of the power supply modules 230 illustrated in FIGS. 2 and 4) and a second one of the power inlets provides power to a second plurality of power supply modules (e.g., another three of the six power supply modules 230 shown in FIGS. 2 and 4). In some cases, an operator of the LACU 200 can set a mode in which to operate the LACU 200, which can include a power supply configuration including whether the power inlets 350 are used in a primary/backup configuration, whether the power inlets 350 each power a corresponding one or more power supply modules 230, or other configurable settings of a power supply unit.

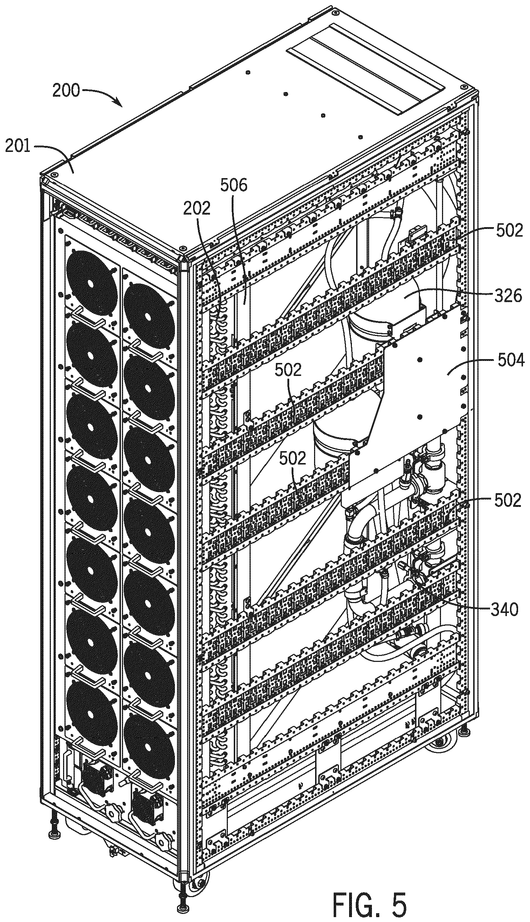

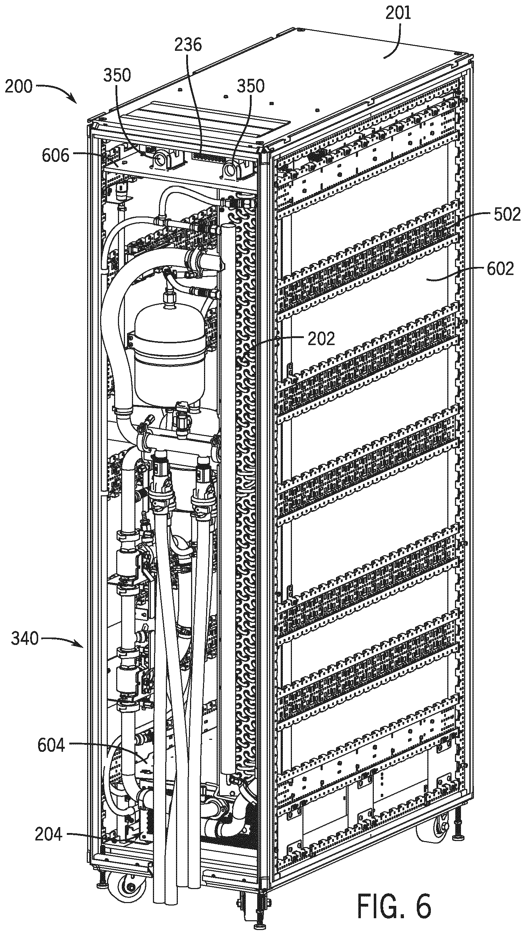

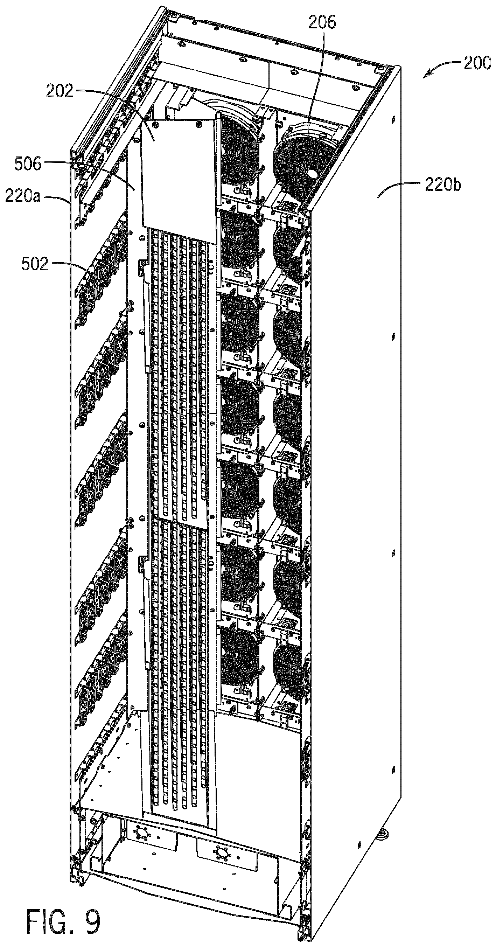

A cabinet of a liquid-to-air cooling unit can include structural components for mounting elements of the liquid-to-air cooling unit within the cabinet. For example, FIGS. 5 and 6 show the liquid-to-air cooling unit 200 with the side panels 220 removed to illustrate structural components of the cabinet 201. As shown, a plurality of mounting bars 502 can be provided that can span the cabinet 201 from a front to a rear of the cabinet 201. These mounting bars 502 can be spaced apart from each other in a vertical direction. As shown, plumbing components (e.g., the LAHX 202, filtration assembly 340, and expansion tanks 326) can be secured to the cabinet 201 at one or more of the mounting bars 502. For example, as shown in FIG. 5, an expansion tank mounting plate 504 is shown mounted to the mounting bars 502 of the cabinet 201. As shown, the expansion tank mounting plate 504 is secured to two contiguous mounting bars 502, which can provide greater stability to the system. Correspondingly, in some embodiments a filter mounting plate can be provided to mount the filter assembly 340 to the mounting bars 502 of the system. A vertical bracket 506 can be secured to a plurality of mounting bars 502 and can secure the LAHX 202 to the cabinet 201, as further described with respect to FIG. 9.

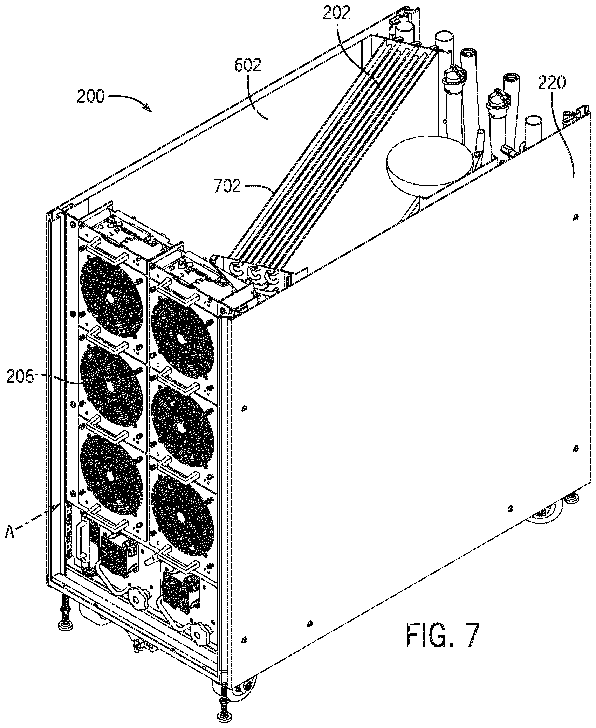

In some cases, a liquid-to-air cooling unit can include elements for directing air flow to maximize a heat transfer efficiency across a liquid-to-air heat exchanger. For example, as shown in FIG. 6, a baffle plate 602 can be provided on at least one side of the cabinet 201 of the LACU 200. The baffle plate 602 can prevent air flow out of the side of the cabinet before the air flow traverses the LAHX 202, thus increasing the cooling efficiency of the system by maximizing the flow of air through the LAHX 202. In some embodiments, baffle plates can be provided on both sides of a liquid-to-air cooling unit, or on either side of a liquid-to-air cooling unit. For example, it can be advantageous to maximize the flow of cool air across a heat exchanger, while it can be less important to control the flow of air once it has transferred heat from a liquid within the liquid-to-air heat exchanger. Thus, a direction of air flow across the heat exchanger can be relevant to determining a location or number of baffle plates of a liquid-to-air cooling unit. For example, as shown in FIG. 7, fans 206 of the LACU 200 can operate to produce an air flow in the A direction as shown, from the front of the LACU 200 to the rear of the LACU 200. The baffle plate 602 and the LAHX 202 can define a flow path of the air, with the baffle plate 602 preventing an air flow out of the side of the cabinet 201 shown. Substantially all air flow can be directed across a surface of the LAHX 202 to maximize a rate of heat transfer and an efficiency of a heat transfer (e.g., to reduce a power required for the fans 206 to produce a given heat transfer rate). In other embodiments, fans can direct air flow in a direction opposite direction A (e.g., from a rear to a front of the LACU 200), and it can be advantageous to position a baffle plate along the opposite lateral side of the LACU 200, to direct a maximal volume of cool air across the LAHX 202. In some cases, side panels (e.g., side panels 220 of LACU 200) can function as a baffle for air flow, and in some embodiments, a liquid-to-air heat exchanger may not include baffle plates.

In some cases, a liquid-to-air heat exchanger can be sized and positioned to maximize air flow through the heat exchanger. For example, a rate of heat transfer from a liquid to an air along a liquid-to-air heat exchanger can be increased by increasing a surface area of the heat exchanger. Increasing a surface area of a liquid-to-air heat exchanger can include maximizing a surface area exposed to air flow by positioning a heat exchanger at an oblique angle relative to a direction of air flow. IA surface area of a heat exchanger can be minimal when a heat exchange surface of a heat exchanger is perpendicular to a flow of air. As shown in FIG. 8 the LAHX 202 can be positioned along an axis B. The axis B can be positioned at an oblique angle C relative to a first side panel 220a at a first lateral side of the LACU 200. In the illustrated embodiment, the angle C is about 22.5 degrees. In some embodiments, an angle between a heat exchanger and a side panel of a liquid-to-air heat exchanger can be between 20-30 degrees, between about 30-40 degrees, between about 40-50 degrees, or up to 90 degrees. In some cases, an angle of a heat exchanger relative to a side panel can decrease with an increased depth of a liquid-to-air cooling unit. As also shown in FIG. 6, for example, the LAHX 202 can also span a height within the cabinet 201, between a plate 604 on a top of the RPU 204, and a plate 606 at a lower end of the power supply unit 236. In other embodiments, a heat exchanger can span other heights within a cooling unit, including, for example, when an RPU occupies a greater height (e.g., 8U).

Brackets for securing a heat exchanger within a cabinet of a cooling unit can be used to install heat exchangers at different points along a heat exchanger. In some examples, a bracket for a heat exchanger can be a sheet metal bracket and can be bent to accommodate different mounting angles (e.g., angle C) of the heat exchanger relative to side panels of the cooling unit. For example, as further illustrated in FIG. 8, a first mounting bracket 506a can secure the LAHX 202 to the cabinet 201 at a lateral side of the LACU 200 including a first lateral side panel 220a, and a second mounting bracket 506b can secure the LAHX 202 to the cabinet 201 at a second lateral side of the LACU 200 corresponding to a second lateral side panel 220b. Depending on a width of a heat exchanger, the heat exchanger can be mounted at different locations along respective lateral sides, and the mounting brackets 506a, 506b can deform to secure a heat exchanger at a desired angle within the cabinet 201.

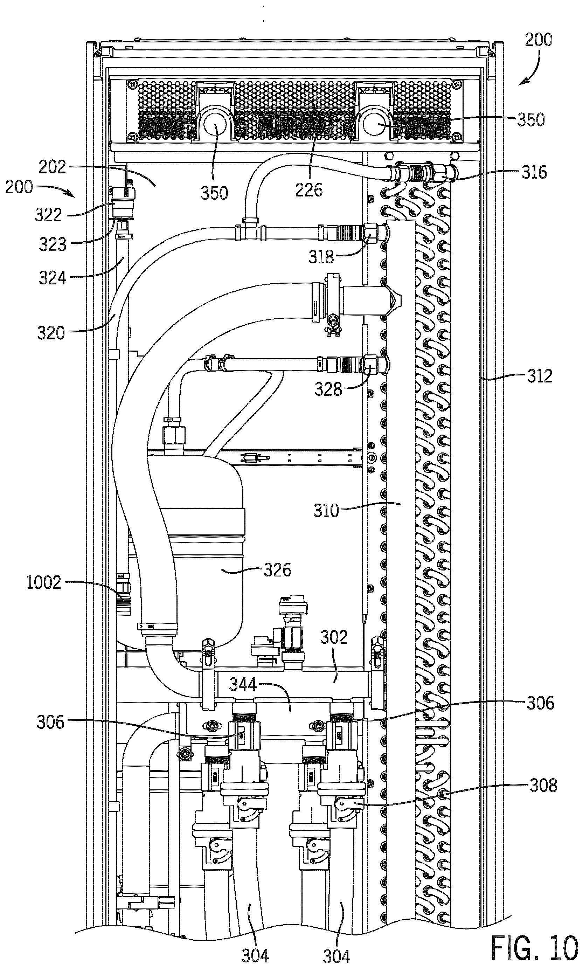

FIG. 10 is a partial rear view of the LACU 200, illustrating components housed in a top portion of the LACU 200. As described above, the LACU 200 can include the air bleed valve 322, which can be fluidly isolated from the fluid cooling circuit in normal operation of the LACU 200. As shown, the air-bleed valve 322 can be secured to the cabinet 201 (e.g., secured to a mounting bar 502 as shown in FIG. 5) via a mounting bracket 323. As shown, the hose 324 can extend downwardly (e.g., can hang from the bracket 323, and can include a quick connect fitting 1002 at the end of the hose. The quick connect fitting 1002 can be a female quick connect fitting and can be connected to either of the liquid ports 316, 318. For example, when bleeding air along the liquid cooling circuit, one or more of the connections from fill/drain hose 320 can be disconnected from the respective liquid port 316, 318, and the quick connect fitting 1002 of the air bleed valve 322 can be connected to the respective liquid port 316, 318 to bleed air therefrom. In some embodiments, an air bleed valve can be fluidly connected to the liquid cooling circuit during an operation thereof and can operate to continually bleed air from hosing thereof.

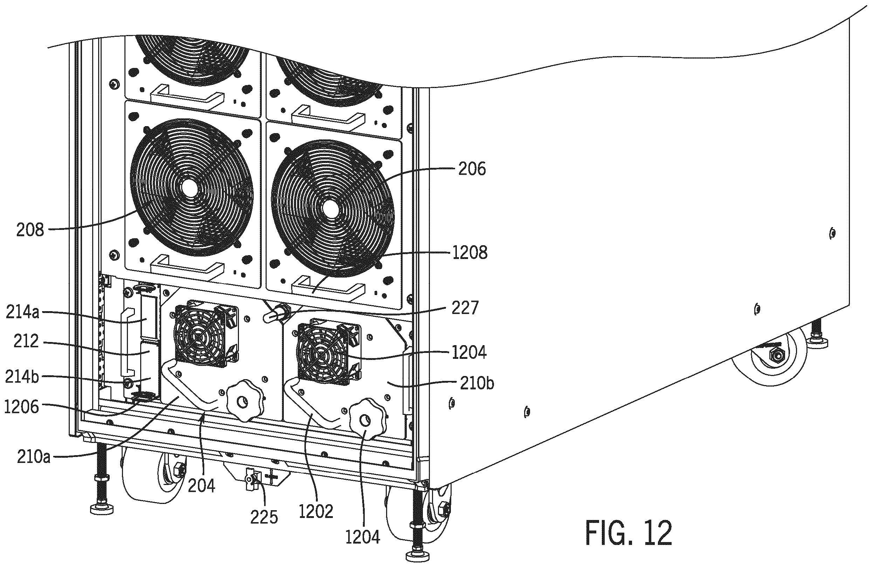

As discussed above, components of a liquid-to-air cooling unit can be redundant and hot-swappable, which can minimize a disruption to the operation of the cooling unit when a single component fails. Accordingly, hot-swappable elements of a cooling unit can include features to facilitate insertion and removal of the respective components. For example, FIG. 12 is a partial front isometric view of the LACU 1200, illustrating mechanical features for facilitating insertion and removal of components of the LACU 200. For example, as shown, each of the pump cassettes 210a, 210b can include a cassette handle 1202 to provide an operator a gripping point for removing or installing the respective pump cassette into the RPU 204. In some examples, a pump cassette can include more than one handle, to provide gripping locations for two hands of an operator, for example. In some cases, cassettes of an RPU can include features for locking the cassette in place or unlocking the cassette to enable removal. As further shown in FIG. 12, each pump cassette 210a, 210b can include a locking knob 1204, which, when rotated in a first direction (e.g., clockwise) can engage a locking mechanism of the RPU to lock the respective cassette 210a, 210b in place within the RPU. The locking knob 1204 can be rotated in a second direction opposite the first direction (e.g., counterclockwise) to disengage the locking mechanism, and allow translation of the pump cassette 210a, 210b relative to the RPU 204. As further shown in FIG. 12, fans 206 of the LACU 200 can include fan handles 1208 to provide a gripping location to allow an operator to remove the respective fan 206.

As further shown in FIG. 12, the hot swappable control modules 214a, 214b can also include cassette support features to facilitate removal and installation of the respective control modules 214a, 214b. As shown, each control module 214a, 214b can include an engagement tab 1206. The engagement tab 1206 can provide a gripping location (e.g., a handle) for an operator to install or remove the respective control module 214a, 214b from the RPU 204. Additionally, the engagement tab 1206 can include retention features to secure the respective control module 214a, 214b in place within the RPU 204. For example, protrusions of the grasping tab (not shown) can snap ably engage geometries of the RPU 204 to retain the control module 214a, 214b in place once inserted. To disengage the protrusions from the RPU 204 and allow removal of the respective control module 214a, 214b, an operator can displace the respective engagement tab 1206 in a vertical direction (e.g., along a height of the LACU 200), and can subsequently pull the engagement tab 1210 to remove the control module 214a, 214b. In other embodiments, other retention mechanisms can be used to retain a control module in place.

FIG. 13 illustrates a manifold, which can be inlet manifold 302 or the outlet manifold 344 (e.g., a supply or return manifold), as illustrated in FIGS. 3 and 6. In the illustrated embodiment of FIGS. 13, the manifold 1300 is oriented in a downward direction, relative to the cabinet, as may allow hosing 1302 from the electrical equipment cabinets to be routed through a cutout in the bottom of the cabinet, or out through the cutout 224 in the side panel 220, as illustrated in FIG. 2. As shown, an elbow connection 1304 extends from the left of the manifold. For an inlet manifold (e.g., manifold 302 illustrated in FIG. 3), the elbow connection 1304 couples a hosing 1306 to the manifold that routes the coolant to the heat exchanger (e.g., the LAHX 202, illustrated in FIG. 3). When the manifold 1300 is an outlet (e.g., a supply) manifold, the elbow connection 1304 and hosing 1306 fluidly connect the manifold 1300 to a filter assembly of a liquid-to-air cooling unit (e.g., filer assembly 340 shown in FIG. 3). On the right side of the illustrated manifold 1300, (i.e., a right side relative to the drawing sheet), a cap 1308 is provided to prevent fluid flow out of the right end of the manifold 1300. Though the manifold 1300 is shown in an orientation with the hosing 1302 extending downwardly (e.g., in a bottom feed configuration), the manifold 1300 may be positioned so that the hosing 1302 can extend upwardly from the manifold. To reverse the orientation, the manifold 1300 can be removed from the bracket 1310 securing the manifold 1300 to a cabinet (e.g., the cabinet 201 shown in FIG. 3). The manifold 1300 may be rotated and reinstalled in the bracket 1310, with the side of the manifold 1300 previously shown at the right being positioned at the left, and the side of the manifold shown on the left being reinstalled on the right. So positioned, the cap 1308 can be repositioned to the opposite of the manifold 1300, and the elbow connection 1304 can be repositioned to the opposite side of the manifold. The hosing 306 can then extend downwardly, and the hosing 1302 can extend upwardly relative to a cabinet (e.g., the hosing can be in a top feed configuration for the cabinet 201 shown in FIG. 2).

It can be advantageous to measure one or more properties of fluid at a manifold, including an inlet and outlet manifold. For example, a first temperature at an inlet manifold can indicate a heat of fluid returning from electrical equipment, and a temperature measured at a second manifold can indicate a heat of fluid being supplied to cool the electrical equipment. A difference between the first temperature and the second temperature can indicate a total cooling efficiency of a cooling unit and can be provided to control systems of the unit (e.g., as described below) to allow components of the cooling unit to be controlled to achieve a desired value (e.g., a set point) for a differential temperature between the inlet and the outlet. As illustrated, then, the manifold 1300 can include a sensor module 1312 (e.g., similar or identical to sensor modules 307, 345 shown in FIG. 3) positioned along the flow path of a fluid in a liquid cooling circuit. In some examples, as described, the sensor module 1312 can include a temperature sensor. In some cases, the sensor module can additionally or alternatively measure other properties of a fluid in the liquid cooling circuit, including, for example, a flow rate, a pressure, a density, a chemical composition etc. In some embodiments, sensors can be provided along different points of a flow path of fluid in a liquid cooling circuit and can be inputs or target values for a control system of a cooling unit.

A filter assembly for a cooling unit can include features for providing redundancy of components of the filter assembly and indicating a need for servicing of components of the filter assembly. FIGS. 14 and 15, for example, further illustrate the filter assembly 340, according to some embodiments. As shown in FIG. 14, the filter assembly 340 can be secured to the cabinet 201 with sheet metal brackets 1402 fixed to mounting bars 502 of the cabinet 201. As shown, piping of the filter assembly 340 can define a primary flow path 1406 and a secondary flow path 1408. An inlet valve 1410 can define an entry for each of the primary flow path 1406 and the secondary flow path 1408. An outlet valve 1412 can define an exit for fluid from each of the primary flow path 1406 and the secondary flow path 1408. The valves 1410, 1412 can include handles 1414 to allow the valves to be moved between a respective first position, in which flow is allowed exclusively through the primary flow path 1406, a secondary position in which fluid flow is allowed exclusively through the secondary flow path 1408, and a third position in which fluid flow is not allowed through either of the primary or secondary flow paths 1406, 1408. In some embodiments, either or both of the valves 1410, 1412 can be electronically controlled (e.g., through linear actuators, servo motors, etc.), and do not require manual engagement. In some embodiments, the valves 1412, 1418 are ball valves. In some embodiment, the valves 1412, 1410 can be any known valve with the capability of routing fluid flow as described. In some cases, as shown, the primary flow path 1406 does not include bends (e.g., fluid flows in a straight line from valve 1410 to valve 1412), and the secondary flow path 1408 includes one or more bends 1415 in piping thereof. Thus, the secondary flow path 1408 can introduce a greater pressure drop for fluid, compared with the primary flow path 1406.

As further illustrated in FIGS. 14 and 15, the primary flow path 1406 can include a primary filter 342, and the secondary flow path can include a secondary fluid filter 1416 for removing particulate matter and impurities from a fluid along either of the respective flow paths 1406, 1408. In some cases, particulate matter can build up within one of the respective filters 342, 1416, and the filter must be removed for servicing. To service one of the filters 342, 1416, an operator can move the valves (e.g., via the handle 1414) to a position to allow fluid flow through the flow path 1406, 1408 not including the filter to be serviced. Fluid can then flow through the other filter 342, 1416 while the filter is being serviced, and thus a maintenance to a filter does not introduce a down time for the LACU 200.

In some cases, a filter assembly can include features for detecting a state of a filter (e.g., for indicating a need to service a filter). For example, when particulate matter builds up within a filter, flow of fluid through the filter can be restricted, and a pressure upstream of the filter can be greater than a pressure downstream of the filter. Thus, measuring a pressure upstream and downstream of a filter can allow a control system or an operator to determine a pressure drop across a filter, and when a pressure drop exceeds a threshold value, this can indicate a need to service the filter. In this regard, FIGS. 14 and 15 illustrate a differential pressure sensor 1430 provided along the fluid coolant circuit. The differential pressure sensor 1430 can measure a pressure difference between a fluid at an upstream port 1432 and a downstream port 1434. The upstream port 1432 can be located upstream of both of the primary flow path 1406 and the secondary flow path 1408, and the downstream port 1434 can be located downstream of both of the primary flow path 1406 and the secondary flow path 1408. In some embodiments, as illustrated, hosing 1436 can be connected to each of the upstream port 1432 and the downstream port 1434 with quick disconnect fittings, to facilitate a servicing and replacement of the differential pressure sensor 1430. Thus, the differential pressure sensor 1430 can be removed and reinstalled without the use of tools, and without providing a disruption or interruption to the system operation. The differential pressure sensor can be operatively connected to a control system of the LACU 200, and the control system can provide an indication to an operator (e.g., an alert, a message, a visual indication, etc.) that one or more of the filters 342, 1416 require servicing.

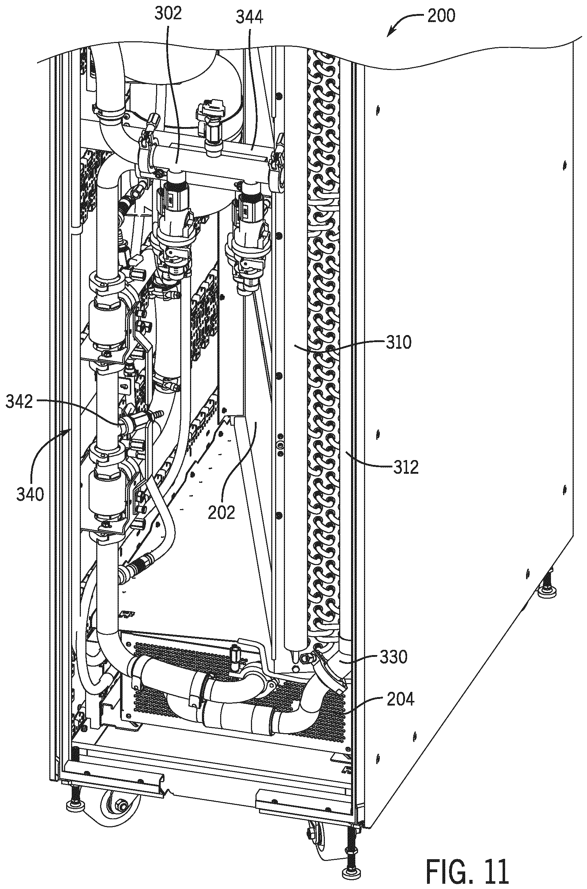

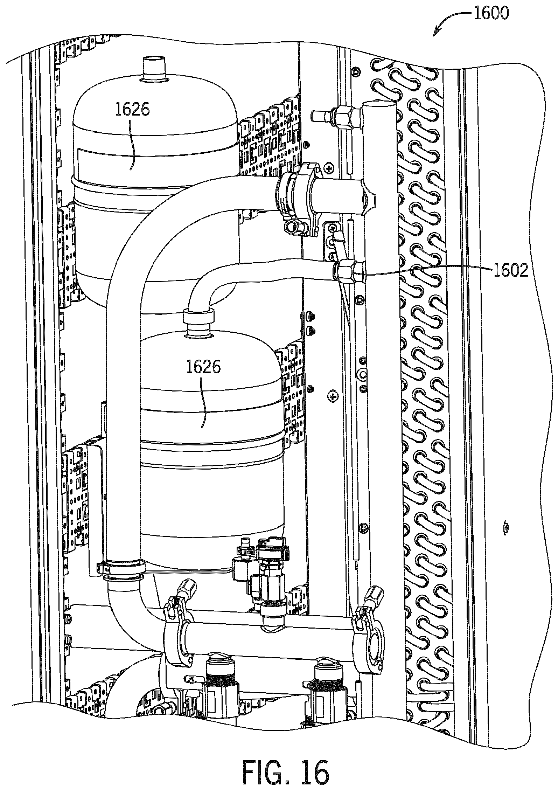

In some embodiments, pressure regulation systems of a liquid-to-air heat cooling unit can provide redundancy to the system and can be operated to allow a servicing or replacement of one pressure regulation system without causing a downtime to the unit. For example, FIG. 16 illustrates a LACU 1600 which can be substantially similar to LACU 200 illustrated in FIGS. 2-12. As shown, however, LACU include two expansion tanks 1626. The expansion tanks 1626 can each be charged for a rated pressure (e.g., 1 bar), and can be connected to plumbing of the LACU 1600 with quick disconnect fittings. Thus, one of the expansion tanks 1626 can be removed for servicing or replacement (e.g., by a toolless disconnection of the disconnect fitting from the tank 1626) and the other expansion tank 1626 can continue to regulate a pressure within the LACU 1600. In some embodiments, a LACU can include more than two expansion tanks, or only one expansion tank, or no expansion tanks. In some cases, only one of the expansion tanks 1626 is connected to the liquid cooling circuit at a given time, and an operator can manually connect a backup expansion tank 1626 to the liquid coolant circuit (e.g., at liquid port 1602), when the connection to the other expansion tan 1626 is removed.

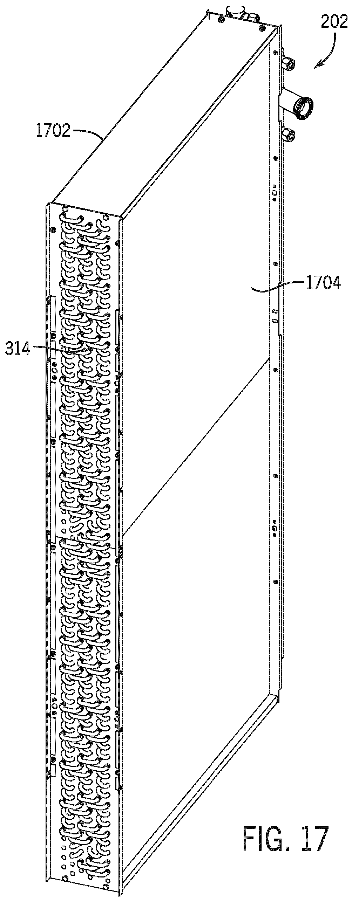

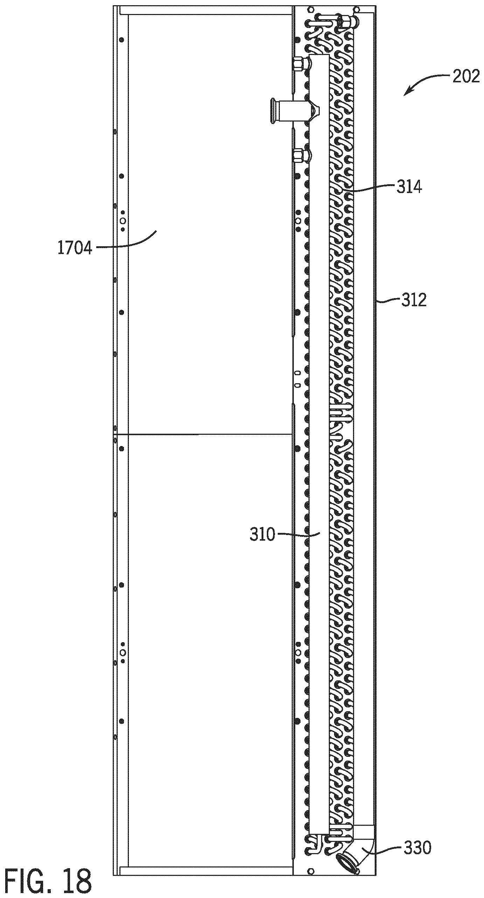

FIGS. 17 and 18 further illustrate the LAHX 202. The LAHX includes a front surface 1702 and rear surface 1704, which can each define a rectangular surface which, when installed, can span a width of the LACU 200, as described above. The area of these surfaces 1702, 1704 can provide an interface at which heat can be transferred from the liquid coils 314 within the LAHX 202 to the surrounding air. FIGS. 17 and 18 illustrate portions of the liquid cooling coils 314 protruding out from sides of the LAHX 202, and the combination of the total length of the coils 314, and the surface area of the coils 314 exposed to the surrounding air maximizes a cooling efficiency of the LAHX 202.

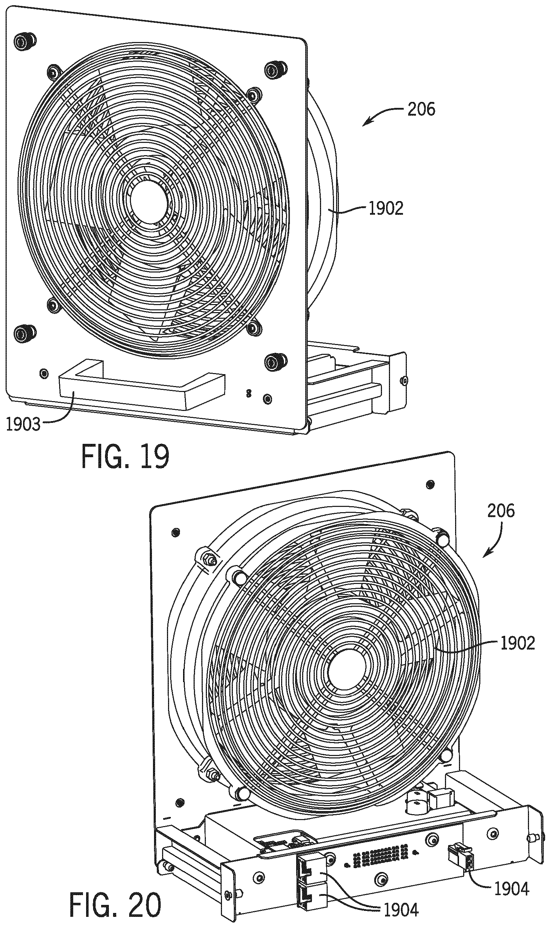

FIGS. 19 and 20 illustrate an embodiment of an individual fan module 1900. The fan module can 1900 can be substantially similar to (e.g., identical to) fans 206, shown in FIG. 2. As shown, the fan module 1900 can include an impeller 1902 mounted on a back side of the fan module 1900. The fan modules 1900 can include a handle (e.g., as described with respect to handle 1208 shown in FIG. 12) to facilitate insertion and removal of the fan module 1900 into a liquid-to-air cooling unit (e.g., LACU 200 illustrated in FIG. 2-12). The fan module 1900 can also include one or more blind mate connectors 1904 to engage corresponding electrical connections and interfaces of a LACU. The fan module 1900 can be a hot swappable fan module and can be replaced during operation of a LACU. In some cases, the fan module includes sensors (not shown) for sensing properties of an air flowing through the fan, or of an ambient air. For example, a fan module can include flow sensors to measure a rate of flow of air, temperature sensors, and/or humidity sensors. Additionally, a fan module can include a fan controller to control operating aspects of the fan (e.g., a fan speed). A controller of the fan can receive instructions from a main controller of a cooling unit (e.g., over a wired or wireless connection, a Modbus, ethernet, etc.). When a controller of a fan is not connected to a main controller, the fan controller can operate the fan according to preprogrammed algorithms to retain a speed, increase a speed, decrease a speed, or stop the impeller of the fan.

FIG. 21 illustrates a control unit 2100 for use in a LACU (e.g., similar or identical to the control unit 212 of the LACU 200, as shown in FIGS. 2 and 12). As shown, the control unit 2100 can include two compartments 2102a, 2102b for housing two separate control module 2104a, 2104b (e.g., similar or identical to control modules 214a, 214b shown in FIGS. 2 and 12), which can alternately be referred to as controller cartridges. The control unit can 2100 can be sized and configured to be received into a slot of an RPU (e.g., RPU 204 illustrated in FIGS. 2 and 12). Control modules 2104a, 2104b can include blind mate connecter (not shown), which can engage with corresponding electrical connections of an RPU when the control unit 2100 is installed therein. In some embodiments, the control modules 2104a, 2104b are identical, and can provide identical controls for a LACU. In some embodiments, electronic components of a LACU (e.g., fans 206 and RPU 204 illustrated in FIG. 2) can be controlled by one of the control modules 2104a, 2104b. In some embodiments, the control modules 2104a, 2104b include failover capabilities, so that when a primary one of the control modules 2104a, 2104b is removed from the control unit 2100, the other one of the control modules 2104a, 2104b assumes control of electrical components of the LACU. In some embodiments, a state of the system can be continually synced between the control modules 2104a, 2104b to facilitate failover when one of the control modules 2104a, 2104b fails or is replaced. In some example, each control module 2104a, 2104b can provide a different mode of operation or different control logic for the LACU, and the provision of two controller units can allow a user to selectively choose a particular control module 2104a, 2104b to use when the control unit 2100 is provided in the system. Alternatively, in some embodiments, one controller of the control module may provide a base functionality with the controller in the other compartment providing extension of functionalities for specific applications or embodiments of the sidecar unit. As shown, an interface board 2106 for inputs and outputs can also be provided in the control unit 2100 for connection to power, fans, pumps, and sensors. These interfaces can connect the controllers of the respective control modules 2104a, 2104b to the pump and fans of the liquid-to-air cooling unit (i.e., the sidecar unit), and the controller can adjust a speed of the fans or of a motor of the pumps in response to system parameters, as described further below.

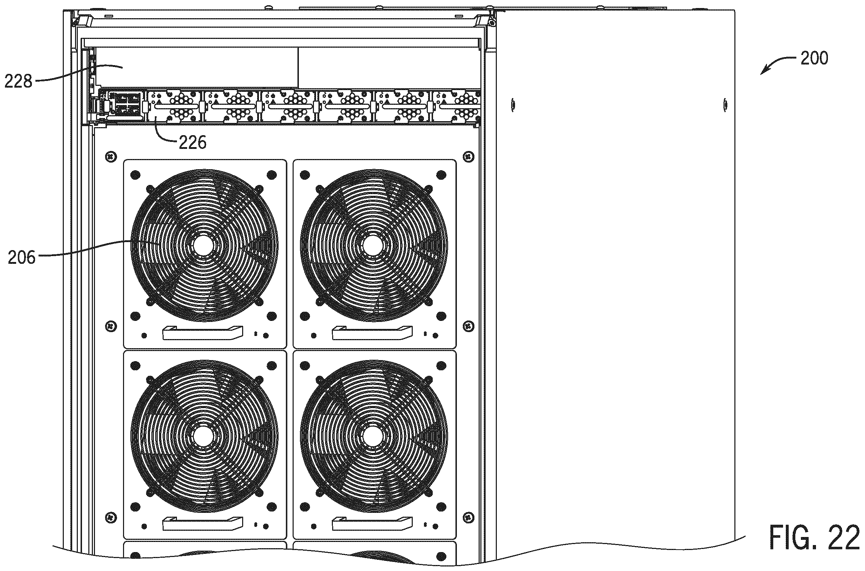

A power supply unit (e.g., power supply unit 226 shown in FIG. 2) can be provided for a LACU to provide power to electronic components of the LACU at specific voltages, and with specific power characteristic (e.g., frequency, current, voltage, etc.). FIG. 22 illustrates the power supply unit 226 installed in a top of the LACU 200, and FIG. 23 illustrates the power supply unit 226. The power supply unit can include features and systems for providing redundancy and resiliency to a LACU, or other cabinets with electronic equipment which may be powered thereby. For example, as shown, the power supply unit 226 includes a plurality (e.g., 6) of hot-swappable power supply modules 230a, 230b, 230c, 230d, 230e. In some cases, each power supply module 230 can be a 3kW power supply module. In other embodiments, power supply modules can provide about 1 kW, 2kW, 4kW, or 5kW of power.

In some examples, a LACU (e.g., LACU 200 illustrated in FIGS. 2-12) can operate with a threshold number of power supply modules in operation. For example, a LACU can require a minimum of one power supply module, a minimum of two operational power supply modules, a minimum of three operational supply modules, a minimum of four operational supply modules, a minimum of five operational supply modules, etc. Thus, a system, including LACU 200 illustrated in FIGS. 2-12, can withstand the loss of one or more power supply modules 230 without stopping an operation of the LACU 200, as long as the number of operational power supply modules 230 exceeds a minimum threshold. As shown, each power supply module 230 can include a handle 2304 which can facilitate easy removal and installation of the power supply module 230 within the power supply unit 226. As further shown, a controller module 2302 can be provided in a power supply unit and can provide interfaces for wired connections into the power supply unit (e.g., ethernet connections, USB connections, etc.). In some cases, the controller module 2302 can include a controller for controlling an operating mode for power supply modules 230 of the power supply unit and can provide interfaces to allow a user to set an operating mode of the power supply unit 226.

In some cases, each power supply module of a power supply unit can be connected to (e.g., can receive power from) each power inlet of a pair of redundant power inlets (e.g., inlets 350, shown in FIG. 10). For example, all of power supply modules 230a, 230b, 230c, 230d, 230e, 230f can be connected to both a first power inlet and a second power inlet (e.g., inlets 350, shown in FIG. 10). In some cases, the first power supply can be prioritized, so that each of the power supply modules 230a-f receive power from the first power inlet while the first power supply is available and only receive power from the second power inlet when the first power inlet is unavailable. In some examples, individual power supply modules can prioritize different power inlets to be used as a primary power inlet for the power supply module. For example, power supply modules 230a-f can each be connected to a first power inlet and a second power inlet, and power supply modules 230a, 230b, 230c can prioritize power from the first power inlet, while power supply modules 230d, 230e, 230f can prioritize power supplied by the second power inlet. In this configuration, if either of the first power inlet or the second power inlet fails or is disconnected, all of the power supply modules can receive a power from the other (e.g., the operational) power inlet. In some cases, three-phase power is received at the power inlets (e.g., power inlets 350 shown in FIG. 10), and power supply modules can filter a signal received from an inlet to process only a single phase of AC power from a given power inlet. For example, power supply module 230a can be connected to a first phase of AC power from a first power inlet, power supply module 230b can be connected to a second phase of AC power from the first power inlet, and power supply module 230c can be connected to a third phase of AC power from the first power inlet. In some cases, phases of AC power can be balanced across power supply modules of a power supply unit. In some cases, each power supply unit can convert an AC power received from an inlet into a DC power for powering components of a cooling unit (e.g., the LACU 200, shown in FIG. 2). Other configurations are possible, and power supply units can include more than 6 power supply modules or less than 6 power supply modules. Further, in some cases, a liquid-to-air cooling unit can include more than one power supply unit.

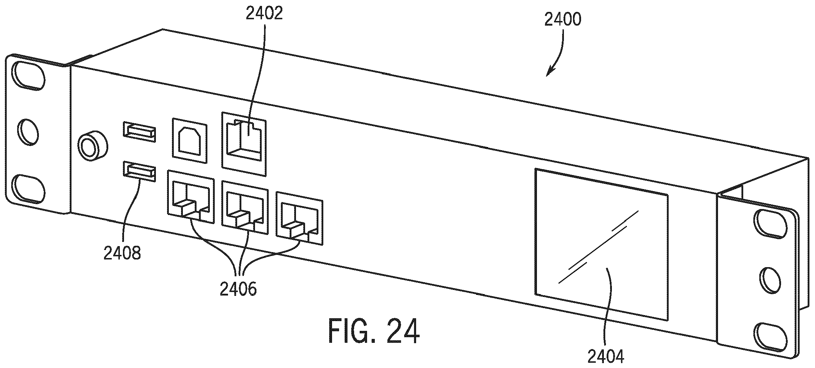

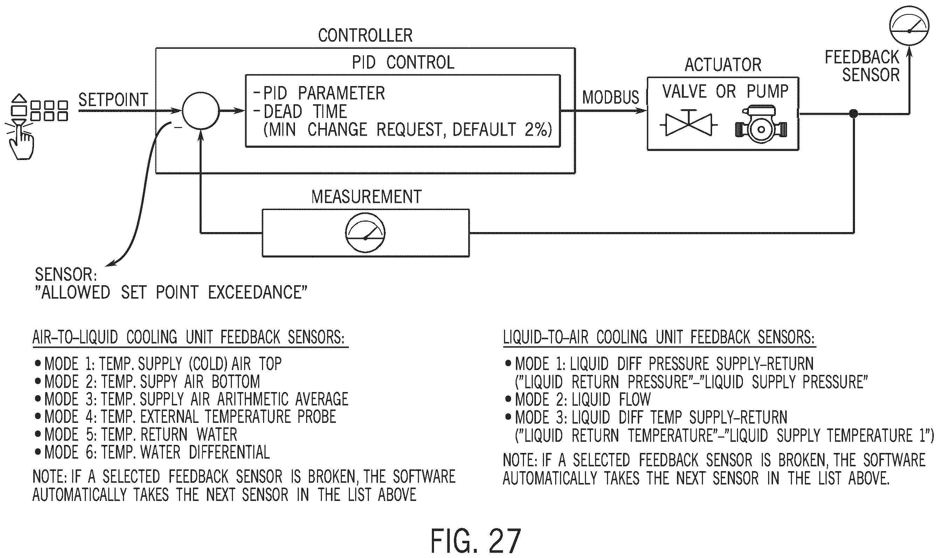

FIG. 24 illustrates an interface board 2400 for use with a liquid-to-air cooling unit according to embodiments of the disclosure. The interface board 2400 can include connections for sensors of a liquid-to-air cooling unit (e.g., sensors of the sensor list in FIGS. 27A and 27B). The board can have a 1Gbe network interface 2402 for connecting to other components within the datacenter, and a user can access the interface through an LCD output 2404 provided on the unit, or through a web interface. In addition to the ethernet connection 2402 described above, the interface board can have ports 2406 for receiving sensor data, including analog or digital data. The board 2400 can provide monitoring capabilities for monitoring sensor values against set values and can provide alerting when the sensor values fall outside of a safe operating region defined in the system. As illustrated, the interface provides three sensor management ports 2406, with each port 2406 being capable of monitoring up to 16 sensor devices. A total length of cable connected to each port can be 40 meters, for example. The interface board can support multiple industry standard protocols for communication and alerting, e.g., SNMP, SMTP, HTTPS, BACnet, Modbus/TCP, and HPI. The interface board can include USB ports 2408 and analog and digital input ports to directly read sensors, for example, sensors with an output of 10 volts. Besides monitoring physical parameters like temperature, humidity, smoke, door status or water intrusion, the management gateway can also monitor in rack chillers and in row coolers with a plug and play installation. Set-up of the management gateway with security features, sensor configuration, user management, alarm and log management can be done through a built in Web Interface. Main access to the interface board 2400 is through the 1 GBE Network interface, supporting industry standard protocols like SNMP, SMTP, HTTPS, BACnet, Modbus/TCP and HPI.

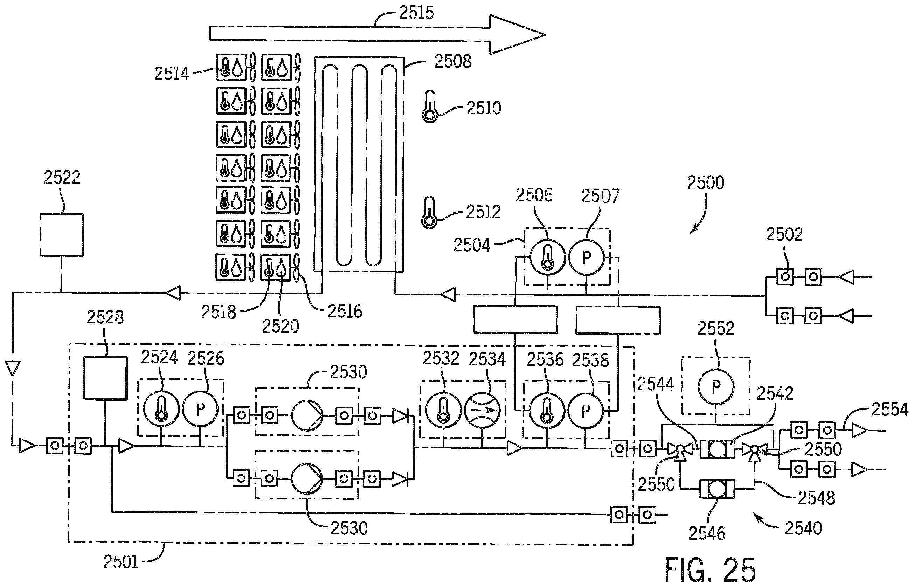

FIG. 25 is a system diagram for a liquid-to-air cooling unit 2500 that includes an RPU 2501 to provide closed loop circulation when coupled to a server unit or other electrical components to be cooled. The liquid-to-air cooling unit 2500 can be substantially similar to (e.g., identical to) the LACU 200 described above and illustrated in FIGS. 2-12. The system includes a liquid return line manifold 2502 (e.g., an inlet, similar to the inlet manifold 302 shown in FIG. 3) with a first sensor module 2504 including a temperature liquid return sensor 2506 and a pressure liquid return sensor 2507. In some embodiments, the first sensor module 2504 is positioned on the inlet manifold 2502 (e.g., the first sensor module can be included in sensor 1312 mounted to manifold 1300, shown in FIG. 13). In other embodiments, a sensor module for sensing properties of a liquid along a return can be positioned at any point in a LACU fluidly upstream of a heat exchanger of the LACU. The return liquid enters a LAHX 2508 (e.g., similar to LAHX 202 illustrated in FIG. 3) which can include a top air temperature sensor 2510 to measure a temperature of an air along a top of the LAHX 2508, and a bottom air temperature sensor 2512 to measure a temperature of an air along a bottom of the LAHX 2508.

The LACU 2500 can include a plurality of fan modules 2514 (e.g., fans 206 illustrated in FIG. 2), which, in the illustrated embodiment, includes 14 fan modules 2514, each including a single fan. In some embodiments, a LACU can include more fan modules or fewer fan module. Some embodiments can include fan modules with one, two, or four fans. Each of the fan modules 2514 placed adjacent to the LAHX 2508 can include three sensors, including a fan speed sensor 2516, an air temperature sensor 2518, and an air humidity sensor 2520. The fan modules 2414 can produce an air flow 2515 across the LAHX 2508 to cool a liquid flowing through the LAHX 2508. Cooled liquid flowing out of the LAHX 2508. can pass toward the RPU 2501 past one or more external bladder expansion tanks 2522 that accommodate any thermal expansion of air, liquid, or fluids in the system. Properties of the liquid entering the RPU 2501 are sensed by a RPU suction temperature sensor 2524 and an RPU suction pressure sensor 2526. In some cases, as illustrated, the RPU 2501 can include an internal bladder expansion tank 2528 to accommodate any thermal expansion of air, liquid, or fluids in the RPU 2501. The liquid of the system passes through one or both of a pair of pump cassettes 2530 in the RPU 2501. In some embodiments, pump cassettes (e.g., the pump cassettes 2530) can each include a pump speed sensor. The liquid can exit the pump cassettes 2530 and flows past additional sensor modules, including a supply liquid temperature sensor 2532, a liquid supply flow rate sensor 2534. A second sensor module 2535 can be positioned downstream of the pump cassettes 2530, and can include a liquid temperature sensor 2536, and a liquid pressure sensor 2538. In some cases, a differential temperature can be calculated between a supply temperature of a liquid measured at fluid temperature sensor 2506 and a return temperature of liquid measured at liquid temperature sensor 2536. Similarly, a differential pressure can be calculated between a supply pressure measured at pressure sensor 2507 and a return pressure measured at 2538. While in the illustrated embodiment, the second sensor module 2535 is positioned in the RPU, in other embodiments, it can be advantageous to position a return sensor module (e.g., the second sensor module 2535) at an outlet of a cabinet of an LACU (e.g., along manifold 2554 shown in FIG. 25).. In some embodiments, a control system for the RPU 2501 is located onboard the RPU 2501. In some cases, a control module of the RPU 2501 can provide control signals to fan modules 2514 to control a rotation of fans thereof. In some cases, each pump cassette 2530 can include a local controller for controlling aspects of a corresponding pump of the pump cassette. Using the various sensors described herein, the control system can control a speed of pumps and/or the fans to achieve target values for cooling the fluid in the system.

The liquid can flow from the RPU 2501 through a filter assembly 2540 which can filter the fluid along either or both of a primary filter 2542 of a primary flow path 2544, or a secondary filter 2546 of a secondary flow path 2548. Valves 2550 (e.g., three-way valves) can be provided at an entry and exit of the primary and secondary flow paths, to selectively allow fluid through either or both of the primary flow path 2544 and the secondary flow path 2548 (e.g., as described with respect to FIGS. 14 and 15). A differential pressure sensor can 2552 can sense a differential pressure between a fluid upstream of the primary and secondary flow paths 2544, 2548, and a fluid downstream of the primary and secondary flow paths 2544, 2548. A differential pressure sensed by the differential pressure sensor 2552 that is above a differential pressure threshold can indicate a need for servicing one or more of the filters 2542, 2546. Fluid can flow from the filter assembly 2540 to a return manifold 2554 to cool electrical equipment downstream of the LACU 2500.

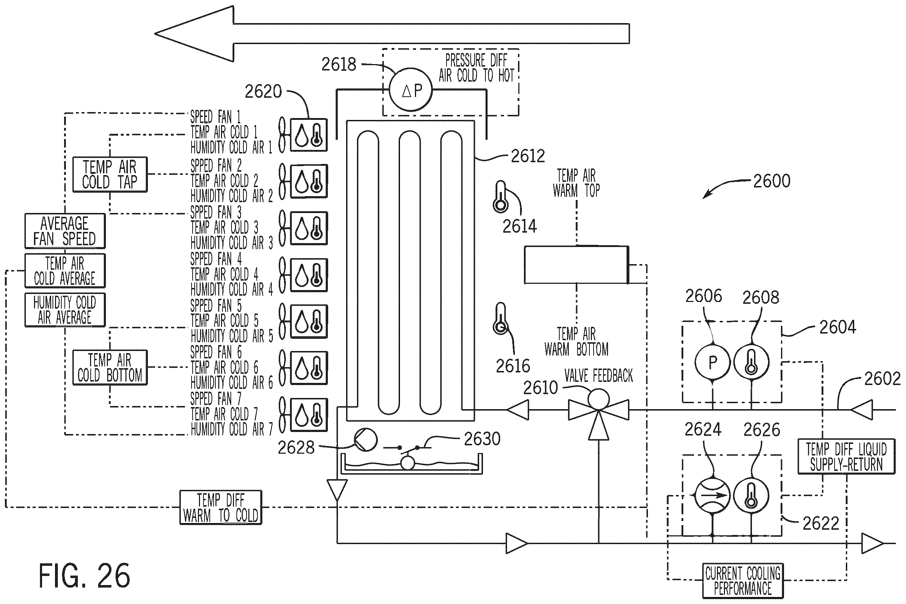

FIG. 26 is a system diagram for liquid to air heat cooling unit 2600 connected to a water supply, such as a pressurized water supply for a building. The system includes a liquid return line 2602 that passes a sensor module 2604 including a pressure liquid supply sensor 2606 and a temperature liquid supply sensor 2608. The liquid passes through a three-way motorized valve 2610 before entering the heat exchanger 2612 with a temperature air warm top sensor 2614 and a temperature air warm bottom sensor 2616. The heat exchanger further includes a pressure differential air cold to hot sensor 2618. The liquid to air heat exchanger 2612 can include seven fan modules 2620. Some embodiments can include fan modules with one, two, or four fans. Each of the fan modules 2620 placed adjacent to the heat exchanger 2612 can include three sensors, including a fan speed sensor, a temperature air cold sensor, and a humidity cold air sensor. The sensed parameters can be analyzed by a control system to calculate a number of parameters, such as temperature air cold top, average fan speed, temperature air cold average, humidity cold air average, temperature air cold bottom, and temperature differential warm to cold. The liquid exists the heat exchanger 2612 and flows past a final set of sensors 2622 including a liquid flow rate sensor 2624 and a temperature liquid return sensor 2626. Additional parameters can be calculated, including temperature differential supply-return and current cooling performance. The system can further include a condensate pump 2628, the state of which can be monitored by calculating the parameters noted above, the status of which can be controlled using a condensate level switch 2630.

In some cases, control systems and processes can be implemented by controller of a cooling system to achieve a desired cooling rate, maintain operating parameters of a cooling unit within threshold ranges, achieve a power efficiency, etc. For example, referring specifically to FIG. 25, a controller can provide signals to fans 2514 to increase a flow rate of air across the heat exchanger 2508 in order to achieve a target outlet temperature for fluid of the LACU 2500. Additionally or alternatively, a speed of one or more of the pumps 2530 can be adjusted to induce a target pressure or pressure difference in the system, or to achieve a target temperature or temperature differential for temperatures measured at different points along a liquid cooling circuit. In some cases, fans 2514 and pumps 2530 can be controlled independently to achieve different set points for operating parameters of the LACU 2500. In some cases, the fans 2514 and pumps 2530 can be controlled in coordination. In some cases, one of the pumps or fans can be controlled to operate at a set value (e.g., fan speed or pump speed), which is not changed to achieve a target for an operating parameter of the LACU.

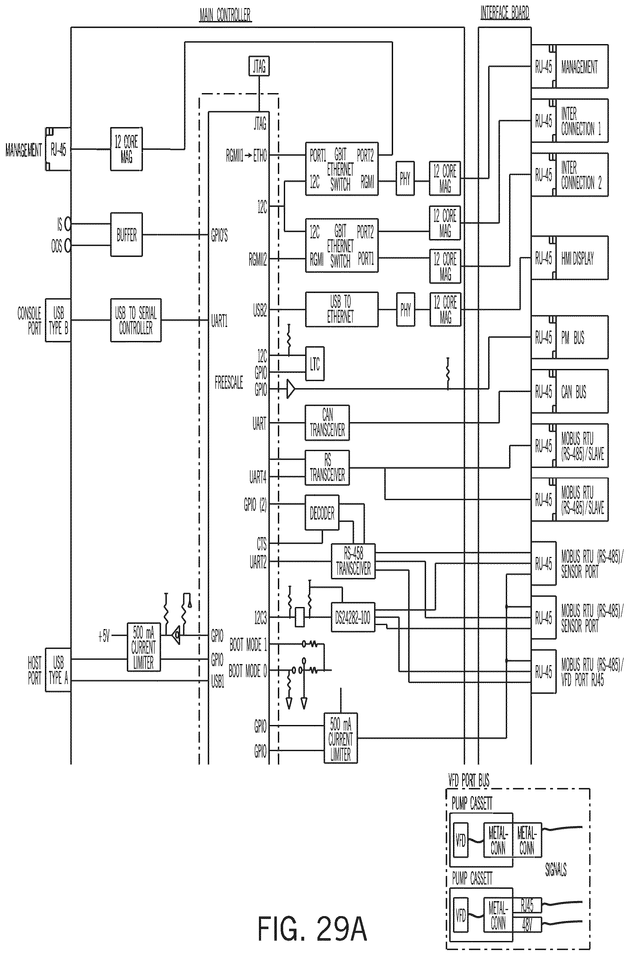

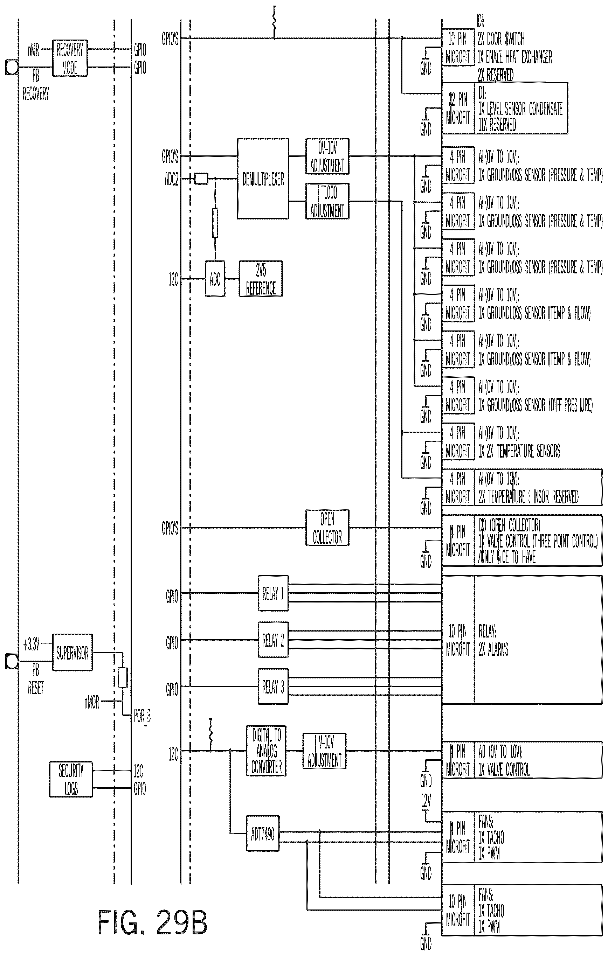

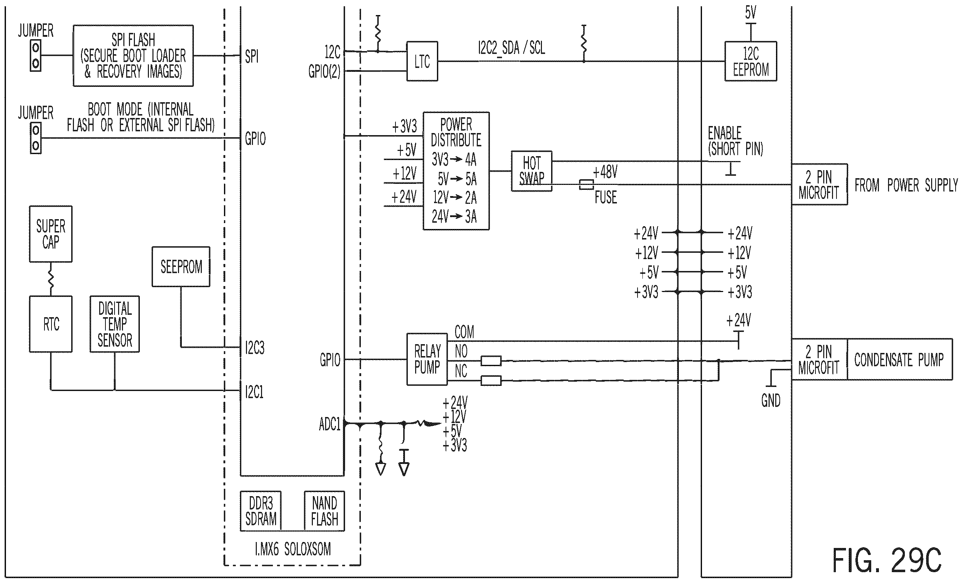

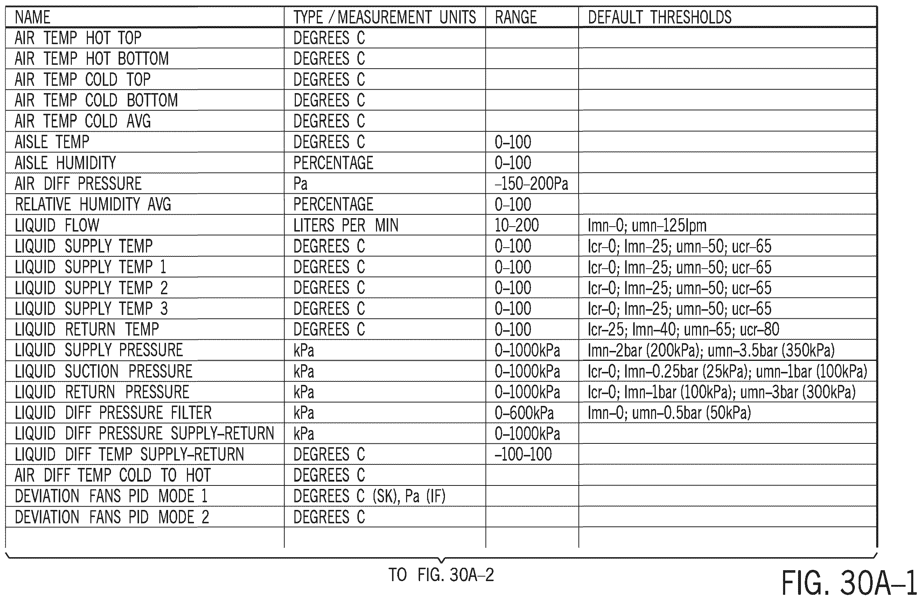

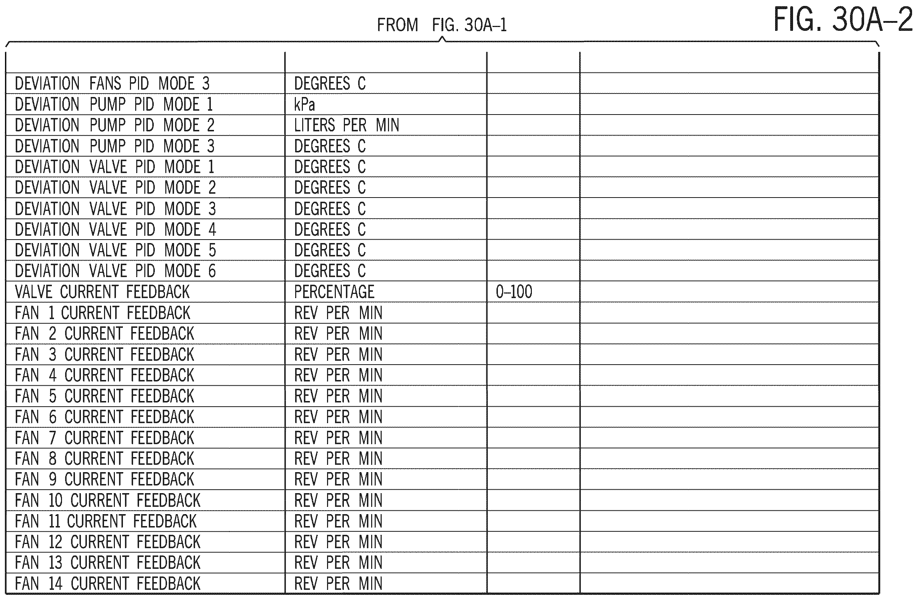

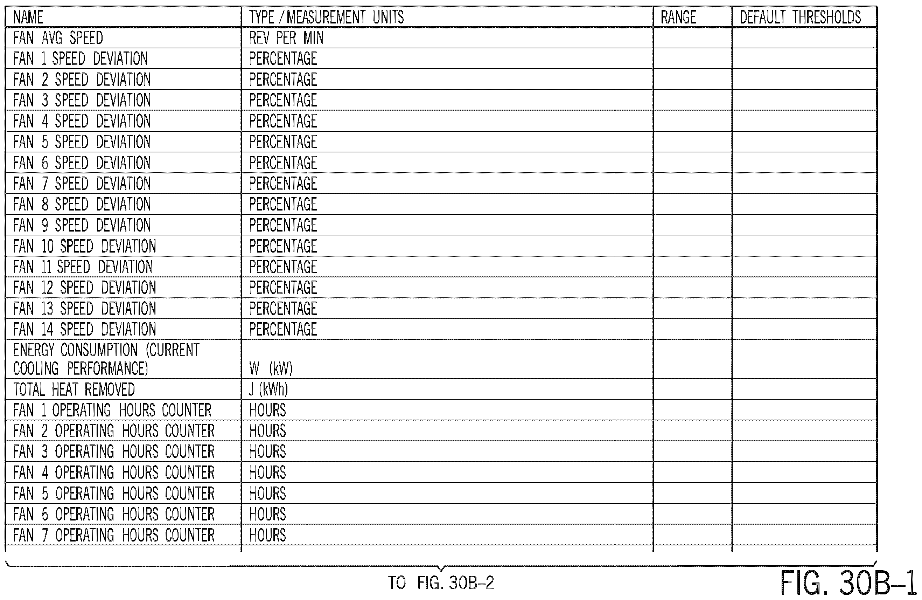

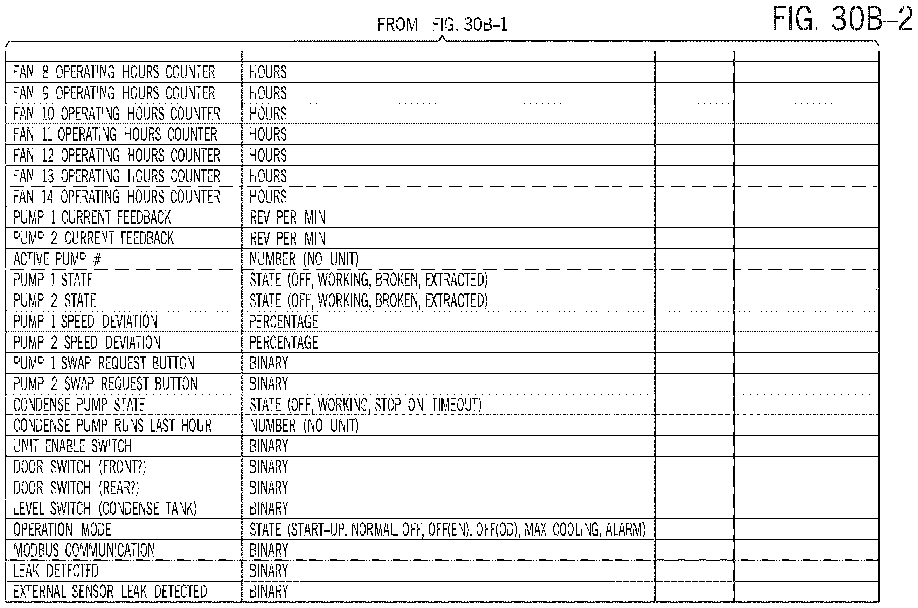

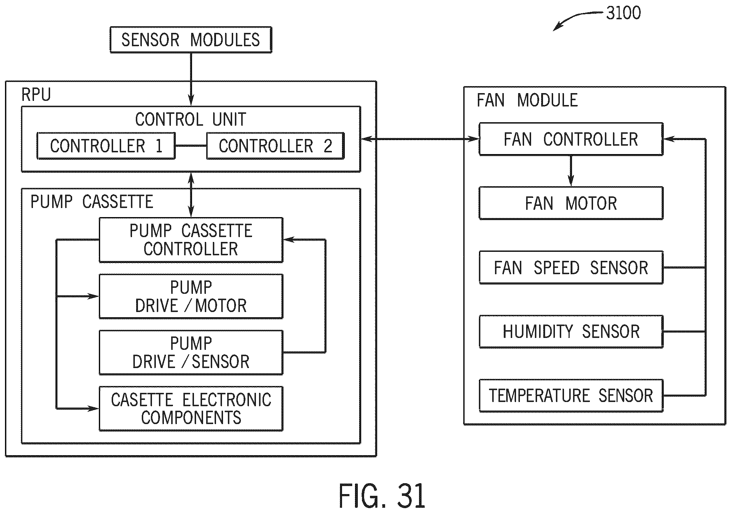

Actuators (e.g., fans 2514 and pumps 2530 of LACU 2500 shown in FIG. 25) can be controlled according to proportional integral derivative controls to achieve corresponding set points for operating parameters. For example, a controller (e.g., a controller of control modules 214a, 214b shown in FIGS. 2 and 12, the main controller illustrated in FIGS. 29A-29C or either of "Controller 1" or "Controller 2" of the "Control Unit" of system 3100 shown in FIG. 31) can have programmed thereon operating ranges for operating parameters of a LACU (e.g., as listed in FIGS. 30A-1 through 30B-2), set points for operating parameters, and gains of one or more PID controllers to be implemented by the controller. Operating parameters, set points, and gains can be preprogrammed at a memory of the controller, or can be set by a user at an input interface of the controller (e.g., a graphical user interface, a web interface, a command line interface, an ethernet interface, a Modbus interface, etc.). The controller can implement a PID control to vary an input into an actuator (e.g., a pump as shown, which can be one or more pumps housed in cassettes 210a, 210b shown in FIG. 2, or pumps 2530 shown in FIG. 25) to achieve a set point (e.g., a target value) for a measurement of a value from a feedback sensor. A measurement from a feedback sensor can be provided back to the controller, which can determine, based on the measurement, an error relative to the desired set point, and can output a signal to the actuator to adjust an operation thereof (e.g., a pump speed). This process can be continuously implemented and can iteratively measure a value, compare that measurement to a set value (e.g., calculate an error), and generate a signal to an actuator to produce a desired output for the feedback sensor.

As further illustrated in FIG. 27, the PID control implemented by the controller can be used to operate one or more pumps as actuators (e.g., pumps 2530 shown in FIG. 25, or pump housed in cassettes 210a, 210b shown in FIG. 2). In some embodiments, the pumps can be operated according to one of three operating modes, as shown, with each operating mode corresponding to a give sensor or set of sensors of the system. For example, in mode 1, as shown, the pumps can be operated to achieve a target value for a differential pressure between a supply and return of a liquid-to-air cooling unit (e.g., the inlet and the outlet of LACU 2500 shown in FIG. 25). With reference to FIG. 25, in mode one, a target value can be a difference between a pressure measured at pressure sensor 2507 (e.g., an inlet or return pressure) and a pressure measured at pressure sensor 2538 (e.g., an outlet or supply pressure). The controller can provide a signal (e.g., to variable frequency drives of one or more of the pumps) to increase a pump speed or decrease a pump speed to achieve the pressure differential. In some cases, mode 1 is a default mode of operation for a liquid-to-air cooling unit. In some cases, an operator (e.g., a user) can select a mode (e.g., including mode 1) in which to operate controls to control a pump speed of the system.

In some cases, a mode of a controller can at least partially depend on an operational state of one or more components of a liquid-to-air cooling unit (e.g., the LACU 200 illustrated in FIGS. 2-12, the LACU 2500 illustrated in FIG. 25, etc.). For example, if a feedback sensor for a given PID control or mode of a PID control is inoperational, or incommunicative with a controller, the controller can switch to another mode, to implement a PID control to achieve a set point for a different operating parameter of the cooling unit. For example, if one or both of sensors 2507, 2538 are inoperational, the controller may not be able to implement mode 1 as illustrated, and the controller may automatically switch to another mode of operation for implementing a PID control (e.g., mode 2 or 3). For example, the controller can switch to Mode 2 to control a speed of pumps 2530 to achieve a set value for liquid flow through the LACU 2500, as can be measured, for example, by flow rate sensor 2534. When neither of modes 1 or 2 are feasible, as when either or all of sensors 2507, 2538, 2534 are operational, the controller can implement a PID control according to mode 3, to achieve a differential temperature between an inlet and outlet (e.g., a return and supply) of the LACU 2500, as can be measured as a difference between temperatures received at temperature sensor 2506 and temperature sensor 2536 respectively. In some cases, either of modes 2 or 3 can be the primary or default mode, and a controller can switch to the other respective modes upon an unavailability (e.g., a failure or lack of communication with feedback sensors of the primary mode). In some cases, additional modes can be implemented to achieve set points for any measured value or differentials between measured values.

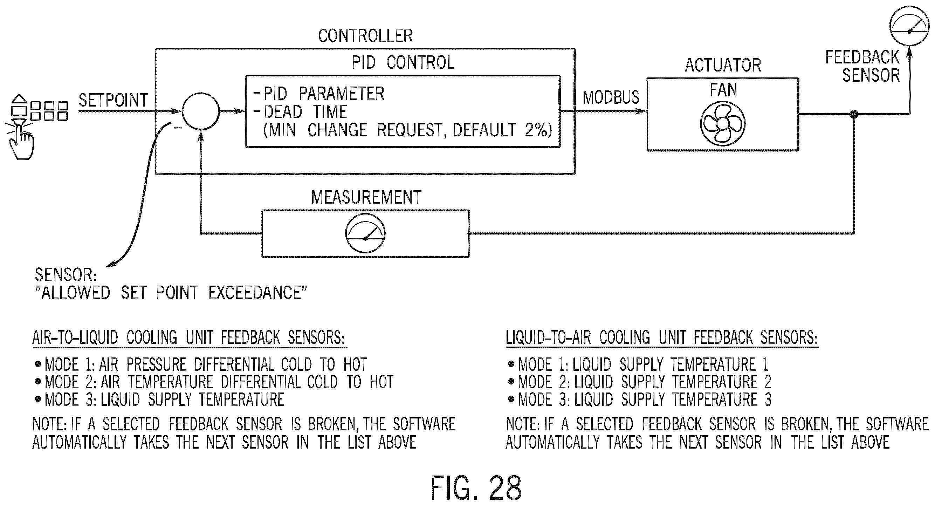

A controller for a liquid-to-air cooling unit (e.g., any or all of LACUS 100, 200, 1600, 2500) can implement PID controllers with components other than pumps as actuators. For example, FIG. 28 illustrates a feedback control system for any of the liquid-to-air cooling units 100, 200, 2500, or 2600 illustrated in FIGS. 1, 2-12, 25, and 26 respectively, wherein a controller for the respective LACU controls a speed of one or more fans of the LACU to achieve a set point for a value of a feedback sensor. The feedback control system shown in FIG. 28 can be implemented in addition to or alternatively to the feedback control system shown in FIG. 27. As shown, the fans (e.g., fans 206 as shown in FIG. 2, or fans 2514 shown in FIG. 25) can be controlled in any of modes 1-3 to achieve an output temperature for liquid of the liquid coolant circuit. For example, mode 1 can rely on temperature sensor 2536 as a feedback sensor, mode 2 can rely on temperature sensor 2532 as a feedback sensor, and mode 3 can rely on temperature sensor 2524 as a feedback sensor. The modes provided for either or both of the feedback control systems shown in FIGS. 27 and 28 are provided for illustration and are not intended to be limiting.

FIGS. 29A-29C illustrate an embodiment of a controller and an interface board connected to a controller, and the pump cassettes of an RPU (e.g., RPU 204 shown in FIG. 2), showing an electrical schematic for the controller's microprocessor including the various inputs into the microprocessor and the various outputs to the interface board and to the interface board's ports.

FIGS. 30A-1 through FIGS. 30B-2 list examples various sensors that can be included in the control system. Subsets of these sensors are used to monitor and control either the liquid-to-air cooling unit or the liquid to air heat exchanger. The sensors can be connected to a control system and supported for communication with the control system firmware. A smaller subset of the sensors can be used by the feedback control system, including those sensors shown in FIGS. 25 and 26 for use in the PID control loop. Many of the sensors are only informational, for example, to determine whether certain temperatures are too high or certain fan or pump speeds are too low. In some embodiments, active operation only relies on two sensors for the pump control loop and the fan control loop. Some of the sensors may be redundant so that if sensors malfunction, the system uses fallback sensors to continue operation.

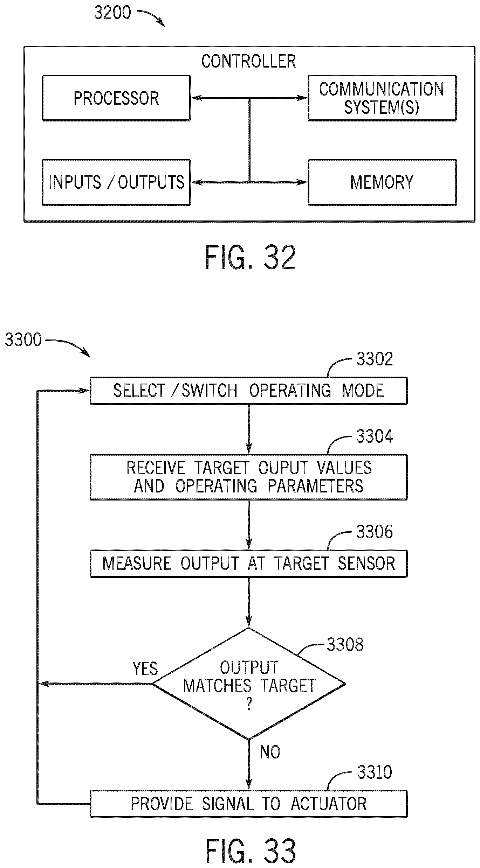

FIG. 31 illustrate a control system 3100 for any or all of the LACUs 100, 200, 1600, or 2500 described above. The control system 3100 can be used to implement either or both of the feedback control systems shown in FIG. 27 and 28, and the process 3300 shown in FIG. 33. As shown, the control system 3100 can include an RPU (e.g., RPU 104 shown in FIG. 1, RPU 204 shown in FIG. 2, RPU 2501 shown in FIG. 25), a Fan Module (e.g., one or more of the fans 106 shown in FIG. 1, fans 206 shown in FIG. 2, and fans 2514 shown in FIG. 25), a Sensing Modules. The sensing modules of the control system 3100 can include temperature sensors, pressure sensors, flow sensors, humidity sensors, or other know sensor types. For example, the Sensor Modules can include any or all of sensors 2506, 2507, 2510, 2512, 2518, 2520, 2516, 2524, 2526, 2532, 2534, 2536, 2538, and 2552 of LACU 2500 shown in FIG. 25. For purposes of illustration, only one Fan Module is shown, however, it is to be understood that the control system 3100 can include any number of fan modules and associated fans, including, for example, 14 fans, as shown and described with respect to FIGS. 2 and 25.

The RPU can include one or more Pump Cassettes and a Control Unit. While only one Pump Cassette is illustrated, an RPU can include distinct control components for multiple pump cassettes (e.g., 2 pump cassettes). The Control Unit can include two controllers: Controller 1 and Controller 2, which can be substantially identical, or can include different programing to implement different controls for one or more elements of a cooling unit. In an example, Controller 1 can be housed in the control module 214a of LACU 200, as shown in FIG. 12, and Controller 2 can be housed in control module 214b of LACU 200, as shown in FIG. 12. In some examples, controllers of a control unit (e.g., Controller 1 and Controller 2 of the illustrated Control Unit) can be operated in an active-passive mode, with only one of the controllers being active at a particular time. For example, Controller 1 can be configured as a primary controller and Controller 2 can be a secondary controller (e.g., a backup or standby controller) and Controller 2 switch to being the primary controller for the system in the case of a failure in Controller 1. In other embodiments, a control unit of a cooling system can include only one controller, or more than two controllers.

As illustrated, the Fan Module can include a Fan Controller, which can provide local controls for an individual fan module (e.g., as partially described with respect to FIGS. 19 and 20). The Fan Module can further include a Fan Speed Sensor (e.g., fan speed sensor 2516 shown in FIG. 25) a Humidity Sensor (e.g., humidity sensor 2520 shown in FIG. 25), and a Temperature Sensor (e.g., temperature sensor 2518 shown in FIG. 25). Each of the Fan Speed Sensor, Humidity Sensor, and Temperature Sensor can provide measurements for a sensed value to the Fan Controller. The Fan Module can further include a Fan Motor, as shown, which can receive a signal from the Fan Controller to drive an operation of the Fan Motor. As further shown, the Fan Controller can be in communication with the Control Unit. In normal operation of the control system 3100, the Fan Controller can provide sensed values from any of the described sensors to the Control Unit (e.g., to either or both of Controller 1 and Controller 2) and can receive a signal from the Control Unit to drive operation of the Fan Motor. In other cases, including when a communication between the Fan Module and the Control Unit is interrupted, the Fan Controller can autonomously control a speed of the Fan Motor, according to instructions preprogrammed in the Fan Controller. In some examples, when a fan controller is autonomously driving a fan motor, it can operate a feedback control system based on sensor parameters obtained from sensors of the fan module.

As further shown in FIG. 31, the Pump Cassette can include a Pump Cassette Controller, which can provide control signal for one or more of a Pump Drive/Motor (e.g., a motor of pump 2530 illustrated in FIG. 25) and Cassette Electronic Components (e.g., LEDs, fans, locking systems, servo motors, linear actuators, speakers, etc.). The Pump Cassette Controller can receive measured signals of a pump speed from a Pump Drive/Sensor, as shown. In some examples, a Pump Cassette can include additional sensing components to sense operational parameters of the Pump Cassette (e.g., signals from sensors 2524, 2526, 2532, 2534, 2536, 2538 housed in RPU 2501 shown in FIG. 25). The Pump Cassette Controller can be in communication with the Control Unit (e.g., via a wired or wireless connection), and can receive instructions from one or both of Controller 1 and Controller 2 to drive a speed the Pump Drive/Motor and/or control the Cassette Electronic Components. As described with respect to the Fan Controller, if communication is lost between the Control Unit and the Pump Cassette Controller, the Pump Cassette Controller can control elements of the Pump Cassette autonomously until a connection is restored with the Control Unit. In some examples, each of the Controller 1, Controller 2, the Pump Cassette Controller, and the Fan Controller can be an instance of the controller 3200 shown in FIG. 32, which is described below.

Referring back to FIG. 31, the Control Unit can be in communication with the Sensor Modules to receive sensed values from sensors thereof. The Control Unit can provide signals (e.g., instructions) to one or more of the Fan Controller and the Pump Cassette Controller to implement a feedback control system (e.g., as described in FIGS. 27 and 28) to achieve a set value for a sensor of the Sensor Modules. In some embodiments, a control unit can be in direct communication with sensors of fan modules and pump cassettes (e.g., the Control Unit can be directly connected to any or all of the Fan Speed Sensor, Humidity Sensor, Temperature Sensor, etc.).

In some examples, communication between components of the control system 3100 can be over a wired connection (e.g., a Modbus, an ethernet connection, USB connections, etc.). In some embodiments, communication between one or more elements of the control system can occur via a wireless connection (e.g., a wi-fi connection, a cellular connected, etc.).

FIG. 32 illustrates an example of a controller 3200 that can be used in a cooling system (e.g., LACU 100, 200, 1600, 2500). In some embodiments, the controller 3200 can be a programmable logic controller (PLC). In some embodiments, the controller 234 can include a processor, one or more Input/Output interfaces, a Communication System(s), and a Memory. In some embodiments, the Processor can be any suitable hardware processor or combination of processors, such as a central processing unit (CPU), a graphics processing unit (GPU), an application specific integrated circuit (ASIC), a field-programmable gate array (FPGA), etc. In some embodiments, one or more Input/Output interfaces can include any suitable display device, such as a computer monitor, a touchscreen, a television, any suitable input devices and/or sensors that can be used to receive user input, such as a keyboard, a mouse, a touchscreen, a microphone, a camera, etc. Inputs can be received at a display which can present a user interface through which an operator can view system parameters, and set control parameters (e.g., set an operating mode, define set points for temperature or pressure, set a language of the system, etc.).

In some embodiments, the Communication System(s) of the controller 3200 can include any suitable hardware, firmware, and/or software for communicating information over any suitable communication networks. For example, the Communication System(s) can include one or more transceivers, one or more communication chips and/or chip sets, etc. In a more particular example, the Communications System(s) can include hardware, firmware and/or software that can be used to establish a Wi-Fi connection, a Bluetooth connection, a cellular connection, an Ethernet connection, etc. In some embodiments, inputs can be received at the controller 3200 through the Communication System(s) (e.g., over a communication network). For example, the controller 3200 can be a controller of a liquid-to-air cooling unit (e.g., LACU 100, 200, 1600, 2500) an application programming interface, command line interface, or web interface can be provided for a liquid-to-air cooling unit to allow an operator to control the liquid-to-air cooling unit remotely.

In some embodiments, the Memory can include any suitable storage device or devices that can be used to store instructions, values, *etc.,* that can be used, for example, by the Processor of the controller 3200 to implement control loops and algorithms, to store logs of the controller 3200, etc. The Memory can include any suitable volatile memory, non-volatile memory, storage, or any suitable combination thereof. For example, the Memory can include random access memory (RAM), read-only memory (ROM), electronically-erasable programmable read-only memory (EEPROM), one or more flash drives, one or more hard disks, one or more solid state drives, one or more optical drives, etc. In some embodiments, the Memory can have encoded thereon a computer program for controlling operation of the Controller 3200.

FIG. 33 illustrates an example process 3300 which can be performed by a control system of a liquid-to-air cooling unit (e.g., control system 3100 shown in FIG. 31). At block 3302, the process can select or switch an operating mode of a cooling unit (e.g., LACU 100, 200, 1600, or 2500). An operating mode can include system parameters for operation of components of a cooling unit (e.g., maximum and minimum speeds of pumps and/or motors, a primary and secondary controller, a set point for a temperature, differential temperature, flow rate, pressure, differential pressure, etc.). As another example, a mode can include a mode of a feedback loop control procedure, as described with respect to FIGS. 27 and 28 (e.g., modes for operation of respective PID controls). Further, in some cases, an operating mode can include a mode of one or more pumps of an RPU (e.g., pumps 2503 of RPU 2501 shown in FIG. 25). For example, pumps can be operated in a parallel mode, with each pump operating to induce a flow through an RPU of a LACU. Alternatively, pumps of an RPU can operate in an active/passive configuration, with one pump being a primary pump and another pump being activated only when the primary pump is not operational. An operating mode can further include which controller of a pair of controllers (e.g., Controller 1 and Controller 2 shown in FIG. 31) to use to implement a control system for the LACU. In some examples, a user input can be provided to select or switch an operating mode. In some cases, system parameters can dictate an operating mode, as, for example, when failure of a feedback sensor of an active PID control system necessitates a switch to a PID control for another feedback sensor, as described with respect to FIGS. 27 and 28.

At block 3304, the system can receive target output values and operating parameters. In some examples, this can include performing a lookup on a database or otherwise retrieving the values and parameters from a memory that is operatively connected to a processor implementing the process 3300. In some cases, an operator can be prompted for input to set one or more target output values and operating parameters. In some cases, operating values and target parameters can be values for operational parameters listed in FIGS. 30A-1 through 30B-2.

At block 3306, a system implementing the process 3300 can measure an output at a target sensor. The target sensor can be a feedback sensor for a PID control implementation, as illustrated in FIGS. 27 and 28. In some cases the target sensor can be a sensor for which an operating range has been set (e.g., the target can be a sensor for a temperature for which the system include a maximum and/or minimum value for the output of the sensor). In some cases, the output from the target sensor is informational, and can be provided to a user at a display or other interface of a liquid to air cooling unit.

At block 3308, the system implementing the process 3300 can check if the output matches a target. In some cases, the target is a target range for the output value (e.g., as set at block 3304). In some cases, the target is a set point of a PID controller for the output of the target sensor.

If the output matches the target value (e.g., a sensed temperature is within a target range, a temperature at an outlet of a LACU equals a set point for the temperature), the process 3300 can return to block 3302 to monitor for any updates to the system that can require switching an operating mode of the system.

If, at block 3308, the output does not match the target, as when a measured value from a sensor falls outside of a specified range, or does not equal a set value, the system can provide a signal to an actuator. The signal can include instructions to increase or decrease a pump speed, as described in FIG. 27, or to increase or decrease a speed of one or more fans, as described in FIG. 28. In some examples, the signal can include instructions to shut down or halt a respective actuator (e.g., one or more of the fans 2514 and pumps 2530 shown in FIG. 25), as when the output indicates a measured value falling outside of a safe operating range. In other examples, an actuator can include a valve to selectively allow or deny fluid flow through portions of a cooling unit (e.g., LACU 100, 200, 1600, 2500, etc.). In some cases, the signal can be calculated based on an output of a PID control, as described with respect to FIGS. 27 and 28. Upon providing the signal to the actuator, the system implementing the process 3300 can return to block 3302 to continue monitoring conditions of the cooling systems.

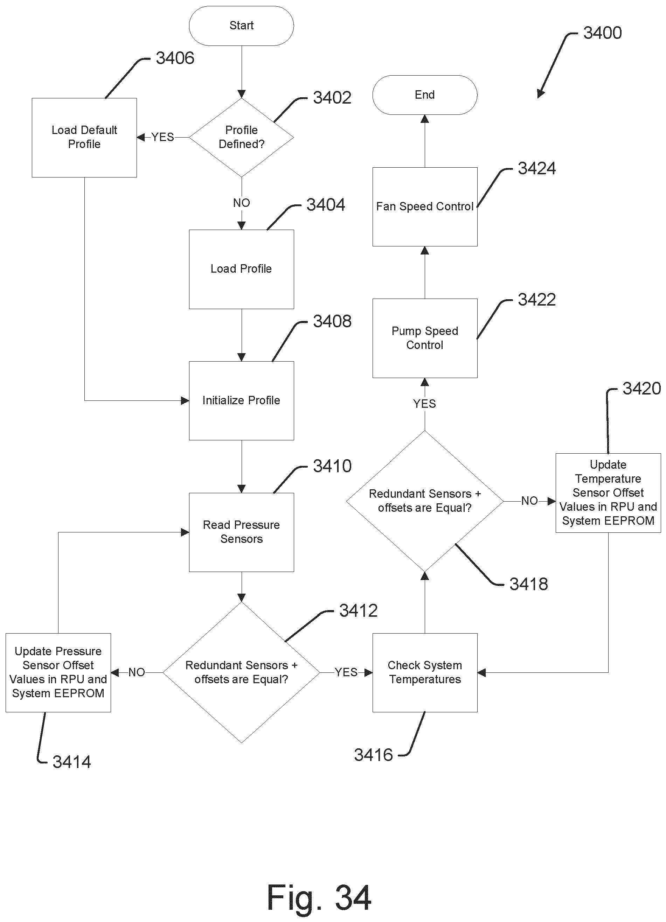

In some cases, controllers of a LACU can initiate a startup process when the LACU is turned on or at the beginning or resetting of an operation of the LACU. A startup process for a LACU can further be initialized upon a change of one or more operational parameters of the LACU by an operator (e.g., a target temperature, differential temperature, pressure, flow rate, an operating mode, etc.). In this regard, FIG. 34 illustrates an example startup process 3400 which can be performed by a control system of a liquid-to-air cooling unit (e.g., control system 3100 shown in FIG. 31 at either or both of Controller 1 and Controller 2). At block 3402, the method can determine if a profile for the LACU has been defined. A profile for the LACU (e.g., LACU 100, 200, 1600, 2500, etc.) can include operational settings and parameters for the LACU (e.g., any configurable parameter of a LACU). Determining if a profile is defined for a LACU can include checking if settings have been input for the LACU by an operator (e.g., through an API, UI, CLI, etc.). In some embodiments, block 3402 can be performed at startup of a LACU, upon a reset event (e.g., an interruption in power, a failover between redundant controllers, a command from an operator, etc.), upon a change in settings (e.g., an update to a user-defined operating parameter), at scheduled intervals, or upon conditions configured by a used.

In some embodiments, a profile can include operating ranges and target values for an operating parameter. For example, a profile can include any of minimum and maximum values for operational parameters, which can include a temperature, a differential temperature, a pressure, a differential pressure, an air flow rate, a liquid flow rate, a pump speed, or a humidity value. Minimum and maximum values for operational parameters can define threshold values at which an operation of the LACU can be changed (e.g., the LACU can be shut off, an operating mode of the LACU can be changed, pump speeds can be increased or decreased, bypass valves can be open or shut, etc.). Further, settings of a profile can include target parameters (e.g., setpoint values for PID controllers as illustrated in FIGS. 27 and 28) for any or all of the operational parameters listed in FIGS. 27 and 28, or additional settings configurable by a user. In some cases, a profile can include target values or thresholds for all, or a portion of the operational parameters listed in FIGS. 30A-1 through 30B-2. In some cases, a profile can include settings for gains to be used in a PID controller.

If a profile is defined at block 3402, the profile can be loaded at block 3404. Loading a profile can include writing settings of the profile to a portion of the memory accessible to a control system (e.g., memory of controller 3200 shown in FIG. 32). In some cases, loading a profile can include assigning values to variables of a software (e.g., a program or algorithm) executed by a control system of the LACU (e.g., control system 3100 shown in FIG. 31). Loading a profile can include communicating all or a portion of the profile to components of a control system (e.g., copying the profile from Controller 1 to Controller 2 shown in FIG. 31, or issuing an instruction from Controller 1 or Controller 2). As an example, with reference to FIG. 31, a maximum pump speed can be an operational parameter of a profile, and loading the profile can include communicating the maximum pump speed from one of Controller 1 and Controller 2 to the Pump Cassette Controller, and the Pump Cassette Controller can execute an algorithm to enforce the maximum pump speed for the Pump Drive/Motor.

If, at block 3402, no profile is defined (e.g., the control system does not identify user-defined settings) the system can reference a default profile to be loaded at block 3406. The default profile can be a profile stored in a memory of a control system of the LACU (e.g., factory settings stored in the Memory of the controller 3200, shown in FIG. 32). In some cases, a default profile can be stored off-device (e.g., can be stored in one or more computing devices remote to or separate from the LACU). For example, a default profile can be stored in one or more remote computing devices (e.g., a cloud based computing device or storage device) and a control system of a LACU can communicate (e.g., at the Communication System(s) of the controller 3200 illustrated in FIG. 32) with the remote computing device to access the default profile. In some cases, a default profile can be specific to a given application or site. For example, a first data center can have corresponding environmental conditions and computing workloads, and a first default profile for the first data center can be defined to accommodate the specific conditions (e.g., environmental conditions and workload requirements) of the first data center. A second default profile can similarly be defined to accommodate conditions of a second data center. The first default profile can be stored at a computing device accessible to LACUs in the first data center (e.g., a communication system of the LACU can communicate with the computing device storing the first default profile through a wired or wireless network connection), and the second default profile can be stored at a computing device accessible to LACUs in the second data center. When a LACU is installed in the first data center, if no profile is defined for the LACU at block 3402, the LACU can communicate with the computing device storing the first default profile, and can load (e.g., download) the first default profile. Similarly, an LACU installed in the second data center with no profile defined at block 3402 can communicate with the computing device storing the second default profile and can load the second default profile. In some examples, only a portion of a profile is defined at block 3402 (e.g., a user configures only a portion of the set of configurable operational parameters) and the portion of the profile that is undefined at block 3402 can be loaded as the default values provided in the default profile at block 3406.

At block 3408, the process 3400 can initialize the profile of the LACU (e.g., either of the default profile defined at block 3404, the profile defined at 3402, or portions of both the default profile and the user-defined profile). Initializing the profile can include implementing all or a portion of the profile in executed code on a control system. For example, mechatronic components (e.g., pumps, fans, and valves) of the LACU can be operated in accordance with operational parameters of the profile loaded for the LACU (e.g., at either or both of blocks 3404 and 3406). For example, with reference to FIG. 31 a default pump speed can be set in accordance with an operational parameter defined in a profile (e.g., at block 3402 or 3404), and the Control Unit can issue a signal to the Pump Cassette Controller (e.g., to the Pump Drive/Motor) to operate the pump at the default pump speed. In some cases, fan speeds can be initialized in accordance with operational parameters (e.g., an initial or default fan speed, a default air flow, etc.). In some cases, initializing a profile can include setting values at local controllers of a fan or a pump (e.g., one of Controller 1 and 2 shown in FIG. 31 can set one or more parameters at the Fan Controller or the Pump Cassette Controller) based on the parameters in the loaded profile at block 3404. In some cases, initializing a profile can include assigning a state to one or more components of the control system of a LACU. For example, dual pumps (e.g., pumps of respective pump cassettes 210a, 210b shown in FIG. 12) can be operated in an active-passive mode, and upon startup, at block 3408, a master controller can communicate a state to each of the pump cassette controller corresponding to the respective pumps.

At block 3410, a control system (e.g., one or both of Controller 1 and Controller 2 of the Control Unit of FIG. 31) can receive (e.g., read) pressure values from pressure sensors of the LACU. For example, the control system can receive pressure values from any or all of pressure sensors 2507, 2526, 2538, and 2552 illustrated in FIG. 25. In some cases, pressure sensors can be provided at additional points along a flow path of a liquid coolant. In some cases, a pressure sensor of a LACU can be a feedback sensor used to implement a control loop (e.g., the feedback sensor of the PID controller shown in FIG. 27 can be one or more pressure sensors of the LACU). For example, as shown in FIG. 27, an LACU can be operated in a "Liquid Diff Pressure Supply-Return" mode, with a PID controller of the system controlling the pump (e.g., either or both of pumps 2530 shown in FIG. 25) to achieve a desired pressure differential between a pressure value of a liquid return (e.g., a pressure value measured at pressure sensor 2538, shown in FIG 25) and a pressure value of a liquid supply (e.g., a pressure value measured at pressure sensor 2507, shown in FIG. 25). In some cases, one or both of pressure sensors 2507, 2538 can fail, or a communication between the sensors 2507, 2538 and a controller (e.g., either of Controller 1 and Controller 2 shown in FIG. 31) can be interrupted, and the controller can obtain pressure values from one or more redundant sensors (e.g., pressure sensor 2526) as a feedback sensor to implement a PID control for the LACU. Thus, with continued reference to FIG. 25, upon a failure of the pressure sensor 2507, the controller can obtain a differential pressure at least partially based on a difference between a pressure value from pressure sensor 2526 and pressure sensor 2538. In some cases, an offset can be calculated between a pressure measured from a primary sensor (e.g., pressure sensor 2507) and a pressure measured from a redundant sensor (e.g., pressure sensor 2526). The offset between a primary sensor and a redundant sensor can be used to calibrate a differential pressure calculated based on the redundant sensor to ensure a continuity of operation of the LACU when communication with the primary sensor is lost.

In this regard, at block 3412, the process can reference an offset stored in memory of a controller (e.g., a memory of either of Controller 1 and Controller 2 shown in FIG. 31) and determine if the offset is accurate relative to a reading from both of a primary and redundant sensor. As an example, an offset can be .1 bar, a reading from the primary sensor can be .9 bar and a reading from the redundant sensor can be .8 bar. In this example, the offset plus the reading from the redundant sensor is equivalent to the reading from the primary sensor, and the system can proceed to block 3416 to check system temperatures. In some case, determining if an offset is accurate at block 3412 includes determining whether the offset is within a tolerance range of a measured difference between a reading from a primary and a redundant sensor. For example, at block 34, the sum of reading from the redundant sensors and the offset can be determined to be "equal" to the reading from the primary sensor if the sum is within 5% of the reading of the primary sensor. In other examples, any tolerance range can be used to determine an equivalency between a sum of an offset and a reading from a redundant sensor, and a reading from a primary sensor (e.g., a difference of less than 10%, less than 15%, less than 20%, or less than 25% can be evaluated as "equal" at block 3410).

If, at block 3412, the sum of the pressure reading from the redundant pressure sensor and the offset is not equal to the pressure reading from the primary pressure sensor, the offset value can be updated at block 3414. Updating the offset value can include writing a calculated offset between the pressure reading from the primary pressure sensor (e.g., pressure sensor 2507) and the redundant pressure sensor (e.g., pressure sensor 2526) to a memory of a controller, for use in implementing control processes for the LACU (e.g., writing the difference between the primary pressure sensor reading and the secondary pressure sensor reading to a memory of either or both of Controller 1 and Controller 2, shown in FIG. 31). After writing an updated pressure offset value at block 3414, readings from the respective primary and redundant pressure sensors can be read at block 3410, and an accuracy of the updated offset value can be evaluated at block 3412. In some cases, multiple offsets can be determined for multiple pressure sensors, and each offset can be evaluated at block 3412. For example, a LACU can include a primary return pressure sensor and a redundant return pressure sensor, and offsets for the primary return pressure sensor and the redundant return pressure sensor can be stored in a memory, in addition to an offset for a primary supply pressure sensor and a redundant supply pressure sensor.

At block 3416, system temperature sensors can be read from temperature sensors of a LACU (e.g., any or all of temperature sensors 2506, 2524, 2536, 2510, 2512 of LACU 2500 shown in FIG. 25). In some cases, as described with respect to the pressure sensors, temperature sensors can be used as feedback sensors to implement PID controller for a LACU (e.g., as shown in FIG. 27). Additionally, one or more temperature sensors can be primary temperature sensors for a PIC control mode of the LACU, and other of the temperature sensors can be redundant temperature sensors, and can be used by a controller of the LACU (e.g., either or both of Controller 1 and Controller 2 shown in FIG. 31) to implement a control mode (e.g., a PID controller as illustrated in FIG. 27) for the LACU when communication between the controller and the primary temperature sensor is lost. At block 3418, the process can determine an accuracy of a temperature offset stored in memory, by comparing the offset to temperature readings from the primary and redundant temperature sensors. The process for determining an accuracy of a temperature offset at block 3418 can be substantially similar to the process for determining an accuracy of a pressure offset described with respect to block 3412. Additionally, if the temperature offset is determined to be inaccurate (e.g., a sum of the offset and a reading from a redundant temperature sensor is not equal to, or within a tolerance range of the reading from the primary temperature sensor), the process 3400 can update the temperature offset value at block 3420 (e.g., similar to updating the pressure offset value at block 3414).

At block 3422, the process 3400 can implement pump speed control to achieve desired operating parameters for a LACU (e.g., any or all of LACU 100, 200, or 2500). In some cases, a controller of the LACU (e.g., controller 1, controller 2, shown in FIG. 31) can issue a signal to a pump cassette (e.g., to the Pump Cassette Controller illustrated in FIG. 31) to control a speed of a pump motor (e.g., the Pump Drive/Motor shown in FIG. 31) to achieve a set point for an operating parameter of the LACU (e.g., a differential pressure between an inlet and an outlet, a liquid flow rate through the liquid coolant loop, a differential temperature between the inlet and the outlet, etc.). For example, at block 3422 the process 3400 can implement the PID controller shown in FIG. 27. As shown in FIG. 27, the pumps of a LACU can be operated in one of a plurality of modes to achieve a set point for a desired operational parameter. For example, as shown in FIG. 27, the pump speed control can be operated in a Liquid Differential Pressure Mode (i.e., Mode 1 illustrated in FIG. 27), with the pump speed adjusted by a PID controller to achieve a set point for a differential pressure between a supply (e.g., a sensed pressure at a fluid outlet such as at the fluid outlet manifold 344 shown in FIG. 10, or a pressure sensed at the pressure sensor 2538 shown in FIG. 25) and a return (e.g., a sensed pressure at a fluid inlet such as at the inlet manifold 302, or a pressure sensed at the pressure sensor 2507 shown in FIG. 25). In some cases, the pump speed can be operated in a Liquid Flow Mode (e.g., Mode 2 illustrated in FIG. 27) to achieve a set point for a flow rate through the liquid coolant circuit (e.g., a flow rate sensed at the flow rate sensor 2534 shown in FIG. 25). In some cases, a pump speed can be operated in a Liquid Differential Temperature Mode (e.g., Mode 3 shown in FIG. 27) to achieve a set point for a temperature difference between a fluid inlet (e.g., the temperature sensed at temperature sensor 2506 shown in FIG. 25) and a fluid outlet (e.g., a temperature sensed at the temperature sensor 2536 shown in FIG. 25). In some cases, an operating mode can be selected by an operator of the LACU. In some cases, a LACU can operate in a default mode (e.g., Mode 1 shown in FIG. 27) and can switch to another mode upon a failure of a sensor used to sense an operating parameter of the mode. Further, while FIG. 34 illustrates a pump speed control at block 3422, the disclosure is equally applicable to the control of a control valve (e.g., the three-way motorized valve shown in FIG. 26) of an air-to-liquid cooling unit. A position of a control valve can be controlled to control a flow through an air-to-liquid cooling unit to achieve a set point for an operating parameter according to one or more modes illustrated in FIG. 27 (e.g., Modes 1-6 of the Air-to-Liquid Cooling Unit shown in FIG. 27). Pump speed for pumps of an LACU can be controlled according to parameters defined in the profile defined at one or more of blocks 3404, 3406. Implementing a pump speed control can include incrementally changing a speed of pumps in response to a determination that a measurement from a feedback sensor, or a calculation of a feedback parameter based on a measurement from one or more feedback sensors, differs from a set point. For example, referring to FIG. 27, if a measured differential pressure between an inlet and an outlet exceeds a set point, a pump speed can be changed (e.g., increased) by at least 2% relative to a previous pump speed. In some cases, a pump speed is increased by a minimum number of rotations per minute. In some cases, if a measurement from a feedback sensor is within a range of a setpoint (e.g., within 5 %, 4 %, 3 %, 2 %, or 1 %), the PID controller can allow the fan to operate in steady state (e.g., without altering a fan speed).

At block 3424, the process 3400 can implement fan speed control to achieve the desired operating parameters for the LACU. In some embodiments, a controller of the LACU can implement the PID controller illustrated in FIG. 28 to control a speed of the fans (e.g., the fans 206 illustrated in FIG. 1) to achieve a set point temperature for a coolant in the liquid cooling loop. Similar to the operation of the pump speed control described above at block 3422, fans (e.g., fans 206 shown in FIG. 2, fans 2514 shown in FIG. 25, or the Fan Module shown in FIG. 31) of a LACU can be operated according to one or more modes to achieve set points for corresponding operating parameters. In some cases, the process can select a default fan speed control mode (e.g., one of the fan speed control modes shown in FIG. 28) based on a user input or on a default setting (e.g., a factory setting) stored in a memory of the control unit. As shown in FIG. 28, when a feedback sensor for the control mode is broken or otherwise not in operation (e.g., removed for maintenance, or out of communication with the controller), a different mode can be selected, relying on a different feedback sensor for operation. In some cases, each mode can have associated therewith a separate set point for an operating parameter (e.g., for a temperature sensed at the respective feedback sensors for the different operating modes). In some cases, PID control gains can be individually defined for each operating mode. As further shown in FIG. 28, a PID control for fan speed can operate for air-to-liquid cooling units, alternatively or in addition to the LACUs described above. Implementing a fan speed control can include incrementally changing a speed of fans in response to a determination that a measurement from a feedback sensor, or a calculation of a feedback parameter based on a measurement from one or more feedback sensors, differs from a set point. For example, referring to FIG. 28, if a measured temperature of a liquid supply exceeds a set point for the liquid supply, a fan speed can be changed (e.g., increased) by at least 2% relative to a previous fan speed. In some cases, a fan speed is increased by a minimum number of rotations per minute. In some cases, if a measurement from a feedback sensor is within a range of a setpoint (e.g., within 5 %, 4 %, 3 %, 2 %, or 1 %), the PID controller can allow the fan to operate in steady state (e.g., without altering a fan speed).

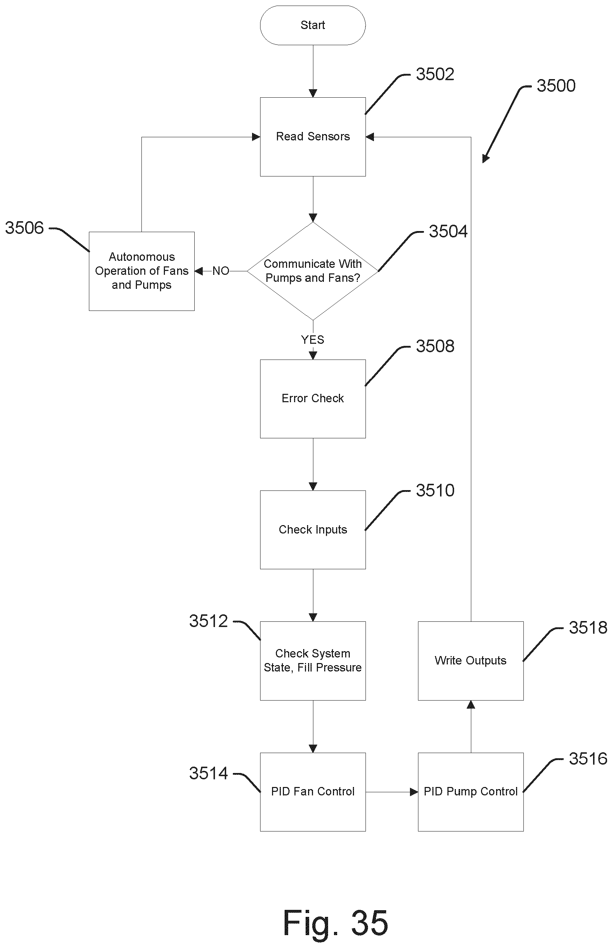

FIG. 35 illustrate an example process for a continuous operation of a cooling unit (e.g., the main controller illustrated in FIGS. 29A-29C, one or both of Controller 1 and Controller 2 shown in FIG. 31, etc.). LACUs such as LACU 100, 200, 2500, or air-to-liquid cooling units such as unit 2600 shown in FIG. 26). At block 3502, the controller can read values from sensors of the cooling unit. In some cases, the sensor readings can be readings of sensors used for the PID control methods described above with respect to blocks 3424 and 3422 shown in FIG. 34 (e.g., the PID controllers shown in FIGS. 27 and 28). In some cases, the sensors can be sensors not used as feedback sensors in PID controls (e.g., air temperatures sensors 2518 and humidity sensor 2520 shown in FIG. 25). Sensor reading can be recorded and logged and can be used by operators of the unit to evaluate an operational state of the unit. In some cases, reading for sensors can be provided at an interface (e.g., an API, a GUI, a web interface, a command line interface, a display at a panel of the unit, etc.). In some cases, readings from sensors can trigger one or more operations of the cooling unit. For example, if a reading is not available for a feedback sensor of a PID controller (e.g., when a reading is not received from pressure sensor 2507 along liquid return of LACU 2500 shown in FIG. 25), a PID control of the cooking unit can switch to another operating mode (e.g., the PID controller shown in FIG. 27 can switch from Mode 1 of the LACU to Mode 2). In some cases, a maximum and minimum operation parameters are defined for a cooling unit (e.g., maximum and minimum values loaded in a profile of the unit, as shown at block 3404 of FIG. 34), and if a reading from a sensor exceeds a maximum or minimum value set for that sensor, an operation of the cooling unit can be altered (e.g., the cooling unit can be shut off, a fan of the cooling unit can be shut off, a speed of fans or a pump of the cooling unit can be altered, an alert can be generated, etc.).

At block 3504, the process 3500 can check a communication with mechatronic components of the cooling unit (e.g., mechatronic components comprising actuators of PID controllers, as illustrated in FIGS. 27 and 28). For example, one or both of Controller 1 and Controller 2 can check a communication with the Fan Controller and the Pump Cassette Controller shown in FIG. 31. As another example, with reference to FIG. 26, a controller can check a communication with controllers of the fans 2620 and with the valve 2610. Checking a communication can include polling the given mechatronic component and determining if a response is received. In some cases, if mechatronic components are operational, they perform a push communication, advertising themselves to a controller, and a controller can determine that communication is lost with the mechatronic component after a predetermined time if a communication is not received within that time period. In some cases, any known methods, or protocols for checking a communication can be used to determine if the controller can communicate with mechatronic components of the cooling system.

At block 3506, if communication with the mechatronic components is unsuccessful at block 3504, mechatronic components can be operated autonomously. For example, in some cases, local controllers of mechatronic components can operate the components in an autonomous mode (e.g., an "emergency mode") until communication is established with the controller of the cooling unit. As an example, with reference to FIG. when the Fan Controller of the Fan Module (e.g., the fans 2620 shown in FIG. 26, the fans 2516 shown in FIG. 25, the fans 206 shown in FIG. 2, etc.), is not in communication with the Control Unit, the Fan Controller can operate the Fan Motor at a predefined speed, or according to a local PID stored on the Fan Controller until communication is reestablished with the Control Unit. In some cases, the Pump Cassette Controller can operate the Pump Drive/Motor according to a predefined speed or PID control when the Pump Cassette Controller loses communication with the Control Unit. As another example, when the cooling unit is an air-to liquid cooling unit (e.g., air-to-liquid cooling unit 2600 shown in FIG. 26), when a valve along a fluid flow path (e.g., the motorized valve 2610) loses communication with a controller of the unit, the valve can revert to a default position, to allow a flow of fluid through the unit (e.g., through the heat exchanger 2612) until communication is established with the controller. In some cases, for example, a valve can default to a fully open position at block 3506 to allow all flow through the liquid cooling loop of the cooling unit to flow through a heat exchanger. In some cases, a subset of mechatronic components of a cooling unit can operate in autonomous mode while other components are operated according to instructions received from a controller of the unit. For example, as shown in FIG. 25, a LACU 2500 can include a plurality of fans 2514 and dual pump cassette 2530. At block 3504, the process 3500 can determine that a controller can communication with the pump cassettes 2530 (e.g., with local controllers of the pump cassettes 2530) and a subset of the fans 2514 (e.g., with local controllers for each of the subset of fans 2514), while communication is not established with the remaining fans 2514 of the plurality of fans 2514. In this example, the controller for the LACU 2500 can operate to control the pump cassettes 2530 and the subset of the plurality of fans 2514, while the remaining fans 2514 can operate in autonomous mode. In some cases, if communication cannot be established with a threshold number of mechatronic components, all mechatronic components can operate in autonomous mode until a communication with the controller can be established. For example, in some cases, if a communication with both of the pump cassettes 2530 cannot be established, the fans 2514 and the pump cassettes can be operated in autonomous mode. As further illustrated in FIG. 35, block 3504 can be evaluated in a loop (e.g., continuously evaluated) and the process can continually determine if communication is established with components.

At block 3508, when communication is established with all or a portion of the mechatronic components (e.g., fans and pumps or pump cassettes of an LACU, or fans and valves of an air-to-liquid cooling unit), the process proceeds to check an error state of components of the unit. For example, with reference to FIGS. 31 and 32, the Fan Controller can have stored in a Memory, an error state of the fan. In some cases, individual components can have temperature sensors, and an operating temperature above a given threshold can trigger an error. In some cases, an error can be triggered when a component has been continuously operated over a predefined period of time. In some cases, errors can be information, and can be relayed (e.g., in a message, a log, an alert, at a GUI, etc.) to an operator to aid in operation of the cooling unit. In some cases, an error can trigger a shutdown of all or a portion of the unit. For example, when the Control Unit receives an error from one of the Pump Cassette Controllers indicating an overheating of the Pump Cassette, the Control Unit can initiate a failover to another Pump Cassette and can provide instructions to the Pump Cassette Controller to reduce a speed (e.g., to shut off) the overheated Pump Cassette.

At block 3510, the process 3500 can check for inputs. An input can be an input from an operator at an interface of a cooling unit. For example, an operator can access a web interface, a command line interface, an application programming interface, or can perform a direct wired connection to a controller of the cooling unit, and can provide an input for any operational value of the cooling unit (e.g., maximums and minimums for operational parameters, default operating modes, set points for PID controls, etc.). In some cases, a user can provide an input for any value defined in the profile of the cooling unit (e.g., the profile loaded at block 3404 of process 3400).

At block 3512, the process can check a system state and fill pressure of the cooling unit. For example, in some cases, a drop in fill pressure for a closed loop liquid cooling system (e.g., any of the LACUs 100, 200, and 2500) can indicate a leakage of fluid from the system. An action can be performed at block 3512 upon a determination that a system parameter is outside of acceptable system parameters. For example, a fill pressure that is lower than a rated fill pressure of the system can trigger an alert or a warning to an operator indicating a low fill pressure. If the fill pressure falls below another threshold value, an operation of the cooling unit can be stopped. In some cases, a system state can include a level of condensate detected, or contained in a condensate reservoir (e.g., as shown in FIG. 26). Other operational parameters can be checked at block 3512, and can indicate a need to perform a maintenance action, perform a filling operation, drain a condensate reservoir, replace a pump, etc.

At block 3514, the process 3500 can implement a fan speed control for a cooling unit (e.g., the LACUs 100, 200, 2500, the air-to-liquid cooling unit 2600, etc.). Implementing the fan speed control at block 3514 can include performing the PID controller illustrated in FIG. 28. Further performing the fan speed control at block 3514 can be substantially similar to performing fan speed control at block 3424 of process 3400 shown in FIG. 34.

At block 3514, the process 3500 can implement a fan speed control for a cooling unit (e.g., the LACUs 100, 200, 2500, the air-to-liquid cooling unit 2600, etc.). Implementing the fan speed control at block 3514 can include performing the PID controller illustrated in FIG. 28. Further performing the fan speed control at block 3514 can be substantially similar to performing fan speed control at block 3424 of process 3400 shown in FIG. 34.

At block 3516, the process 3500 can implement a PID control to control pump speed control for a cooling unit (e.g., the LACUs 100, 200, 2500). Implementing the pump speed control at block 3516 can include performing the PID controller illustrated in FIG. 27. Further, performing the pump speed control at block 3516 can be substantially similar to performing pump speed control at block 3422 of process 3400 shown in FIG. 34. In some cases, at block 3516, a PID controller is implemented to control a flow through a cooling unit (e.g., air-to-liquid cooling unit 2600 shown in FIG. 26) by controlling a position of a valve (e.g., the motorized valve 2610 shown in FIG. 26).

At block 3518, outputs can be written (e.g., to the Memory of one or both of Controller 1 and Controller 2 shown in FIG. 31). Outputs can be measurements from sensors along the cooling unit (e.g., any or all of sensors 2506, 2507, 2552, 2536, 2538, 2532, 2534, 2524, 2526, 2520, 2518, 2510, 2512 shown in FIG. 25, and or all of sensors 2606, 2608, 2618, 2614, 2616, 2624, 2626 shown in FIG. 26). In some cases, sensor readings can be logged as a time series, allowing an operator to view a historical value over time for a given parameter. The output can be communicated to an external system (e.g., via a communications system), and can be stored off the cooling unit. In some cases, outputs also include measured speeds for pumps (e.g., pumps of pump cassettes 2530 shown in FIG. 25), fans (e.g., fans 2514 shown in FIG. 25, fans 2620 shown in FIG. 26, etc.) or a position of a valve (e.g. a position of motorized valve 2610 shown in FIG. 26). Other outputs recording a system state can be written at block 3518, and can include error states, temperatures, flow rates, humidity, pressure, differential temperatures, differential pressures, etc. In some cases, an output can be a calculated value for a speed control signal based on a feedback received from a feedback sensor upon implementation of the PID controls at blocks 3514, 3516. For example, a calculated speed signal for a pump or a fan can be output at block 3518.

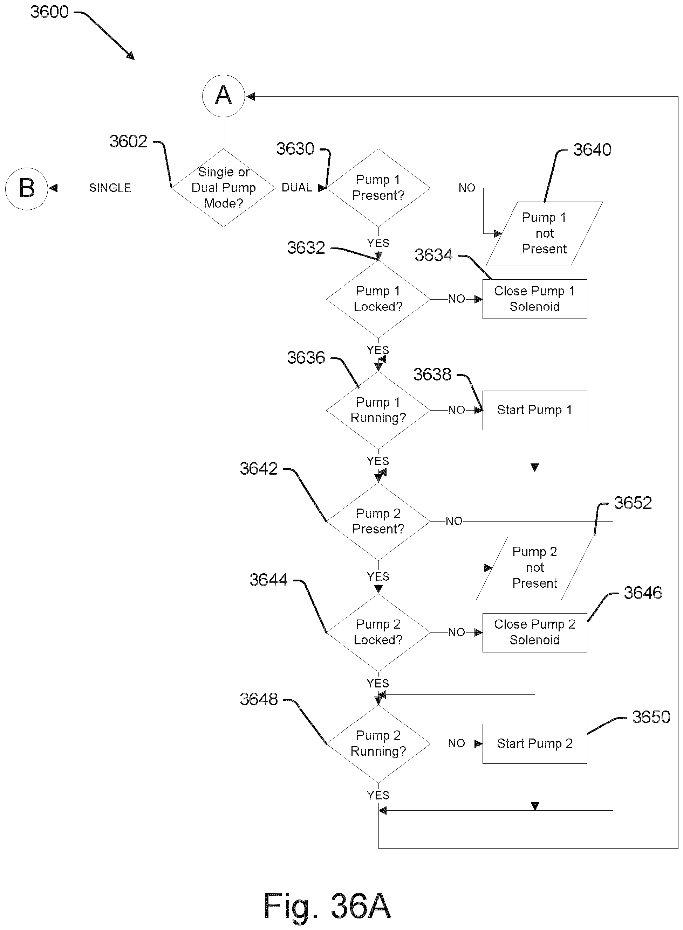

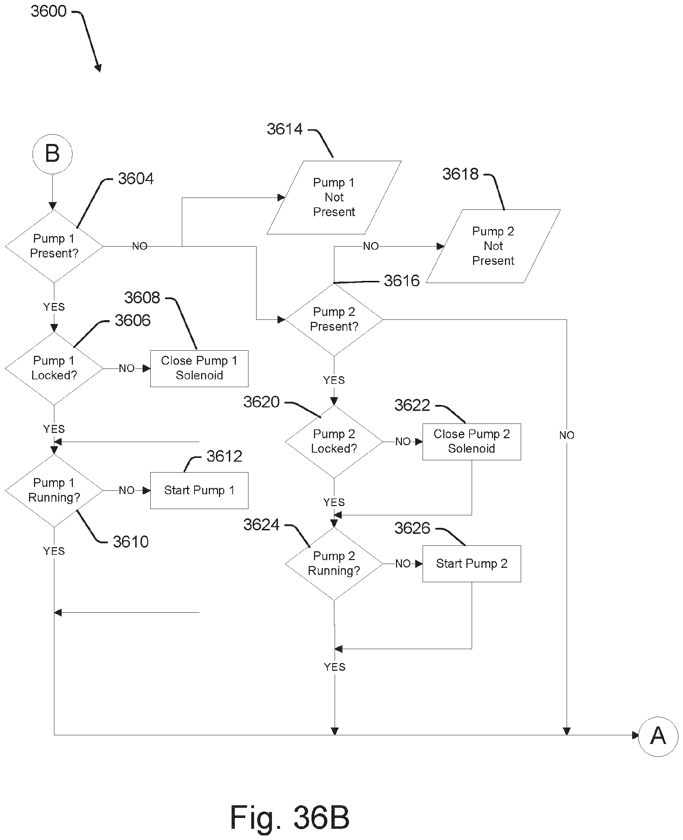

FIGS. 36A and 36B illustrate a process for operating pumps of a LACU (e.g., pumps of pump cassettes 210a, 210b shown in FIG. 2, pumps of pump cassette 2530 shown in FIG. 25, etc.). As shown, the process can decide whether to operate the pumps in Single or Dual Pump Mode at block 3602.

A decision with respect to whether to operate in Dual Pump Mode or Single Pump Mode can be made based on a setting of the LACU. For example, a controller of the LACU (e.g., either or both of Controller 1 and Controller 2 illustrated in FIG. 31) can have stored thereon a variable or an entry indicating a mode of operation for the pump, and a value of the variable or entry can indicate one of a Single or Dual Pump Mode. In some cases, an operator can select whether to operate the pumps in Dual or Single Pump Mode (e.g., via an input received at an interface). In some cases, an operating mode for the pumps can be defined in the profile for the LACU (e.g., the profile loaded at block 3404 shown in FIG. 34). In some cases, the decision whether to operate in Dual or Single Pump Mode can be made based on an operating condition. For example, in some cases, it can be necessary to increase a cooling rate of the LACU in response to a condition, which can include, for example, an increased temperature of a fluid within a cooling loop. As an example, if a single pump is operating at maximum capacity, and a temperature of a fluid at the outlet of the LACU exceeds a threshold value, the mode of the pumps of the LACU can be changed from Single Pump Mode to Dual Pump Mode, to provide an increased flow of fluid through the LACU. In some cases, an operating mode of the pumps can be changed from Single Pump Mode to Dual Pump Mode in response to a pump exceeding a certain threshold speed. For example, a LACU can switch to Dual Pump Mode if the operating pump is operating at or above 80 % capacity, 90 % capacity, 95 % capacity, etc.

If the process 3600 determines a block 3602 that the pumps of the LACU are operating in Single Pump Mode (e.g., "SINGLE"), the process 3600 can check if a first pump is present at a block 3604. In some cases, the first pump can be randomly chosen between the dual pumps of an LACU. In some cases, a first pump is defined in a controller (e.g., one or both of Controller 1 and Controller 2 shown in FIG. 31). Determining if a pump is present can include performing a communication with the pump (e.g., a communication between the Control Unit and the Pump Cassette Controller shown in FIG. 31). In some cases, determining if Pump 1 is present includes attempting to perform one or more operations of the pump (e.g., issuing instructions from the Control Unit to the Pump Cassette Controller to perform one or more action ), which can include, for example, reading values from sensors of the pump cassette for the first pump, operating the first pump at a first speed, operating a fan of the pump cassette, etc.

If Pump 1 is present, the process 3600 can proceed to determine if Pump 1 is locked at block 3606. In some cases, locking the pump includes engaging a solenoid to maintain a pump cassette (e.g., pump cassettes 210a, 210b shown in FIG. 2, pump cassettes 2530 shown in FIG. 25, etc.) in position, In some cases, movement of a pump cassette during operation can cause fitting of the pump cassette to disengage fitting of the LACU, and can cause fluid leakage and other mechanical issues. If Pump 1 is not locked, the process 3600, at block 3608, can include locking a solenoid to maintain Pump 1 in place. In some cases, with reference to FIG. 31, this can involve an instruction from the Control Unit to the Pump Cassette Controller to issue a signal to a solenoid (e.g., included in Cassette Electronic Components) to lock the pump cassette in place. In some cases, a solenoid is not provided, and Pump 1 can be locked through other locking mechanisms. In some cases, automated locking may not be provided for pumps of an LACU, and a communication (e.g., an alert) can be generated for an operator to inform the operator that Pump 1 is unlocked. The operator can perform a manual locking mechanism in response to the communication, and the process 3600 can determine that Pump 1 is locked in response.

If Pump 1 is locked, the process can proceed to determine if Pump 1 is running at block 3610. If Pump 1 is not running, the process can start Pump 1 at block 3612, and if Pump 1 is running, the process can proceed to assess whether an operating mode of the LACU is Single or Dual Pump Mode at block 3602.

If Pump 1 is not present, a message can be generating indicating that Pump 1 is not present at block 3614. In some cases, the message can include an error or a log entry. In some cases, the message can comprise an alert that is provided to an operator at an interface (e.g., a web interface, a mobile app, an API, a CLI, etc.).

Additionally, if Pump 1 is not Present, the process 3600 can proceed to determine if Pump 2 is present at block 3616. Determining if Pump 2 is present can be substantially similar to determining if Pump 1 is present, and the description provided above for Pump 1 can be applicable for Pump 2. If Pump 2 is not present, a message is generated indicating that Pump 2 is not present at block 3618.

If Pump 2 is present, the process can proceed to check if Pump 2 is locked at block 3620. If Pump 2 is not locked, the process can include locking Pump 2 at block 3622. The process 3600 can proceed to check if Pump 2 is running at block 3624. If Pump 2 is not running, the process can include starting Pump 2 (e.g., similar to the description above for Pump 1) at block 3626.

If Pumps 1 and 2 are operated in Dual Pump Mode (e.g., "DUAL"), the process 3600 can ensure that both of Pumps 1 and 2 are running. Ensuring that both pumps 1 and 2 are running can include, for each of Pumps 1 and 2, checking if the pump is not present. As described above, if either or both of Pumps 1 and 2 are not present, a message can be generated indicating the absence of the respective pump. The process 3600 can further check if each of Pumps 1 and 2 are locked and can lock the respective pumps if the pumps are not lock (e.g., as described above with respect to Pump 1). Further, the process can determine if Pumps 1 and 2 are running, and if one of the pumps is not running, the process 3600 can start the pump. As shown in FIGS. 36A and 36B, in some cases, Pumps can be started in series (e.g., the process 3600 can determine if Pump 1 is present, locked, and running before checking if Pump 2 is present, locked, and running). In some cases, pumps of a LACU can be started in parallel.

For example, if operating in Dual Pump Mode, the process 3600 can check if Pump 1 is present at block 3630. If Pump 1 is present, the process 3600 can check if Pump 1 is locked at block 3632. If Pump 1 is locked, the process can assess if Pump 1 is running at block 3636. If Pump 1 is not locked, Pump 1 can be locked at block 3638 and check if Pump 1 is running at block 36420. If Pump 1 is not running, the process can start Pump 1 at block 3638. If Pump 1 is running, the process can check if Pump 2 is present at block 3642.

If Pump 1 is not present, a message can be generated indicating that Pump 1 is not present at block 3640. Additionally, if Pump 1 is not present, the process 3600 can proceed to determine if Pump 2 is present at block 3642. If Pump 2 is present, the process 3600 can check if Pump 2 is locked at block 3644. If Pump 2 is locked, the process can access if Pump 2 is running at block 3648. If Pump 2 is not locked, Pump 2 can be locked at block 3646 and check if Pump 2 is running at block 3648. If Pump 2 is not running, Pump 2 can be started at block 3650 and the process can proceed to assess whether an operating mode of the LACU is Single or Dual Pump Mode at block 3602. If Pump 2 is running, the process can proceed to assess whether an operating mode of the LACU is Single or Dual Pump Mode at block 3602.

If Pump 2 is not present, a message can be generating indicating that Pump 2 is not present at block 3652. Additionally, if Pump 2 is not present, the process can proceed to assess whether an operating mode of the LACU is Single or Dual Pump Mode at block 3602.

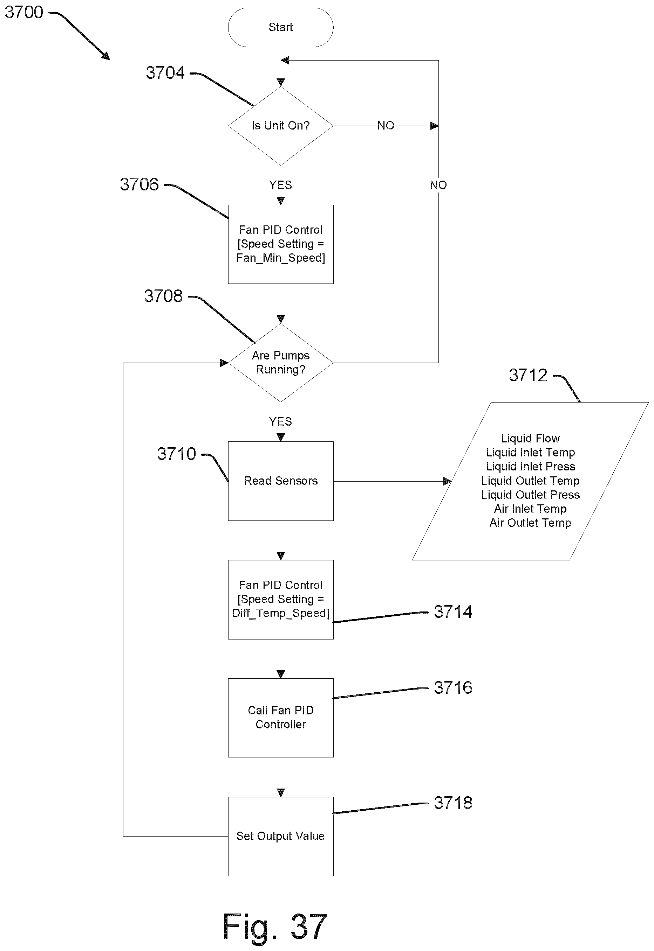

FIG. 37 illustrates a process for operating fans of a cooling unit (e.g., fans 106, 206, 2514, 2620 shown in FIGS. 1, 2, 25, and 26 respectively). The process can include determining if the cooling unit (e.g., the LACU 1, 2, 25 shown in FIGS. 1, 2, and 25, the air-to-liquid cooling unit 2600 shown in FIG. 26, etc.). If the unit is on, a speed of the fans of the unit can initially be set to a minimum speed value. The minimum speed value can be stored in a controller of the cooling unit (e.g., Controller 1, Controller 2, shown in FIG. 31), and in some cases can be defined in a profile of the unit (e.g., a profile loaded at block 3404 shown in FIG. 4). In some cases, a minimum speed of a fan is stored at a local controller of the fan (e.g., the Fan Controller shown in FIG. 31) and can be set as a default value that can be read only (e.g., the minimum speed value can be inaccessible for an operator, and unavailable to change as a user setting).

At block 3708, the process can determine if one or more pumps are running (e.g., the pumps of pump cassettes 210a, 210b shown in FIG. 2, pump cassettes 2530 shown in FIG. 25, etc.). Determining that the pump is running at block 3710 can be similar to determining if one or both of Pump 1 and Pump 2 are running, as described with respect to FIGS. 36A and 36B.

At block 3710, sensors of the cooling unit can be read. Reading the sensors can include communication between the Control Unit and the Sensor Modules shown in FIG. 31. Reading sensors at block 3710 can be substantially similar to reading sensors at block 3502 shown in FIG. 35, and the description with respect to block 3502 is applicable for block 3710. At block 3712, sensor values can be written to a system. In some cases, the sensor values can be written to a controller of a cooling unit (e.g., controller 1, Controller 2, shown in FIG. 31). In some cases, the sensor values can be communicated to another computing system (e.g., cloud-based stored, a mobile application, a database, a logging system, etc.), and can be accessed remotely from the cooling unit. As illustrated in FIG. 37, sensor readings written at block 3712 can include a liquid flow rate, a liquid inlet (e.g., return) temperature, a liquid inlet pressure, a liquid outlet temperature, a liquid outlet pressure, an air inlet temperature, an air outlet temperature, etc. In some cases, any value obtained from a sensor (e.g., any or all of the sensors shown in FIGS. 25 and 26) can be written at block 3712.

At block 3714, a speed of the fans of the cooling unit can be incremented. In some cases, the speed of the fans can be incremented or altered based on the measured values obtained at block 3710. For examples, if measured values from a feedback sensor exceed a set point for a temperature value of a fluid in cooling unit, a speed of the fans can be increased by a predefined amount. At block 3716, a fan PID controller (e.g., the fan PID controller shown in FIG. 28) can be called. Calling the fan speed PID controller at block 3716 can be substantially similar to performing block 3514 of FIG. 35, or block 3424 shown in FIG. 34. At block 3718, an output value can be generated from the PID controller, and a subsequent signal (e.g., at block 3714) to the fan to alter a speed of the fan (e.g., a signal from the Control Unit to the Fan Controller shown in FIG. 31) can be based on the output generated at block 3718.

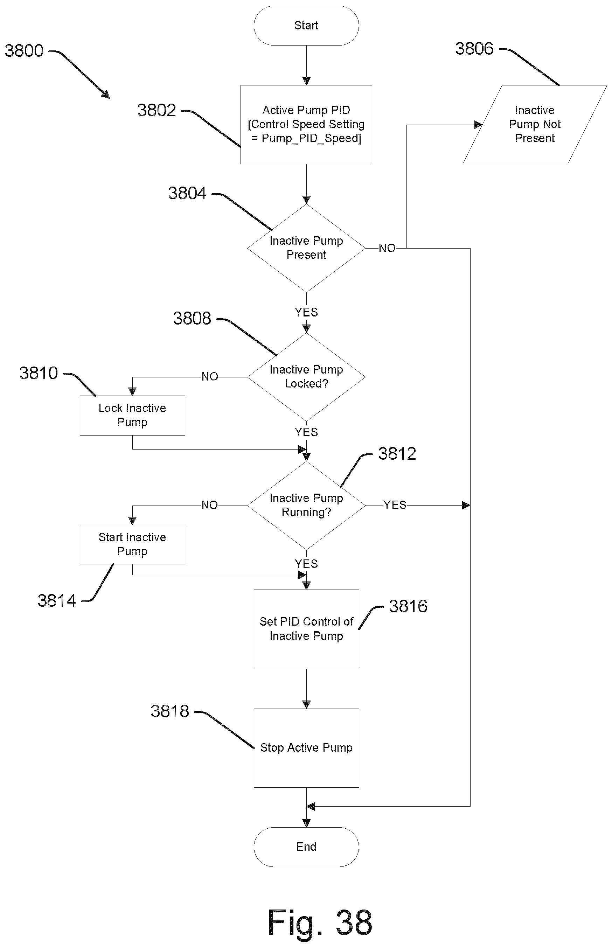

FIG. 38 illustrates an example process 3800 for performing a switchover from an active pump (e.g., an active one of pumps of the cassettes 210a, 210b shown in FIG. 2, an active one of the pumps of the pump cassettes 2530 shown in FIG. 25., etc.). Process 3800 can be performed when a LACU (e.g., LACU 100, 200, 2500 shown in FIGS. 1, 2, and 25 respectively) are operating in Single Pump Mode, as described, for example, with respect to FIGS. 36A and 36B, with one pump being an active pump, and the other pump being an inactive pump.

At block 3802, the active pump can be operated according to a PID control for the pump (e.g., the PID control shown in FIG. 27). At block 3804, the process can determine if the inactive pump is present. Determining if the inactive pump is present can include determining if a communication is established with the inactive pump, as described with respect to block 3504 shown in FIG. 35. If the inactive pump is not present, at block 3806, a message can be generated (e.g., an error, a log, an alert, an entry in a database, etc.) indicating that the inactive pump is not present.

If the inactive pump is present, (e.g., as determined by a communication from the pump to a controller of the LACU, a position of a limit switch, etc.), the process 3800 can determine if the inactive pump is locked at block 3808, as described, for example with respect to FIGS. 36A and 36B. If the inactive pump is not locked, the process 3800 can include locking the inactive pump in place at block 3810 (e.g., either by indicating a need for an operator to manually lock the inactive pump, or by performing a locking operation automatically). The process can proceed to block 3812 and determine if the inactive pump is running. If the inactive pump is not running, the process 3800 can start the inactive pump at block 3814 and proceed to block 3816. If the inactive pump is running at block 3812, the process can then proceed to block 3816.

In some cases, a process for performing a switchover between pumps of an LACU can include performing the switchover to minimize a disruption in flow through the LACU. In some cases, a switchover can include ramping down (e.g., iteratively slowing) a previously active pump, and ramping up (e.g., iteratively speeding up) a previously inactive pump to maintain a flow rate previously induce by the previously active pump while the switchover is in process. A previously inactive pump can be ramped up until it reaches the full speed values of the previously active pump prior to the switchover or can be ramped up to a speed required by a PID control (e.g., the PID control shown at FIG. 27). At block 3816, a speed of the inactive pump can be set to the speed dictated by the PID control for pump speed. This can include an iterative (e.g., a stepwise) speeding of the inactive pump until the inactive pump reaches a steady state speed dictated by the PID control (e.g., communicated from the Control Unit to the Pump Cassette Controller shown in FIG. 31). At block 3818, the process can stop the active (e.g., the previously active) pump. Stopping the active pump can include iteratively slowing the active pump until a flow through the active pump is stopped.

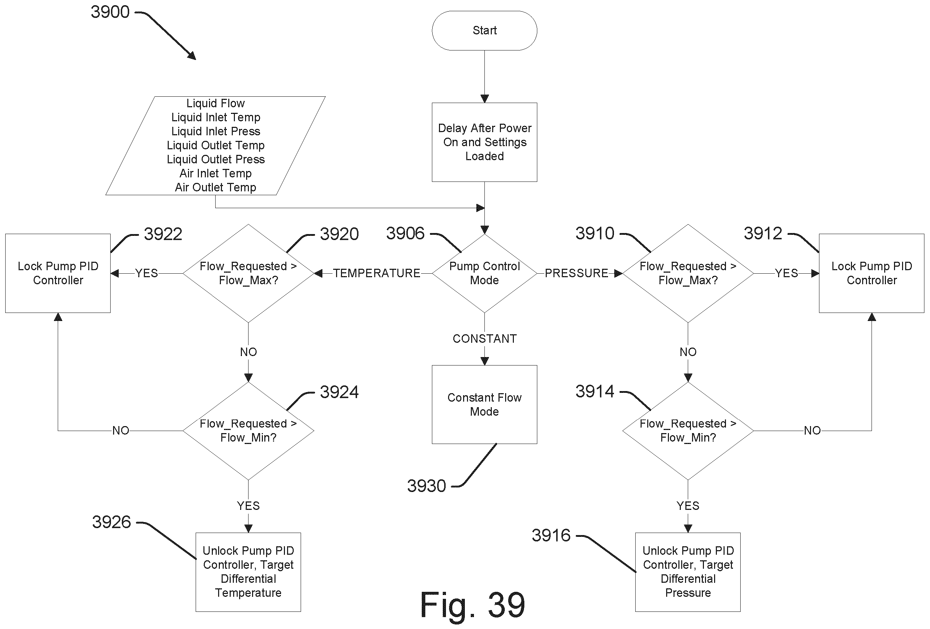

FIG. 39 illustrates an example process 3900 for controlling an operating mode of pumps of an LACU. The pump control mode can be decided at block 3906 of process 3900. As shown, the pump can be operated in one of a target differential pressure mode at block 3916 (e.g., Mode 1 for a Liquid-to-Air Cooling unit, as shown in FIG. 27), constant flow mode at block 3930 (e.g., Mode 2 for a Liquid-to-Air Cooling Unit shown in FIG. 27), and a target differential temperature mode at block 3926 (e.g., Mode 3 for a Liquid-to-Air Cooling Unit shown in FIG. 27). The mode can be selected by an operator. Additionally, or alternatively, an LACU can have stored thereon a default mode. When the LACU cannot implement one of the modes (e.g., due to a fault in a sensor required to operate a PID control for the given mode), the LACU (e.g., a controller of the LACU) can switch to another of the modes. In some cases, an operator can select an order of modes to be implemented upon a failure of a give mode. For example, an operator can determine (e.g., via an input at an interface of the LACU) that the LACU should perform block 3916 by default, and when the LACU is unable to perform block 3916, the LACU switch to block 3930 (e.g., a control of the pumps of the LACU is switched from implementing a PID control for a target differential pressure to a PID control for a target flow rate). In some cases, more operating modes corresponding to pump control methods (e.g., PID controls) can be implemented.

The process 3900 can enforce maximum flow rates of fluid through the pumps and can interrupt an operation of a given mode when a flow rate is outside of an acceptable range. In some cases, a maximum and minimum flow rate is calculated based on system parameters (e.g., a temperature of fluid, a pressure of the fluid, an ambient temperature, a lifespan of the pumps, etc.). In some cases, maximum and minimum flow rates are defined as a system parameter and can be loaded as part of a profile for a LACU (e.g., as described with respect to block 3404 shown in FIG. 34). If a flow rate of fluid in the LACU exceeds a maximum flow rate value, or is less than a minimum flow rate, the process 3900 can stop the PID controller (e.g., "Lock" the PID controller). A controller (e.g., one or both of Controller 1 and Controller 2 shown in FIG. 1) can issue a speed signal to the pumps (e.g., to the Pump Cassette Controller shown in FIG. 31) to alter speed of the pumps to bring the flow rate through the LACU within the defined acceptable range (e.g., less than or equal to a maximum flow rate and greater than or equal to a minimum flow rate). The process can continuously evaluate the flow rate, and when the flow rate is within the acceptable range, the PID controller for a given operating mode (e.g., one of the PID controllers implemented at block 3916 and 3926) can be unlocked, and the pumps can be operated via a PID controller to achieve a set point for target operating value.

For example, the process 3900 may determine the pump control mode at block 3906 in a target pressure mode ("PRESSURE"). In the PRESSURE mode, the process 3900 evaluates if a flow rate of a fluid in the LACU exceeds a maximum flow rate value at block 3910. If the flow rate of the fluid in the LACU is above a maximum flow rate value, the process locks the pump PID controller at block 3912. If the flow rate of the fluid in the LACU is below a maximum flow rate value, the process assesses if the flow rate of the fluid in the LACU is above a minimum flow rate value at block 3914. If the flow rate of the fluid in the LACU is above a minimum flow rate value, the process locks the pump PID controller at block 3912. If the flow rate of the fluid in the LACU is above a minimum flow rate value, the process unlocks the pump PID controller and targets differential pressure at block 3906 (e.g., Mode 1 for a Liquid-to-Air Cooling unit, as shown in FIG. 27)

In some cases, the process 3900 may determine the pump control mode at block 3906 in a target temperature mode ("TEMPERATURE"). In the TEMPERTURE mode, the process 3900 evaluates if a flow rate of a fluid in the LACU exceeds a maximum flow rate value at block 3920. If the flow rate of the fluid in the LACU is above a maximum flow rate value, the process locks the pump PID controller at block 3922. If the flow rate of the fluid in the LACU is below a maximum flow rate value, the process assesses if the flow rate of the fluid in the LACU is above a minimum flow rate value at block 3924. If the flow rate of the fluid in the LACU is above a minimum flow rate value, the process locks the pump PID controller at block 3922. If the flow rate of the fluid in the LACU is above a minimum flow rate value, the process unlocks the pump PID controller and targets differential pressure at block 3926 (e.g., Mode 3 for a Liquid-to-Air Cooling Unit shown in FIG. 27).

In other cases, the process 3900 may determine the pump control mode at block 3906 to be a constant flow mode ("CONSTANT"), and the process operates at block 3930 (e.g., Mode 2 for a Liquid-to-Air Cooling Unit shown in FIG. 27).

In some cases, a process may need to call a multi-step controller to control flow through a bypass loop in other to achieve a setpoint for an operating parameter of the LACU, or, in some cases, to extend or boost an uptime of the system. For example, a process for calling the multi-step controller can be implemented by a controller of the sidecar to control a valve of bypass loop. In some embodiments, the process can be called to achieve a desired set point for an operating parameter when a pump speed of pumps of a CDU is at a minimum value. In some embodiments, all or a portion of the process can be executed as part of an uptime boost mode for the sidecar.

To start, the process can evaluate whether an outlet of the coolant loop is blocked (e.g., when pumps are running, but there is not flow of coolant in the coolant loop). If a blockage is detected, a valve of the bypass loop can be fully opened to allow 100% of the flow of the coolant loop to flow through the loop bypass circuit. In some embodiments, the process can evaluate a pressure at an outlet (e.g., as measure by pressure sensor 228g for secondary outlet 120b illustrated in FIG. 32). For example, the outlet pressure can be compared to a maximum pressure of the system and if the outlet pressure exceeds the maximum pressure, a valve of the loop bypass circuit can be partially opened. In some embodiments, as illustrated, a valve of the loop bypass circuit can be opened 75% to allow 75% of the flow of the loop to flow through the loop bypass circuit. In other embodiments, the loop bypass circuit can be opened to allow a greater percentage or a lesser percentage of the flow through the coolant loop to bypass pumps and the HX of the loop. Opening the loop bypass circuit can thus relieve pressure along the coolant loop.

Continuing, the process can proceed to implement the multi-step controller, to control operating parameters through partially opening or partially closing the valve of the loop bypass circuit to permit or restrict flow of the coolant through the loop bypass circuit (e.g., directly from secondary inlet 118b to secondary outlet 120b, as illustrated in FIG. 32). In some embodiments, the operating parameter that is controlled by the multi-step controller is a differential parameter (e.g., a differential temperature between a inlet and an outlet, a differential pressure between a inlet and an outlet, or a differential pressure between a suction port and a discharge port for a pump), and permitting greater flow through the loop bypass circuit can reduce a difference between an operating parameter at the inlet and the operating parameter at the outlet.

In some cases, the multi-step controller can evaluate the value of the operating parameter against a setpoint for the operating parameter. For example, a differential pressure between the inlet and the outlet can be compared to a differential pressure setpoint. In some embodiments, a differential temperature between the inlet and the outlet can be compared to a differential temperature setpoint. If the operating parameter value exceeds the setpoint value (e.g., a difference between a pressure or temperature of the inlet and outlet exceeds the setpoint for the differential pressure or temperature respectively) the multi-step controller can proceed to measure the difference between the operating parameter and the setpoint, and can modulate the valve of the loop bypass circuit to allow a greater portion of the coolant in the coolant circuit to flow through the bypass circuit.

For example, the multi-step controller can evaluate if the operating parameter exceeds the setpoint value by more than a first offset. In an example, the first offset could be 1 bar, the operating parameter can be a differential pressure between the inlet and the outlet, which can be 3 bar, and the set point can be 1 bar. In this example, the operating parameter exceeds the set point (1 bar) by more than the first offset (1 bar). Thus, when the operating parameter exceeds the setpoint by more than the first threshold, the bypass valve can be controlled to restrict flow through the loop bypass circuit by a first restriction amount. In the illustrated embodiment, the first restriction amount is 20%, and thus, the valve of the loop bypass circuit can be partially closed to restrict the flow through the valve and thus through the bypass circuit by 20%. While the first restriction amount is illustrated as 20%, a first restriction amount can restrict flow through a loop bypass circuit by any amount, and can be set (e.g., by an operator) as a percentage of total flow through the system, a percentage of flow through the bypass loop prior to implementing the restriction, an absolute amount of flow through the bypass loop, or a percentage by which a valve of the bypass loop is opened or closed.

In some embodiments, the multi-step controller implemented can further evaluate differences between an operating parameter and a set point and restrict a flow through a loop bypass circuit by a corresponding restriction amount. As illustrated, if the operating parameter does not exceed the setpoint by more than a first threshold, the multi-step controller can evaluate whether the operating parameter exceeds the setpoint by a second threshold, the second threshold being lower or smaller than the first threshold. If the operating parameter exceeds the setpoint by more than the second threshold, the multistep controller can issue a signal to the valve of the loop bypass circuit to restrict flow through the loop bypass circuit by a second restriction amount. In some embodiments, the second restriction amount can be less than the first restriction amount (e.g., as illustrated, the second restriction amount is 10% and the first restriction amount is 20%). In some embodiments, if the operating parameter does not exceed the setpoint by the second offset, the multi-step controller can evaluate if the operating parameter exceeds the setpoint by a third offset, the third offset being smaller than the second offset. If the operating parameter exceeds the setpoint by the third offset, the multistep controller can issue a signal to the valve of the loop bypass circuit to restrict flow through the loop bypass circuit by a third restriction amount. Further, if the operating parameter does not exceed the setpoint by the third offset, the multi-step controller can evaluate if the operating parameter exceeds the setpoint by a fourth offset, the fourth offset being smaller than the third offset. If the operating parameter exceeds the setpoint by the fourth offset, the multistep controller can issue a signal to the valve of the loop bypass circuit to restrict flow through the loop bypass circuit by a fourth restriction amount. Each evaluation and their respective flow restrictions can comprise a flow restriction step of the multi-step controller. As illustrated, the multi-step controller can comprise four flow restriction steps. In other embodiments, a multi-step controller can include less than four flow restriction steps, or more than four flow restriction steps. In some embodiments, an operator can select a number of flow restriction steps for a multi-step controller, as well as offsets and restriction amount corresponding to each step.

Continuing, if the operating parameter is not greater than the setpoint, the process can implement a step or steps to increase flow of coolant through the loop bypass circuit. For example, if the operating parameter is less than the setpoint by more than a fifth offset, the valve of the loop bypass circuit can be controlled to increase a flow through the loop bypass circuit by a first flow increase amount (e.g., 20% as illustrated). If the operating parameter is not less than the setpoint by more than the fifth offset, the multi-step controller implemented by the process can evaluate whether the operating parameter is less than the setpoint by more than a sixth offset, the sixth offset being smaller than the fifth offset. If the operating parameter is less than the setpoint by more than the sixth offset, the valve of the loop bypass circuit can be controlled to increase a flow through the loop bypass circuit by a second flow increase amount (e.g., 10% as illustrated). The process further includes evaluating whether the operating parameter is less than the setpoint by more than a seventh offset and controlling the valve of the loop bypass circuit to achieve a third flow increase amount. The process further includes evaluating whether the operating parameter is less than the setpoint by more than an eighth offset and controlling the valve of the loop bypass circuit to achieve a fourth flow increase amount. In some embodiments, the offsets used for evaluation can be set by an operator of the CDU. In some embodiments, the flow increases amounts that the valve of the loop bypass circuit is controlled to achieve can be set by the operator. In some embodiments, more than four flow increase steps can be implemented in a multi-step controller, or less than four flow increase steps.

The multi-step controller can be operated as a continuous process or a loop, and after each iteration of the loop, the controller can once again be called to determine a control signal for the valve of the control loop. In some embodiments, when an operating parameter exceeds the setpoint by an offset (e.g., by the first, second, third, or fourth offsets), the valve of the loop bypass circuit can be opened to increase a flow through the bypass circuit. Similarly, in some embodiments, when the operating parameter is less than the setpoint by another offset (e.g., by the fifth, sixth, seventh, and eighth offsets) the valve of the loop bypass circuit can be partially closed to restrict flow through the loop bypass circuit.

In some cases, control systems of a controller can be applicable in the contexts of multiple different types of cooling units. For example, the controllers illustrated in FIGS. 31 and 32 can be housed in the removable control modules 2104a, 2104b shown in FIG. 21, or the removable control module 214a, 214b shown in FIG. 12. While these control modules 2104a, 2104b, 214a, 214b are shown and described in the context of a LACU (e.g., the LACU 200 shown in FIGS. 2-12), control modules according to the present disclosure can be compatible with liquid-to-air cooling units, air-to-liquid cooling units (e.g., the cooling unit 2600 shown in FIG. 26), liquid-to-liquid cooling units, etc. All or a portion of the control methods stored on the controllers of the removable control modules can be usable across different types of cooling units. In some aspects, a cooling unit may include a heat exchanger, a first flow control assembly for driving a flow of a process fluid through the heat exchanger, and a second flow control assembly for driving a flow of a working fluid across the heat exchanger. The working fluid is a fluid used to cool downstream electrical systems, while the process fluid is a fluid to which waste heat from the working fluid is rejected. Where a fluid (e.g., a working fluid or a process fluid) is air or other gases, flow control assemblies can include fans to drive a flow of the air or gas across the heat exchanger. Where a fluid is a liquid coolant, flow control assemblies can include pumps for driving a flow of the liquid through the heat exchanger, or valves to regulate a flow of liquid through the heat exchanger (e.g., as when a pressure for the fluid is supplied by a facility). Thus, for example, in the context of the LACU 200 described above and shown in FIGS. 2-12, the process fluid is air, the working fluid is a liquid coolant, and the flow control assembly for the working fluid includes the pumps housed in the pump cassettes 210a, 210b shown in FIG. 12, while the flow control assembly for the process fluid includes the fans 206. In the context of the air-to-liquid cooling unit 2600 shown in FIG. 26, the process fluid is a facility water and the working fluid is an air, with the flow control assembly for the process fluid including the valve 2610, and the flow control assembly for the working fluid being the fans 2620. In other examples a process fluid and a working fluid can both be a liquid or can both be an air. In some cases, flow control assemblies for process fluids and working fluids can be pumps, or can both be fans, or can be a combination of pumps and fans, or pumps and valves.

A control system for a cooling unit can provide a generalization (e.g., an abstraction) of a control of process and working fluids, as can allow the control system to be implemented across different cooling units and systems. In some examples of the disclosed technology, control systems (e.g., software implemented at a controller) can control a flow of a process fluid to achieve a desired temperature value for a working fluid (e.g., a supply temperature at an outlet of the cooling unit or of the heat exchanger, a differential temperature of the working fluid across an inlet and outlet of the cooling unit and the heat exchanger, etc.). For example, in a LACU, a PID controller for control of the fans can control a speed of the fans to control a flow of the process fluid (i.e., air) across the heat exchanger to achieve a target outlet temperature for the liquid coolant (e.g., one of the Liquid Supply Temperature 1, Liquid Supply Temperature 2, and Liquid Supply Temperature 3, shown in FIG. 28 for a Liquid-to-Air Cooling Unit). Similarly, for an air-to-liquid cooling unit, where the working fluid is air, and the process fluid is facility water, the control system can implement a PID controller for control of a valve (e.g., the valve 2610 shown in FIG. 26) to control a flow of the process fluid through the heat exchanger in order to achieve a target outlet temperature of the working fluid (i.e., air) at an air outlet of the unit (e.g., as shown in the modes for an air-to-liquid cooling unit illustrated in FIG. 27). In some examples, a control system for cooling units can control a flow of a working fluid to achieve a desired flow rate for the working fluid. Thus, in a default mode, pumps of a LACU (e.g., LACU 200 shown in FIGS. 2-12) can be controlled (e.g., via a PID controlled implemented at the control system) to achieve a constant target flow rate or RPM value for the pump (e.g., as shown with respect to the pump control PID for a LACU illustrated in FIG. 27). In some examples, a flow control assembly for a working fluid can be controlled to achieve a desired differential pressure for the working fluid, or to achieve a target pressure value at one or more points along piping of the cooling unit.

A control of flow control assemblies (e.g., systems including any of pumps, fans, controllable valves, etc.) to drive a flow of fluid through a cooling unit can further be designed to implement "fence" conditions on operation of the cooling unit while targeting desired values within the system. For example, as shown in blocks 3920, 3924, 3910, 3914 FIG. 39, a LACU (e.g., LACUs 100, 200, 2500, 3100 shown in FIGS. 1, 2, 25, and 31 respectively) can have programmed thereon a maximum flow rate (e.g., Flow_Max) and a minimum flow rate (e.g., Flow_Min), and control of the pumps of the LACU can be adjusted based on whether the output of a respective PID controller (e.g., a constant flow PID controller at block 3930, a differential pressure PID controller at block 3916, a differential pressure controller at block 3926, etc.) would produce a flow that is within a range bounded by a maximum and minimum flow rate. If the output of the respective PID controller is outside of a range bounded by a maximum flow rate and a minimum flow rate, the control system can either switch an operating mode of the pumps (e.g., switch from a differential pressure mode to a constant flow mode, etc.) or can manually set an output to produce a flow rate within the range (e.g., set an output flow rate to the minimum flow rate if the PID controller produces a flow rate output that is below the minimum flow rate, or set an output flow rate to the maximum flow rate when the PID controller produces a flow rate that is above the maximum flow rate). Fence conditions can be hard coded in a system (e.g., in a memory of Controller 1, Controller 2 shown in FIG. 31), or can be user defined. In some cases, fence conditions that can be critical to an operation of the system (e.g., maximum allowable pressure along a liquid cooling circuit, maximum pump speeds, maximum fan speeds, etc.) can be hard coded, while other fence conditions can be user configurable and can define optimal conditions and behaviors of the system. Fence conditions can include, but are not limited to the operating conditions shown in FIG. 30A-1 (e.g., ranges for Liquid Supply Temperature, Liquid Return Temperature, Liquid Supply Pressure, Liquid Return Pressure, Average Relative Humidity, etc.).

In some cases, operating a cooling unit can require prioritizing a target values or operational parameter over another value or parameter. For example, some desired operating conditions (e.g., a maximum allowable pressure along a liquid cooling circuit) can have a greater priority than other operating conditions. In an example, as shown in FIG. 30A-1, a LACU can have stored thereon a range for a Differential Temperature (e.g., -100 C to 100 C) between a supply and return (e.g., a difference in temperature between an inlet and an outlet of the LACU), but a maximum allowable pressure along a liquid cooling circuit can have greater priority. Thus, where both conditions cannot be satisfied simultaneously, a control system for the LACU can select an actuator output (e.g., a pump speed) that satisfies the higher priority condition (e.g., maximum allowable pressure), even if it results in a value for a differential temperature that is outside the specified range. In some cases, a priority of respective fence conditions can be hard-coded into a control system for a cooling unit.

In some cases, a controller can change an operating mode of flow control assemblies for a cooling unit (e.g., from the default operating mode described above) in response to a condition of the system. For example, in some cases, flow control assemblies for the service fluid can be insufficient to produce a necessary cooling of the working fluid. With reference to LACU 200, a heat of the liquid coolant (e.g., measured at the outlet or supply) can exceed a capacity of the fans to cool (e.g., the fans can be insufficient to cool the liquid coolant even when all fans are operated at a maximum speed). When a controller of the LACU 200 detects this condition, it can change a control mode for the pumps. Detecting that a heat of a liquid coolant exceeds a capacity of the fans can include determining that a heat is above a threshold, determining that the fans are operating at a maximum speed, detecting that an approach temperature of the heat exchanger is below a threshold value, etc. When this condition is met, an operating mode of the pumps can be changed to decrease a temperature of the liquid coolant at the outlet of the cooling unit. In some cases, a controller can issue an instruction (e.g., a signal) to one or more pumps to operate at a maximum allowable speed in response to determining that the fans are operating at maximum speed. In some cases, a controller can implement a PID control for the one or more pumps to implement a PID control to achieve a target value for an outlet temperature of the liquid coolant. Operating modes of the fans and the pumps of the LACU can return to default operating modes (e.g., as described above) when the conditions that required a change in operating mode no longer exists.

In some examples, a liquid cooling system in which the disclosed control systems can be implemented may include an enclosure (e.g., the cabinet 201 shown in FIG. 2) housing a heat exchanger (e.g., the heat exchanger 202 shown in FIG. 9, the heat exchanger 2508 shown in FIG. 25, the heat exchanger 2612 shown in FIG. 26, etc.). The heat exchanger may be configured to transfer heat from a working fluid to a process fluid, where the working fluid is used for cooling electrical equipment within a data center. The system may include a first flow control assembly to control flow of the working fluid through the heat exchanger and a second flow control assembly to control flow of the process fluid through the heat exchanger. For example, in the context of the LACU 200 shown in FIGS. 2-12, the working fluid may be a liquid coolant, and the process fluid may be air. The first flow control assembly may include the pumps housed in the pump cassettes 210a, 210b, while the second flow control assembly may include the fans 206. In the case of the air-to-liquid cooling unit 2600 shown in FIG. 26, the working fluid may be air, and the process fluid may be facility water. The first flow control assembly may include the fans 2620, while the second flow control assembly may include the valve 2610.

As described above, control systems of a cooling unit can include sensors to sense, among other things, a value of an operating parameter to be targeted by operation of flow control assemblies of the cooling unit. In particular, cooling units implementing the disclosed control systems can include a temperature sensor and a first flow sensor positioned within the enclosure. These sensors may be used to monitor the temperature and flow rate of the working fluid. A controlled of the cooling unit can be configured to receive measurements from the sensors and determine control signals for operation of flow control assemblies based on these measurements and target values. Specifically, the controller may receive a flow rate measurement of the working fluid from the first flow sensor and determine a first signal based on this measurement and a target flow rate for the first fluid. The controller may also receive a temperature measurement from the first temperature sensor and determine a second signal based on this measurement and a target temperature for the first fluid. In the context of the LACU 2500 shown in FIG. 25, the controller can receive a supply temperature of the working fluid from sensor 2536, and can generate a signal (e.g., via a PID controller) for controlling a speed of the fans 2514 (e.g., the flow control assembly for the process fluid) based on the supply temperature and a target temperature (e.g., a target supply temperature, a target differential temperature between a temperature measured at sensor 2506 and sensor 2536, etc.). Additionally, the controller can receive a flow rate measurement from sensor 2534 and can generate a speed signal for one or both of the pumps 2530 based on the measured flow rate and a target flow rate. The controller may send the signal for control of the fans to the fans 2514, and the pump speed signal to one or more of the pumps 2530. The described control processes allow for simplified and simultaneous control of the flow of both a working fluid and a process fluid through a heat exchanger. By adjusting these flows, the disclosed control systems may maintain desired temperature and flow conditions for a working fluid used to cool the data center equipment.

In some examples, control systems for a cooling unit can be designed to handle situations where normal cooling capacity achievable through control of a flow of a process fluid as described above is exceeded. In some cases, a controller can determine that a maximum flow of a process fluid has been achieved (e.g., and thus a maximum cooling capacity from the process fluid is achieved). For example, in the context of the LACU 2500 shown in FIG. 25, the controller can determine that the fans 2514 are operating at a maximum speed (e.g., via readings from fan speed sensors). In some cases, a controller can determine that a process fluid has achieved a maximum cooling capacity through sensing parameters of the working fluid or the process fluid. For example, measured values of a temperature of the working fluid over time can indicate that an increase in speed of the fans 2514 does not produce a corresponding cooling of the liquid coolant. In some cases, a flow rate for a process fluid can be bounded by fence conditions and determining that a maximum cooling capacity of the process fluid has been achieved can include determining that the system has reached the fence condition. For example, a speed of fans of an LACU can be restricted based on a dew point for the working fluid, to ensure that an air flow across the heat exchanger does not produce conditions leading to condensation along a liquid cooling circuit. In other examples, maximum flow rates for a process fluid can be determined according to any configured fence condition.

Where a flow rate of a process fluid (e.g., an air flow rate for the LACU 2500 shown in FIG. 25) is maximized, or where control of flow control assemblies for the process fluid fail to bring a temperature of the working fluid below a threshold value, a controller can change an operating mode of a flow control assembly for the working fluid from a constant flow mode to a mode targeting a temperature value for the working fluid. For example, with reference to FIG. 25, when the controller determines that the fans 2514 are operating at a maximum fan speed, the controller can implement a PID controller for the pumps 2530 to control a speed of the pumps to achieve a desired temperature or temperature differential for the liquid coolant. The controller can generate a pump speed signal for the pumps 2530 based on a target temperature and a measured temperature (e.g., a supply temperature measured at sensor 2536), and can send the pump signal to one or more of the pumps 2530 to control a speed of the pumps, enhancing a cooling capacity of the cooling unit 2500. In other examples, the controller can issue a signal to one or more of the pumps 2530 to operate at a maximum pump speed when the controller determines that the fans 2514 are operating at a maximum speed, or a cooling capacity achievable through control of the flow of the process fluid is at a maximum. While the above description has referenced the LACU 2500, the described process is applicable for cooling units having different working and process fluids and including different flow control assemblies to control a flow of the respective fluids across a heat exchanger. For example, the controller can be installed in the air-to-liquid cooling unit 2600 shown in FIG. 26, and can increase a speed of the fans 2620 (e.g., the flow control assembly for the working fluid) when a maximum flow is achieved for the process fluid (e.g., when the valve 2610 is fully open). Notably, where a flow control assembly control a flow of a fluid through use of a valve, a signal from a controller can include an instruction to the valve (e.g., to an actuator, a solenoid, a servo motor, etc.) to put the valve in one of an open position, a closed position, and a partially open position to achieve a desired flow.

A control system implemented by a controller of a cooling unit may also be designed to handle failure conditions. For example, if the controller detects a failure condition of one or more components of a flow control assembly for a process fluid, it may control an operation of the flow control assembly for the working fluid to compensate for the failure, including, for example, by increasing a flow of the working fluid. This may help maintain cooling capacity even if one part of the system is not functioning properly.

As noted above, a controller for a cooling unit can be housed in a housing (e.g., the control module 214a, 214b shown in FIG. 12) that can be insertable into a liquid-to-air cooling unit, an air-to-liquid cooling unit, an in-rack CDU, a liquid-to-liquid CDU, etc. The controller can detect parameters of the cooling unit (e.g., via communication with electrical components of flow control assemblies of the cooling unit) and can implement the above-described control methods for process fluids and working fluids of the cooling unit, which can be uniform regardless of differences in the configurations of the respective cooling units.

In some cases, a CDU (e.g., the LACU 200 shown in FIGS. 2-12) can be operated in an uptime boost mode to improve the duration of uptime operation (e.g., to extend uptime of the CDU and downstream IT components). In some cases, a controller (e.g., controller 234 shown in FIG. 34) may not specifically and separately define an "Uptime Boost Mode" but may rather provide this functionality transparently to an operator, as a consequence of operation under other methods and settings that can allow for improved protection of a downstream IT load.

Liquid cooled components such as in-row coolers, rear door coolers, cold plate loops, and immersion chassis can contain thin metal components that will warp or deform if the operating pressure becomes too high. An operator can define (e.g., through an interface of the CDU) a maximum allowable pressure, and a controller of the CDU (e.g., controller 234 of CDU 100, shown in FIG. 34) can operate the CDU to prevent a pressure along piping of a liquid cooling loop (e.g., plumbing for transporting the working fluid)a from reaching or exceeding the maximum allowable pressure.

An uptime boost mode for a CDU can be implemented by a controller to extend operation of the CDU when the heat rejection capacity of the CDU is reduced. In some embodiments, an uptime boost mode can override one or more operating modes of the CDU, so that, while the CDU is operating in uptime boost mode, PID controllers of one or both of flow control assemblies for a working fluid and a process fluid can be disabled or changed. In this regard, an example process can be executed by a controller of a CDU to extend an uptime of the CDU and downstream IT components (e.g., by preventing a thermal shutdown of the CDU or downstream IT components and preventing damage due to overpressure). The process can evaluate whether a temperature of the working fluid (e.g., a supply temperature measured at sensor 2536 of FIG. 25) exceeds a maximum tolerable temperature for the working fluid. In some examples, the maximum allowable temperature can be defined by an operator of the CDU.

Continuing, if the temperature of the working fluid exceeds the maximum allowable temperature, the process can evaluate a state of a flow control assembly for the process fluid (e.g., the fans 2514 of LACU 2500 shown in FIG. 25, or the valve 2610 of the air-to-liquid cooling unit 2600 shown in FIG. 26).. The flow control assembly of the process fluid can be controlled to increase flow of a process fluid across the heat exchanger (e.g., the heat exchanger 2508 shown in FIG. 25, the heat exchanger 2612 shown in FIG. 26, etc.), HX 142 shown in FIG. 22), and thus increase a heat transfer from the working fluid to the process fluid.

If the flow control assembly for the process fluid is operating at a maximal capacity (e.g., a flow of process fluid across the heat exchanger is maximized, given fence conditions), the controller can compare a pressure of the working fluid to a maximum allowable pressure. In some cases, increased flow of a working fluid can increase a pressure within the plumbing of the cooling unit beyond a safe range (e.g., a maximum allowable pressure).

If the pressure of the working fluid does not exceed the maximum allowable pressure, the controller can control a flow control assembly to increase a flow rate of the working fluid (e.g., to increase a pump speed of the pumps 2530 of the LACU 2500 shown in FIG. 25). In some examples, when a flow of the working fluid is increased, a differential temperature between the temperature of the working fluid at an inlet and the temperature of the working fluid at an outlet of the cooling unit (e.g., a differential temperature between measured values of the liquid coolant at sensors 2506, 2536 shown in FIG. 25) is decreased. Increasing flow of the working fluid and decreasing the differential temperature between a cooling unit inlet and outlet can decrease a rate at which a temperature of coolant entering the CDU through the inlet increases and can thus extend the amount of time a downstream load can continue operating before a thermal shut down.

The processes 3400, 3500, 3600, 3700, 3800, 3900 can be implemented by one or more controllers of a cooling unit (e.g., LACU 100, 200, 2500 shown in FIGS. 1, 2, and 25, the air-to-liquid cooling unit 2600 shown in FIG. 26, etc.). For example, one or both of Controller 1 and Controller 2 shown in FIG. 31 can include instructions thereon for implementing any of the processes 3400, 3500, 3600, 3700, 3800, 3900. In some cases, portions of one or more of the above listed processes can be performed in response to instructions from remote computing systems (e.g., a remote controller hosted on a computing system external to the cooling unit.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Features of the system or any other device(s) or component(s) described may be incorporated into/used in a corresponding method and vice versa.

The previous description of the disclosed embodiments is provided to enable any person skilled in the art to make or use the disclosed technologies. Various modifications to these embodiments will be readily apparent to those skilled in the art, and the generic principles defined herein may be applied to other embodiments without departing from the spirit or scope of the disclosed technologies. Thus, the disclosure is not intended to be limited to the embodiments shown herein but is to be accorded the widest scope consistent with the principles and novel features disclosed herein.

## Claims

1. A liquid cooling system having an enclosure and a heat exchanger positioned in the enclosure, the heat exchanger transferring heat from a first fluid to a second fluid, the first fluid cooling electrical equipment within a data center, the liquid cooling system comprising:
a first flow control assembly to control flow of the first fluid through the heat exchanger;
a second flow control assembly to control flow of the second fluid through the heat exchanger;
a first temperature sensor and a first flow sensor positioned within the enclosure; and
a controller in communication with the first flow control assembly, the second flow control assembly, the first temperature sensor, and the first flow sensor, the controller:
receiving a flow rate measurement from the first flow sensor;
receiving a temperature measurement from the first temperature sensor;
determining a first signal based on the flow rate measurement and a target flow rate of the first fluid;
determining a second signal based on the temperature measurement and a target temperature of the first fluid; and
sending the first signal to the first flow control assembly and sending the second signal to the second flow control assembly in order to simultaneously control flow of the first fluid and the second fluid through the heat exchanger.

2. The liquid cooling system of claim 1, wherein the first flow control assembly includes a first pump, and the second flow control assembly includes a first fan, wherein the first signal is a first pump speed signal and the second signal is a first fan speed signal.

3. The liquid cooling system of claim 2, wherein the controller:
determines that the first fan is operating at a maximum fan speed;
in response to determining that the first fan is operating at the maximum fan speed, when the temperature measurement exceeds the target temperature of the first fluid, determines, based on the temperature measurement, a second pump speed signal; and
sends the second pump speed signal to the first pump.

4. The liquid cooling system of claim 3, wherein the second pump speed signal comprises an instruction to operate the first pump at a maximum allowable speed.

5. The liquid cooling system of claim 4, wherein the second pump speed signal is determined by a proportional integral derivative controller, wherein the proportional integral derivative controller controls a speed of the first pump to achieve a target temperature of the first fluid.

6. The liquid cooling system of claim 1 or of any of claims 2 to 5, wherein the controller:
detects a failure condition of the second flow control assembly;
in response to detecting the failure condition, generates a third signal, the third signal comprising an instruction to the first flow control assembly to increase a flow rate of the first fluid; and
sends the third signal to the first flow control assembly.

7. The liquid cooling system of claim 1 or of any of claims 2 to 6, wherein the first flow control assembly includes a plurality of fans, and the second flow control assembly includes a controllable valve, wherein the second signal comprises an instruction to one of open, partially open, or close the controllable valve.

8. The liquid cooling system of claim 1 or of any of claims 2 to 7, wherein the controller is housed in a removable housing installed in at least one of an air-to-liquid cooling unit or a liquid-to-air cooling unit.

9. The liquid cooling system of claim 1 or of any of claims 2 to 8, wherein the controller calculates a dew point for the first fluid, and wherein the first signal and the second signal are generated based on the dew point.

10. The liquid cooling system of claim 1 or of any of claims 2 to 9, and further comprising a first pressure sensor; and wherein the first signal is determined based on a maximum allowable pressure of the first fluid.

11. A method of controlling a liquid cooling system including a heat exchanger transferring heat from a first fluid to a second fluid, the first fluid cooling electrical equipment within a data center, the method comprising:
sensing a temperature and a flow rate of the first fluid;
comparing the flow rate to a target flow rate of the first fluid;
comparing the temperature to a target temperature of the first fluid;
generating a first pump speed signal;
generating a second fan speed signal;
determining that the second fan speed signal is a maximum fan speed;
determining that the temperature exceeds a target temperature of the first fluid; and
determining a second pump speed signal when the second fan speed signal is at the maximum fan speed and the temperature exceeds the target temperature of the first fluid.

12. The method of claim **11** and further comprising generating a second pump speed signal to operate a pump at a maximum allowable speed.

13. The method of claim 12 and further comprising generating the second pump speed signal using proportional integral derivative control.

14. The method of claim 11, claim 12 or claim 13, and further comprising calculating a dew point of the first fluid and generating the first pump speed signal and the second fan speed signal based on the dew point.

15. The method of claim 11 or of any of claims 12 to 14, and further comprising sensing a pressure and determining the first pump speed signal based on a maximum allowable pressure.
